# EUROPEAN PATENT SPECIFICATION

(11) **EP 4 238 976 B1**
(45) Date of publication and mention of the grant of the patent: **29.04.2026**
(21) Application number: 21892188.0
(22) Date of filing: 25.10.2021
(51) Int. Cl.: C07F 5/02, C07F 7/08, C07F 19/00, C09K 11/06, C07F 9/6584, H10K 85/10, H10K 50/12, H10K 85/60

(54) **POLYCYCLIC COMPOUND AND ORGANIC LIGHT-EMITTING DEVICE USING SAME**
POLYCYCLISCHE VERBINDUNG UND ORGANISCHE LICHTEMITTIERENDE VORRICHTUNG DAMIT
COMPOSÉ POLYCYCLIQUE ET DISPOSITIF ÉLECTROLUMINESCENT ORGANIQUE L'UTILISANT

(30) Priority: 10.11.2020 KR 20200149523
(43) Date of publication of application: 06.09.2023
(73) Proprietor: SFC Co., Ltd., Cheongju-si, Chungcheongbuk-do 28122 (KR)
(72) Inventor: MOON, Jun-young, Cheongju-si Chungcheongbuk-do 28122 (KR); JOO, Sung-hoon, Cheongju-si Chungcheongbuk-do 28122 (KR); SHIN, Bong-ki, Cheongju-si Chungcheongbuk-do 28122 (KR); YANG, Byung-sun, Cheongju-si Chungcheongbuk-do 28122 (KR); KIM, Ji-hwan, Cheongju-si Chungcheongbuk-do 28122 (KR); JO, Hyeon-jun, Cheongju-si Chungcheongbuk-do 28122 (KR); CHOI, Sung-eun, Cheongju-si Chungcheongbuk-do 28122 (KR); WOO, Seong-eun, Cheongju-si Chungcheongbuk-do 28122 (KR); PARK, Dong-myung, Cheongju-si Chungcheongbuk-do 28122 (KR); KANG, Soo-kyung, Cheongju-si Chungcheongbuk-do 28122 (KR)
(74) Representative: Grosse, Felix Christopher
(86) International application number: PCT/KR2021/015020
(87) International publication number: WO 2022/103018

(56) References cited:
- WO-A1-2016/152418
- WO-A1-2020/145725
- CN-A- 110 790 782
- CN-A- 110 790 782
- CN-A- 111 153 919
- KR-A- 20190 101 900
- KR-A- 20200 087 717

## Description

The present invention relates to a polycyclic compound and a highly efficient and long-lasting organic light emitting device with significantly improved life characteristics and luminous efficiency using the polycyclic compound.

Organic light emitting devices are self-luminous devices in which electrons injected from an electron injecting electrode (cathode) recombine with holes injected from a hole injecting electrode (anode) in a light emitting layer to form excitons, which emit light while releasing energy. Such organic light emitting devices have the advantages of low driving voltage, high luminance, large viewing angle, and short response time and can be applied to full-color light emitting flat panel displays. Due to these advantages, organic light emitting devices have received attention as next-generation light sources.

The above characteristics of organic light emitting devices are achieved by structural optimization of organic layers of the devices and are supported by stable and efficient materials for the organic layers, such as hole injecting materials, hole transport materials, light emitting materials, electron transport materials, electron injecting materials, and electron blocking materials. However, more research still needs to be done to develop structurally optimized organic layers for organic light emitting devices and stable and efficient materials for organic layers of organic light emitting Boron containing compounds used in OLEDs are disclosed in WO 2020/145725 A1 and devices. CN 110 790 782 A.

As such, there is a continued need to develop structures of organic light emitting devices optimized to improve their luminescent properties and new materials capable of supporting the optimized structures of organic light emitting devices.

Accordingly, the present invention is intended to provide a compound that is employed in an organic layer of an organic light emitting device to achieve high efficiency and long lifetime of the device. The present invention is also intended to provide an organic light emitting device including the compound.

One aspect of the present invention provides a polycyclic compound represented by Formula I and including the indolocarbazole derivative represented by Structural Formula A introduced therein:

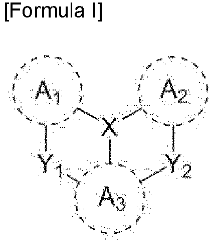

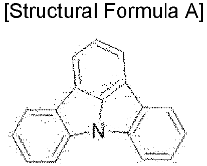

The indolocarbazole derivative represented by Structural Formula A may be substituted with at least one radical R. The structures represented by Formula I and Structural Formula A, specific compounds that can be represented by Formula I and Structural Formula A, and definitions of the rings A₁ to A₃, X, Y₁, Y₂, and R are described below.

The present invention also provides an organic light emitting device including a first electrode, a second electrode opposite to the first electrode, and one or more organic layers interposed between the first and second electrodes wherein one of the organic layers includes at least one of the specific polycyclic compounds that can be represented by Formula I.

The polycyclic compound of the present invention can be employed in an organic layer of an organic light emitting device to achieve high efficiency and long lifetime of the device.

The present invention will now be described in more detail.

The present invention is directed to a polycyclic compound for use in an organic light emitting device, represented by Formula I: 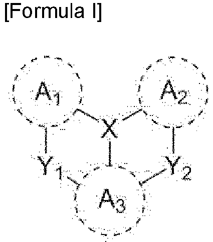 wherein X is B, P=O, P=S or Al, Y₁ and Y₂ are each independently NR₁, O, S, CRR₂R₃ or SiR₄R₅, A₁ to A₃ are each independently selected from substituted or unsubstituted C₅-C₅₀ aromatic hydrocarbon rings, substituted or unsubstituted C₂-C₅₀ aromatic heterocyclic rings, substituted or unsubstituted C₃-C₃₀ aliphatic rings, and substituted or unsubstituted C₃-C₃₀ mixed aliphatic-aromatic rings, and R₁ to R₅ are the same as or different from each other and are each independently selected from hydrogen, deuterium, substituted or unsubstituted C₁-C₃₀ alkyl, substituted or unsubstituted C₂-C₃₀ alkenyl, substituted or unsubstituted C₆-C₅₀ aryl, substituted or unsubstituted C₃-C₃₀ cycloalkyl, substituted or unsubstituted C₃-C₃₀ heterocycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted C₃-C₃₀ mixed aliphatic-aromatic cyclic groups, nitro, cyano, and halogen, and structurally including the indolocarbazole derivative represented by Structural Formula A introduced therein: 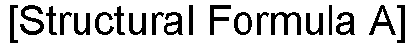 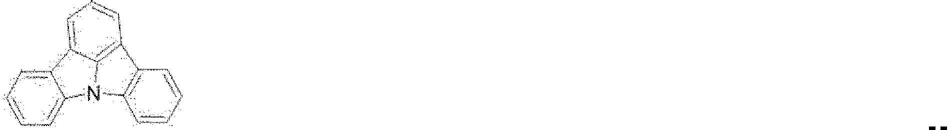 with the proviso that at least one of A₁ to A₃ is the indolocarbazole derivative represented by Structural Formula A, the indolocarbazole derivative represented by Structural Formula A is optionally substituted with one or more radicals R, which are the same as or different from each other and are each independently selected from hydrogen, deuterium, substituted or unsubstituted C₁-C₃₀ alkyl, substituted or unsubstituted C₂-C₃₀ alkenyl, substituted or unsubstituted C₆-C₅₀ aryl, substituted or unsubstituted C₃-C₃₀ cycloalkyl, substituted or unsubstituted C₃-C₃₀ heterocycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted C₃-C₃₀ mixed aliphatic-aromatic cyclic groups, nitro, cyano, and halogen, the substituents of each of the rings A₁ to A₃ are optionally linked to each other to form an alicyclic or aromatic monocyclic or polycyclic ring, each of R₁ to R₅ is optionally linked to an adjacent substituent of at least one of the rings A₁ to A₃ to form an alicyclic or aromatic monocyclic or polycyclic ring, the radicals R are optionally linked to each other to form an alicyclic or aromatic monocyclic or polycyclic ring, R₂ and R₃ are optionally linked to each other to form an alicyclic or aromatic monocyclic or polycyclic ring, and R₄ and R₅ are optionally linked to each other to form an alicyclic or aromatic monocyclic or polycyclic ring,the term "substituted" in the definition of the rings A1 to A3 , R, R1 to R5 , etc. indicates substitution with one or more substituents selected from deuterium, cyano, halogen, hydroxyl, nitro, alkyl, cycloalkyl, haloalkyl, alkenyl, alkynyl, heteroalkyl, heterocycloalkyl, aryl, arylalkyl, heteroaryl, heteroarylalkyl, alkoxy, alkylamine, arylamine, heteroarylamine, alkylsilyl, arylsilyl, and aryloxy, or a combination thereof.

The characteristic structures and ring-forming structures in Formula 1 based on the definitions provided above can be identified from the specific compounds listed below.

According to one embodiment of the present invention, the polycyclic compound may be represented by one of Formulas I-1 and I-2: 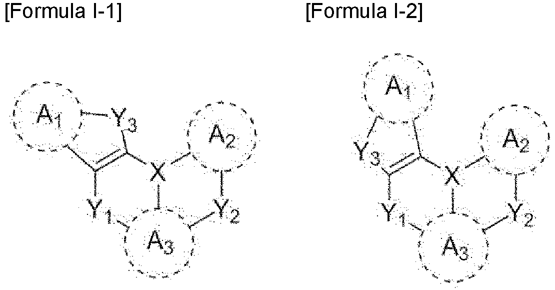 wherein Y₃ is NR₁, O, S, CRR₂R₃ or SiR₄R₅, R₁ to R₅ are as defined in Formula I, and X, Y₁, Y₂, and A₁ to A₃ are as defined in Formula I.

As used herein, the term "substituted" in the definition of the rings A₁ to A₃, R, R₁ to R₅, etc. indicates substitution with one or more substituents selected from deuterium, cyano, halogen, hydroxyl, nitro, alkyl, cycloalkyl, haloalkyl, alkenyl, alkynyl, heteroalkyl, heterocycloalkyl, aryl, arylalkyl, heteroaryl, heteroarylalkyl, alkoxy, alkylamine, arylamine, heteroarylamine, alkylsilyl, arylsilyl, and aryloxy, or a combination thereof. As used herein, the term "unsubstituted" in the same definition indicates having no substituent.

In the "substituted or unsubstituted C₁-C₃₀ alkyl", "substituted or unsubstituted C₆-C₅₀ aryl", etc., the number of carbon atoms in the alkyl or aryl group indicates the number of carbon atoms constituting the unsubstituted alkyl or aryl moiety without considering the number of carbon atoms in the substituent(s). For example, a phenyl group substituted with a butyl group at the para-position corresponds to a C₆ aryl group substituted with a C₄ butyl group.

As used herein, the term "bonded to an adjacent group to form a ring" means that the corresponding group combines with an adjacent group to form a substituted or unsubstituted alicyclic or aromatic ring and the term "adjacent substituent" may mean a substituent on an atom directly attached to an atom substituted with the corresponding substituent, a substituent disposed sterically closest to the corresponding substituent or another substituent on an atom substituted with the corresponding substituent. For example, two substituents substituted at the ortho position of a benzene ring or two substituents on the same carbon in an aliphatic ring may be considered "adjacent" to each other. In the present invention, the alkyl groups may be straight or branched. Specific examples of the alkyl groups include, but are not limited to, methyl, ethyl, propyl, n-propyl, isopropyl, butyl, n-butyl, isobutyl, tert-butyl, sec-butyl, 1-methylbutyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethylpropyl, 1,1-dimethylpropyl, isohexyl, 2-methylpentyl, 4-methylhexyl, and 5-methylhexyl groups.

The alkenyl group is intended to include straight and branched ones and may be optionally substituted with one or more other substituents. The alkenyl group may be specifically a vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, stilbenyl or styrenyl group but is not limited thereto.

The alkynyl group is intended to include straight and branched ones and may be optionally substituted with one or more other substituents. The alkynyl group may be, for example, ethynyl or 2-propynyl but is not limited thereto.

The aromatic hydrocarbon rings or aryl groups may be monocyclic or polycyclic ones. Examples of the monocyclic aryl groups include, but are not limited to, phenyl, biphenyl, terphenyl, and stilbenyl groups. Examples of the polycyclic aryl groups include naphthyl, anthracenyl, phenanthrenyl, pyrenyl, perylenyl, tetracenyl, chrysenyl, fluorenyl, acenaphathcenyl, triphenylene, and fluoranthrene groups but the scope of the present invention is not limited thereto.

The aromatic heterocyclic rings or heteroaryl groups refer to aromatic groups containing one or more heteroatoms. Examples of the aromatic heterocyclic rings or heteroaryl groups include, but are not limited to, thiophene, furan, pyrrole, imidazole, thiazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isoxazolyl, oxadiazolyl, thiadiazolyl, benzothiazolyl, and phenothiazinyl groups.

The aliphatic hydrocarbon rings refer to non-aromatic rings consisting only of carbon and hydrogen atoms. The aliphatic hydrocarbon ring is intended to include monocyclic and polycyclic ones and may be optionally substituted with one or more other substituents. As used herein, the term "polycyclic" means that the aliphatic hydrocarbon ring may be directly attached or fused to one or more other cyclic groups. The other cyclic groups may be aliphatic hydrocarbon rings and other examples thereof include aliphatic heterocyclic, aryl, and heteroaryl groups. Specific examples of the aliphatic hydrocarbon rings include, but are not limited to, cycloalkyl groups such as cyclopropyl, cyclobutyl, cyclopentyl, adamantyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, and cyclooctyl, cycloalkanes such as cyclohexane and cyclopentane, and cycloalkenes such as cyclohexene and cyclobutene.

The aliphatic heterocyclic rings refer to aliphatic rings containing one or more heteroatoms such as O, S, Se, N, and Si. The aliphatic heterocyclic ring is intended to include monocyclic or polycyclic ones and may be optionally substituted with one or more other substituents. As used herein, the term "polycyclic" means that the aliphatic heterocyclic ring such as heterocycloalkyl, heterocycloalkane or heterocycloalkene may be directly attached or fused to one or more other cyclic groups. The other cyclic groups may be aliphatic heterocyclic rings and other examples thereof include aliphatic hydrocarbon rings, aryl groups, and heteroaryl groups.

The mixed aliphatic-aromatic rings or the mixed aliphatic-aromatic cyclic groups refer to structures in which two or more rings are fused together and which are overall non-aromatic. The mixed aliphatic-aromatic polycyclic rings may contain one or more heteroatoms selected from N, O, P, and S other than carbon atoms (C). Examples of the mixed aliphatic-aromatic polycyclic rings include, but are not limited to, tetralin, 1,1,4,4-tetramethyl-1,2,3,4-tetrahydronaphthalene, 1,2,3,4,4a,9b-hexahydrodibenzofuran, 2,3,4,4a,9,9a-hexahydro-4a,9a-dimethyl-1H-carbazole, and 5,6,7,8-tetrahydroquinoline.

The alkoxy group may be specifically a methoxy, ethoxy, propoxy, isobutyloxy, sec-butyloxy, pentyloxy, iso-amyloxy or hexyloxy group but is not limited thereto.

The silyl groups may be, for example, -SiH₃, alkylsilyl, arylsilyl, alkylarylsilyl, and arylheteroarylsilyl. Specific examples of the silyl groups include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl.

The amine group may be, for example, -NH₂, alkylamine, arylamine or arylheteroarylamine. The arylamine refers to an aryl-substituted amine group, the alkylamine refers to an alkyl-substituted amine group, and the arylheteroarylamine refers to an aryl- and heteroaryl-substituted amine group. The arylamine may be, for example, substituted or unsubstituted monoarylamine, substituted or unsubstituted diarylamine, or substituted or unsubstituted triarylamine. The aryl and/or heteroaryl groups in the arylamine and arylheteroarylamine groups may be monocyclic or polycyclic ones. The arylamine and arylheteroarylamine groups may include two or more aryl and/or heteroaryl groups. In this case, the aryl groups may be monocyclic and/or polycyclic ones and the heteroaryl groups may be monocyclic and/or polycyclic ones. The aryl and/or heteroaryl groups in the arylamine and arylheteroarylamine groups may be selected from those exemplified above.

The aryl groups in the aryloxy and arylthioxy groups are the same as those exemplified above. Specific examples of the aryloxy groups include, but are not limited to, phenoxy, p-tolyloxy, m-tolyloxy, 3,5-dimethylphenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, and 9-phenanthryloxy groups. Specific examples of the arylthioxy groups include, but are not limited to, phenylthioxy, 2-methylphenylthioxy, and 4-tert-butylphenylthioxy groups.

The halogen group may be, for example, fluorine, chlorine, bromine or iodine.

More specifically, the polycyclic compound represented by Formula I according to the present invention may be selected from the following compounds 1 to 75:

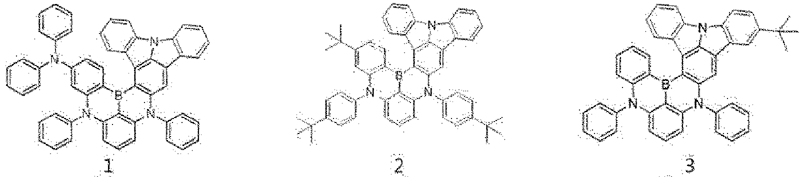

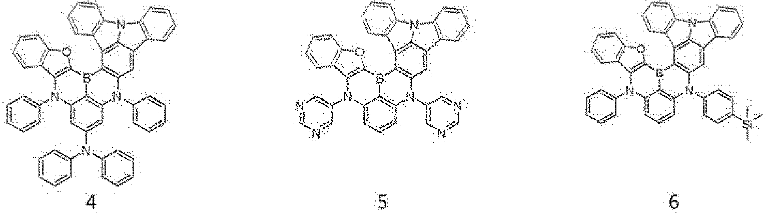

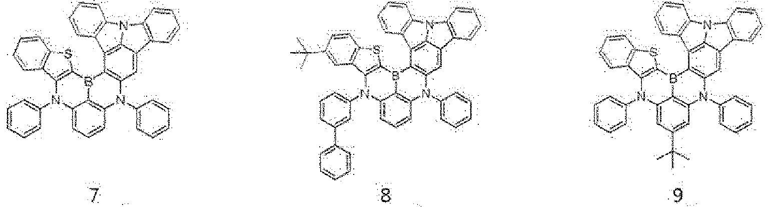

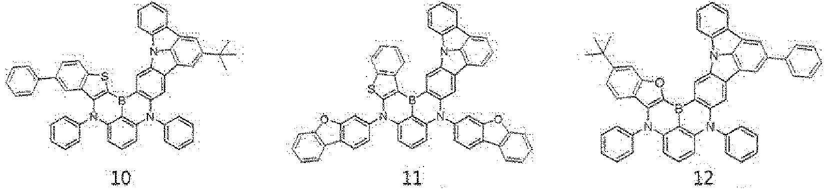

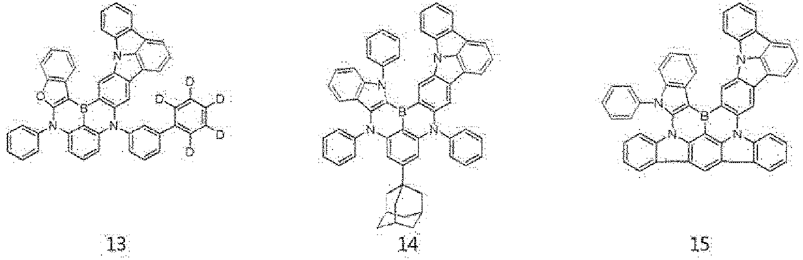

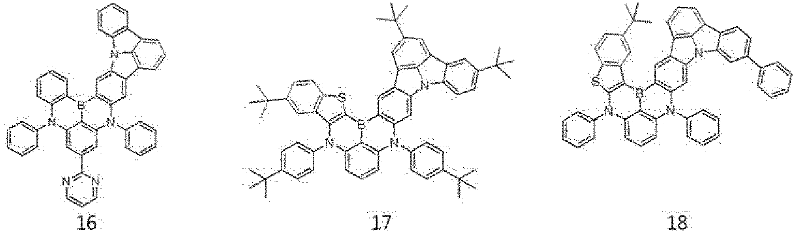

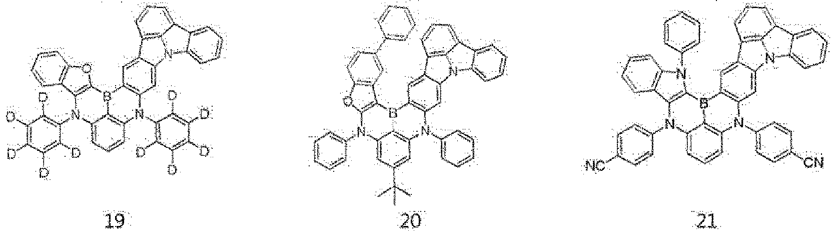

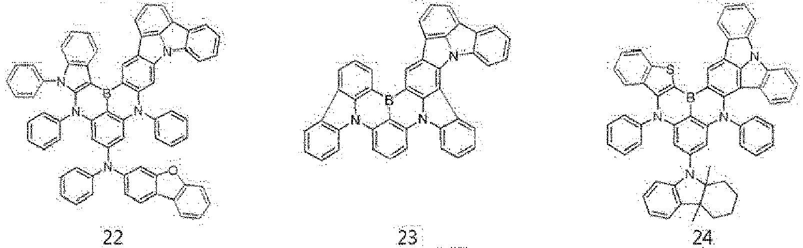

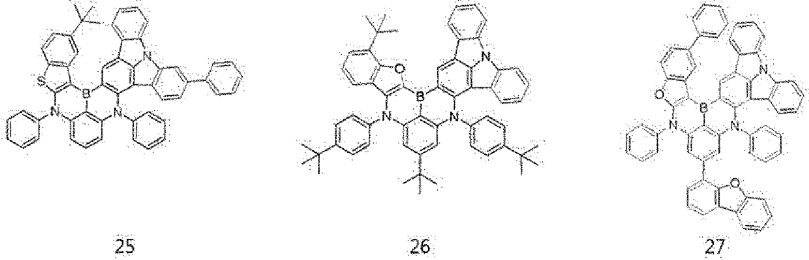

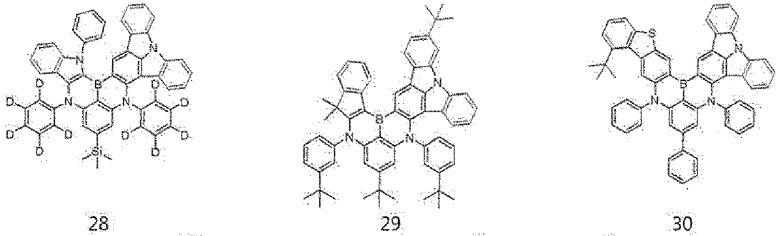

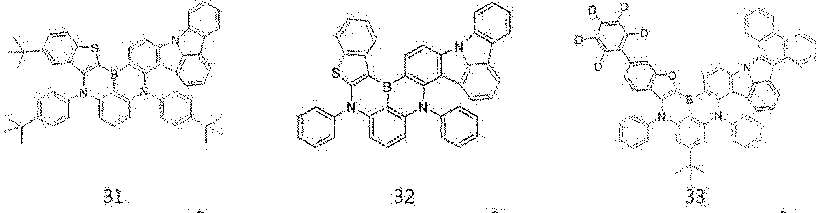

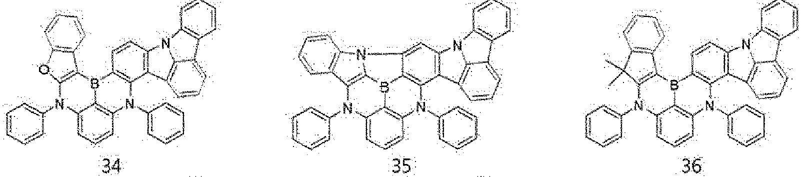

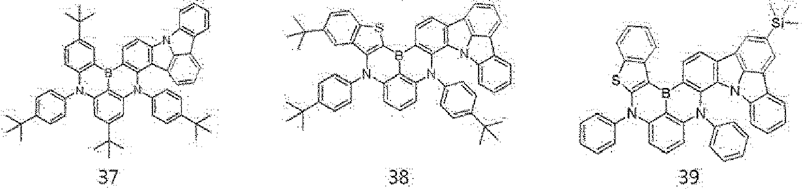

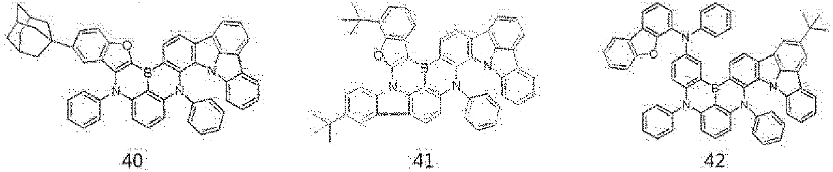

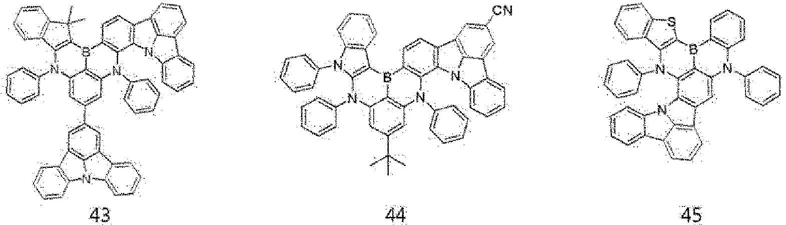

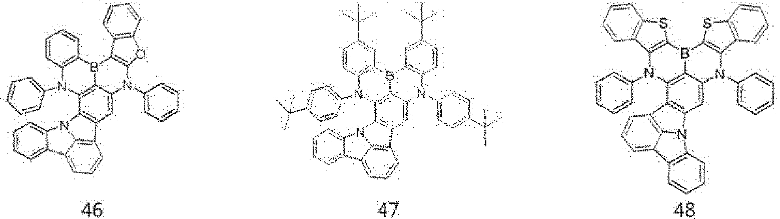

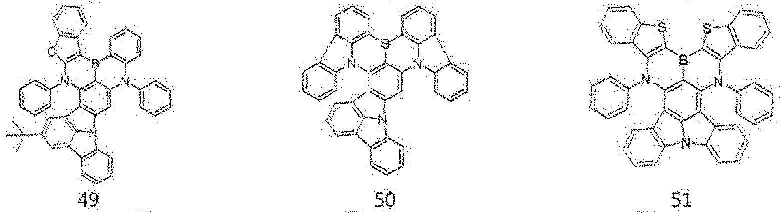

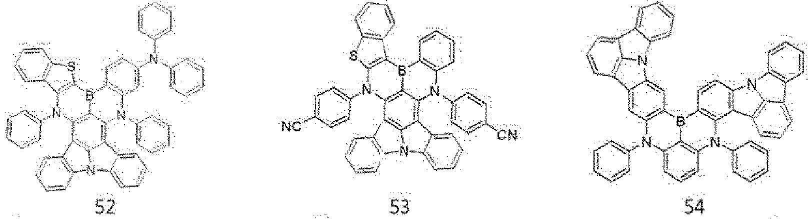

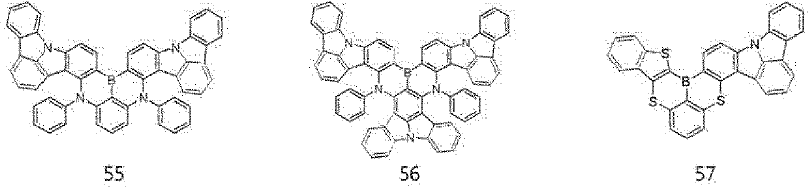

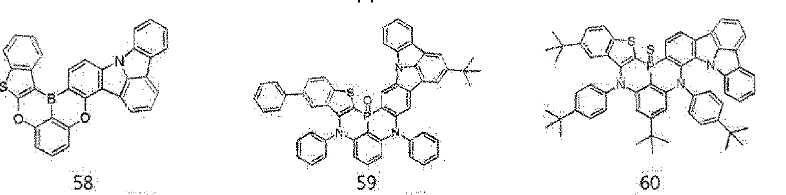

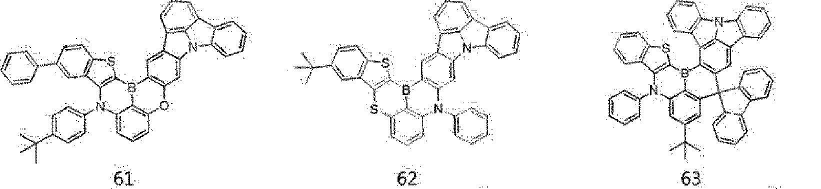

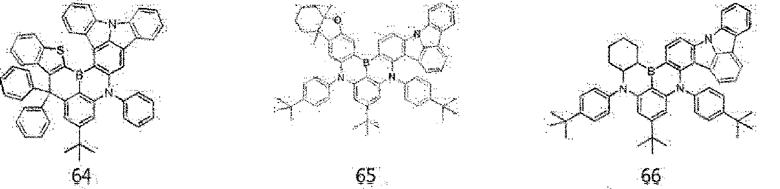

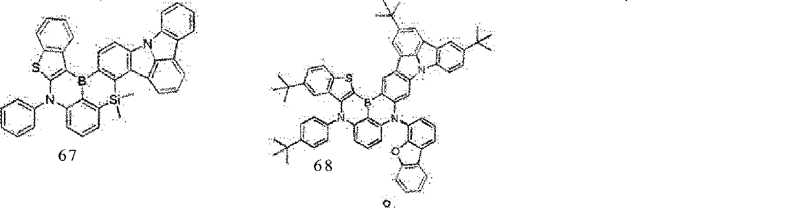

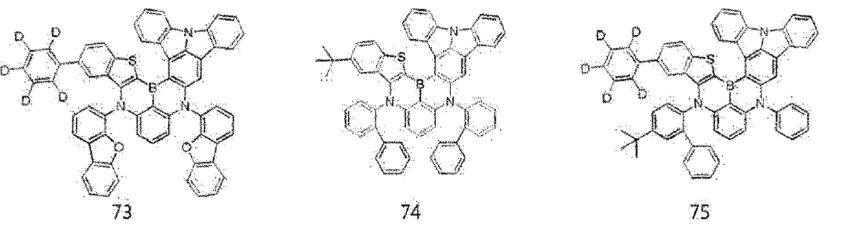

The specific substituents in Formula I can be clearly seen from the structures of the compounds 1 to 75. However, the compounds 1 to 75 are not intended to limit the scope of Formula I.

Each of the above specific compounds contains B, P=O, P=S or Al, preferably boron (B), and has a polycyclic structure. The introduction of specific substituents, including the substituent represented by Structural Formula A, into the polycyclic structure enables the synthesis of organic light emitting materials with inherent characteristics of the substituents. For example, the substituents are designed for use in materials for hole injecting layers, hole transport layers, light emitting layers, electron transport layers, electron injecting layers, electron blocking layers, and hole blocking layers, preferably light emitting layers, of organic light emitting devices. This introduction meets the requirements of materials for the organic layers, making the organic light emitting devices highly efficient and long lasting.

A further aspect of the present invention is directed to an organic light emitting device including a first electrode, a second electrode, and one or more organic layers interposed between the first and second electrodes wherein one of the organic layers includes at least one of the compounds that can be represented by Formula I.

That is, according to one embodiment of the present invention, the organic light emitting device has a structure in which one or more organic layers are arranged between a first electrode and a second electrode. The organic light emitting device of the present invention may be fabricated by suitable methods and materials known in the art, except that the compound of Formula I is used to form the corresponding organic layer.

The organic layers of the organic light emitting device according to the present invention may form a monolayer structure. Alternatively, the organic layers may be stacked togetherto form a multilayer structure. For example, the organic layers may have a structure including a hole injecting layer, a hole transport layer, a hole blocking layer, a light emitting layer, an electron blocking layer, an electron transport layer, and an electron injecting layer but are not limited to this structure. The number of the organic layers is not limited and may be increased or decreased. Preferred structures of the organic layers of the organic light emitting device according to the present invention will be explained in more detail in the Examples section that follows.

The organic light emitting device of the present invention includes an anode, a hole transport layer, a light emitting layer, an electron transport layer, and a cathode. The organic light emitting device of the present invention may optionally further include a hole injecting layer between the anode and the hole transport layer and an electron injecting layer between the electron transport layer and the cathode. If necessary, the organic light emitting device of the present invention may further include one or two intermediate layers such as a hole blocking layer or an electron blocking layer.

According to a preferred embodiment of the present invention, one of the organic layers interposed between the first and second electrodes may be a light emitting layer composed of a host and the compound represented by Formula I as a dopant.

The content of the dopant in the light emitting layer is typically in the range of about 0.01 to about 20 parts by weight, based on about 100 parts by weight of the host but is not limited to this range.

According to one embodiment of the present invention, the host may be an anthracene derivative represented by Formula H: 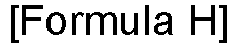 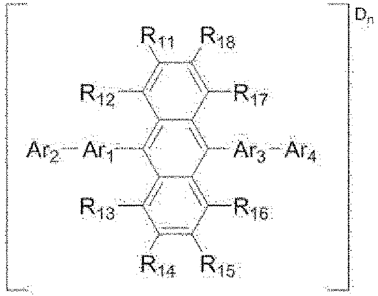 wherein R₁₁ to R₁₈ are the same as or different from each other and are each independently selected from hydrogen, substituted or unsubstituted C₁-C₃₀ alkyl, substituted or unsubstituted C₂-C₃₀ alkenyl, substituted or unsubstituted C₆-C₅₀ aryl, substituted or unsubstituted C₃-C₃₀ cycloalkyl, substituted or unsubstituted C₃-C₃₀ heterocycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted C₃-C₂₀ mixed aliphatic-aromatic cyclic groups, nitro, cyano, and halogen, Ar₁ and Ar₃ are the same as or different from each other and are each independently substituted or unsubstituted C₆-C₃₀ arylene or substituted or unsubstituted C₅-C₃₀ heteroarylene, Ar₂ and Ar₄ are the same as or different from each other and are each independently selected from hydrogen, substituted or unsubstituted C₆-C₅₀ aryl, substituted or unsubstituted C₃-C₃₀ cycloalkyl, substituted or unsubstituted C₃-C₃₀ heterocycloalkyl, substituted or unsubstituted C₂-C₅₀ heteroaryl, and substituted or unsubstituted C₃-C₂₀ mixed aliphatic-aromatic cyclic groups, Dₙ represents the number of deuterium atoms replacing hydrogen atoms, and n is an integer from 0 to 50.

The anthracene host derivative represented by Formula H may be selected from the following compounds:

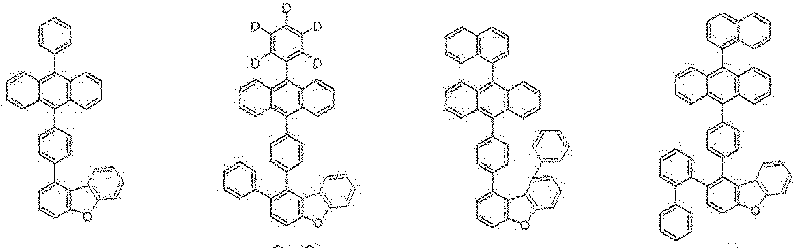

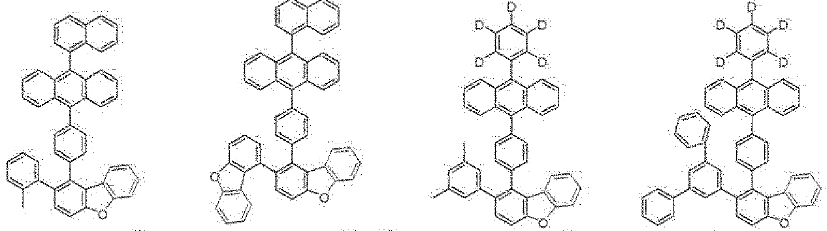

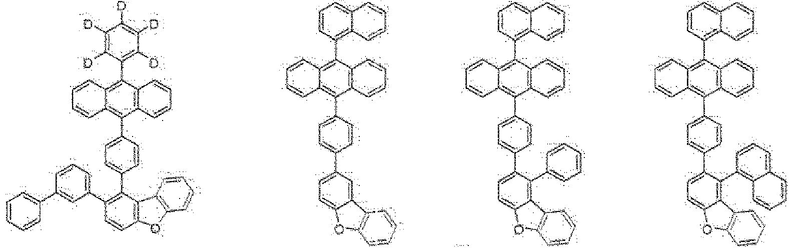

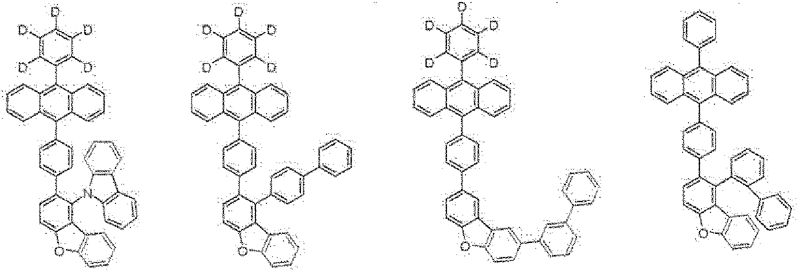

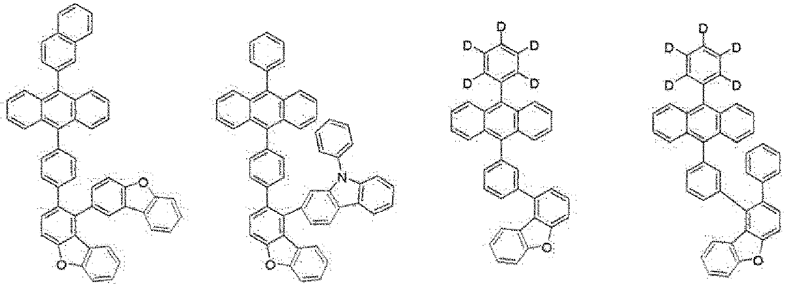

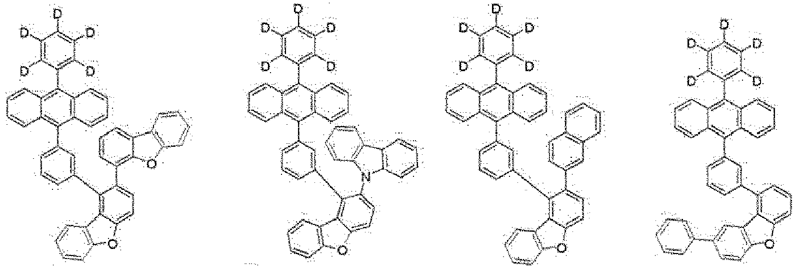

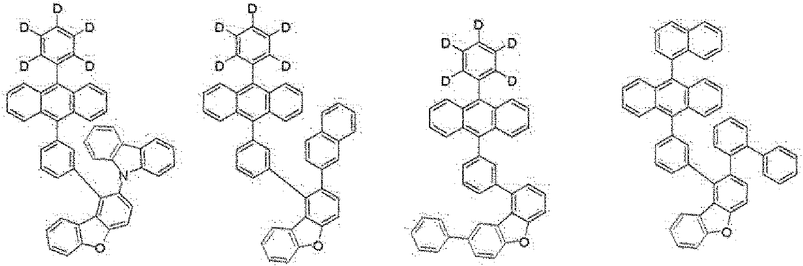

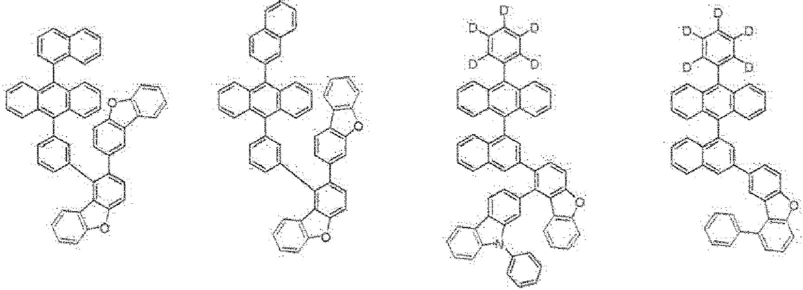

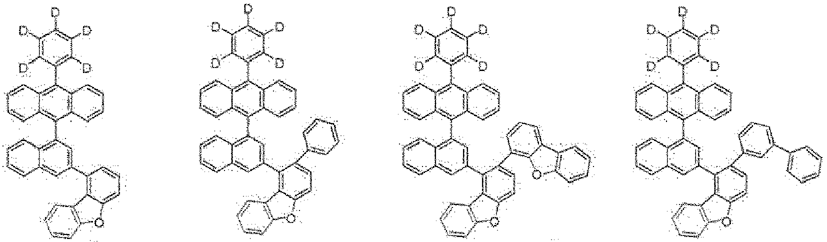

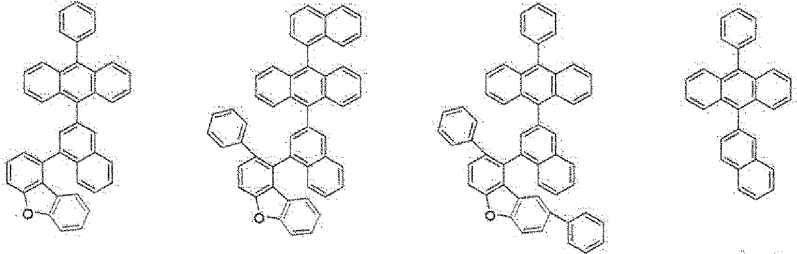

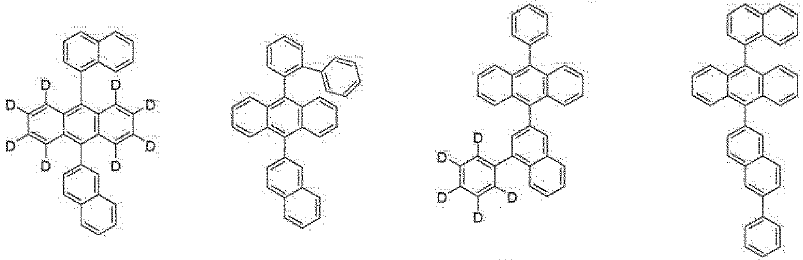

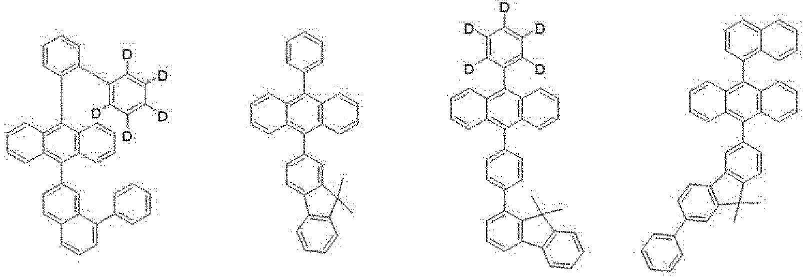

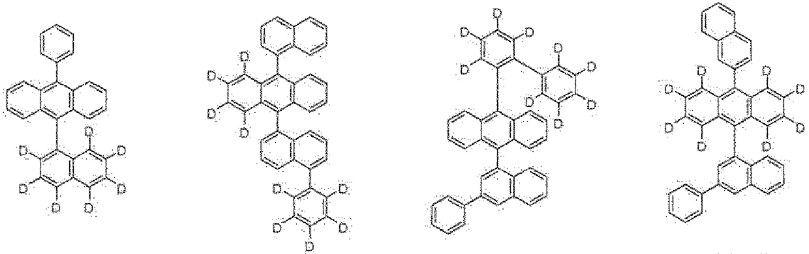

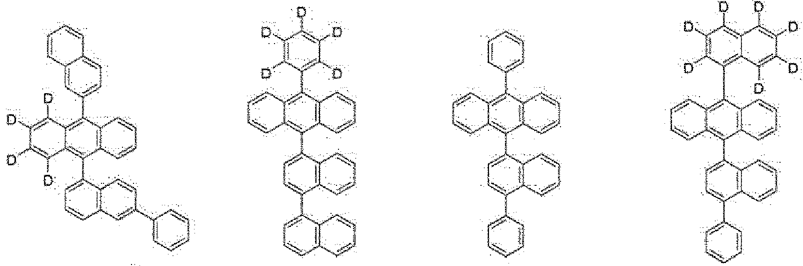

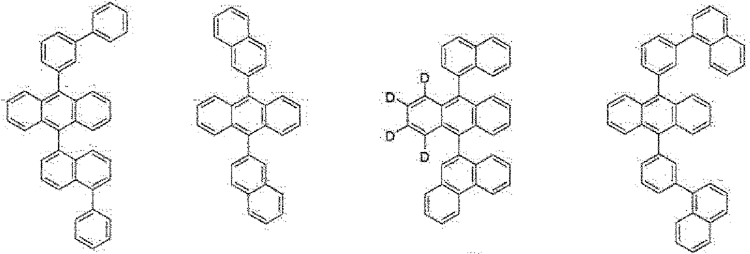

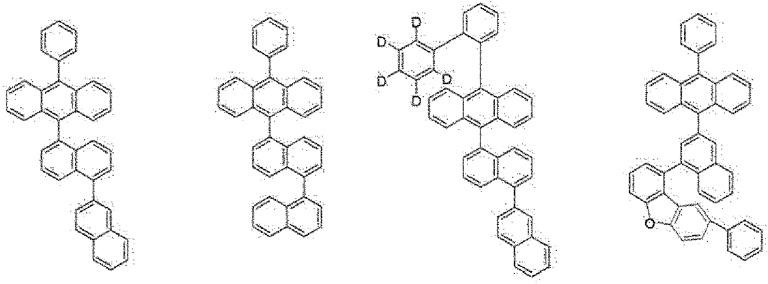

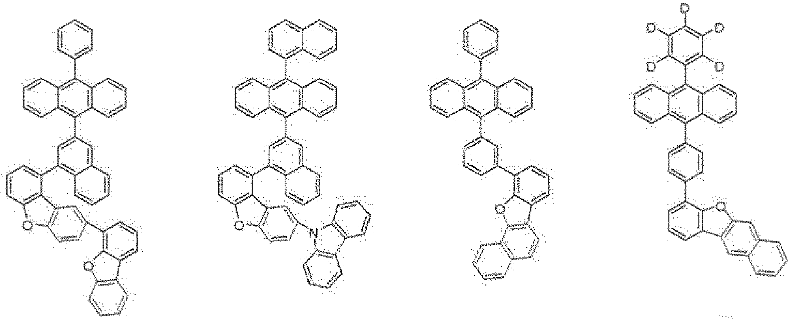

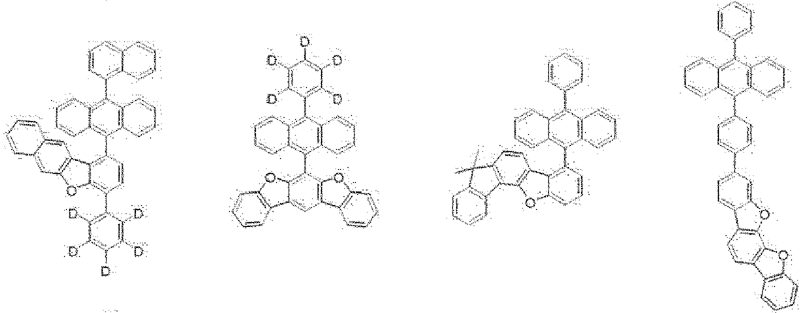

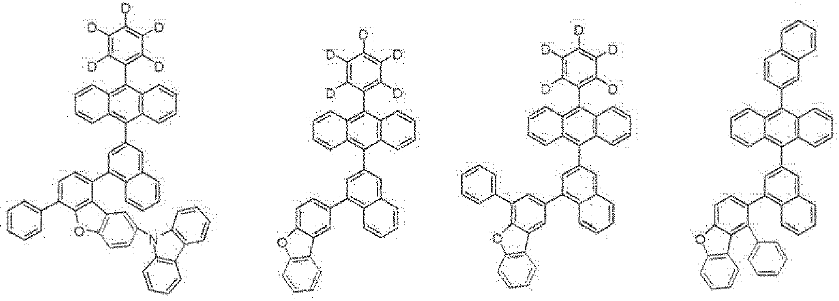

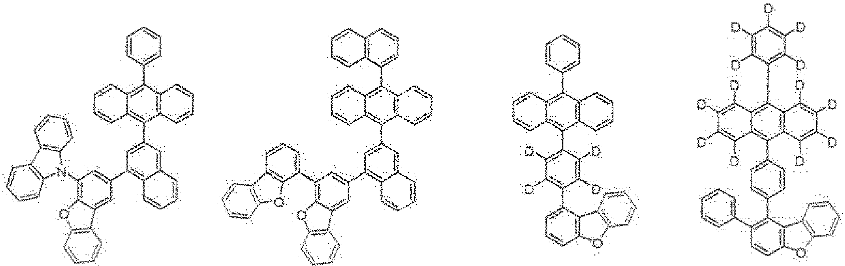

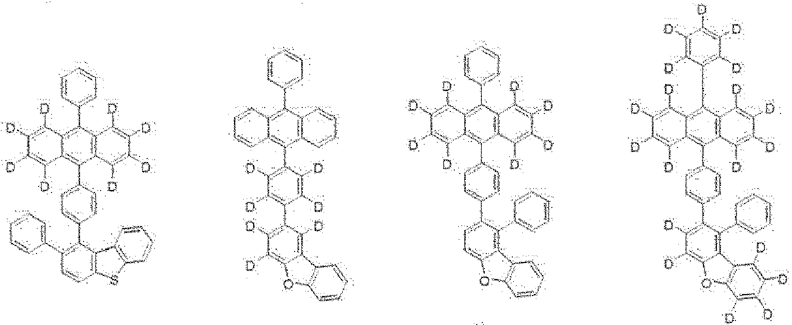

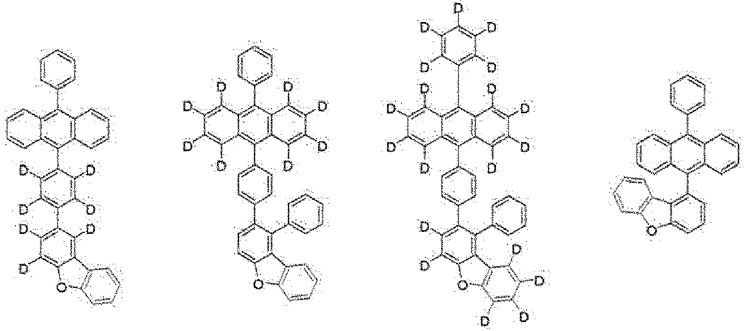

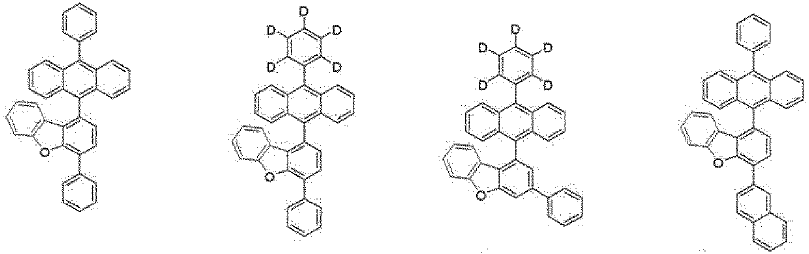

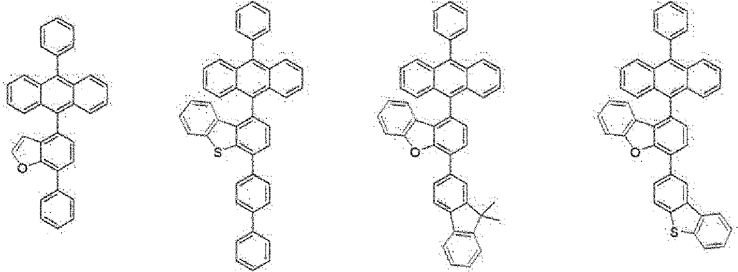

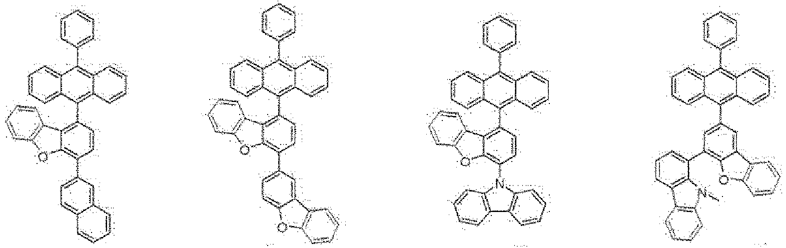

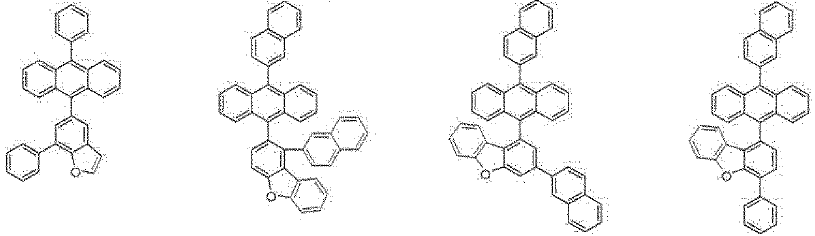

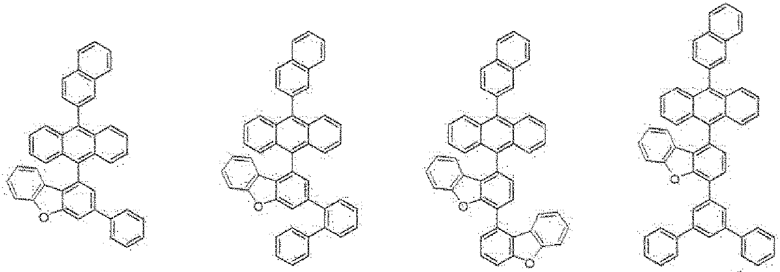

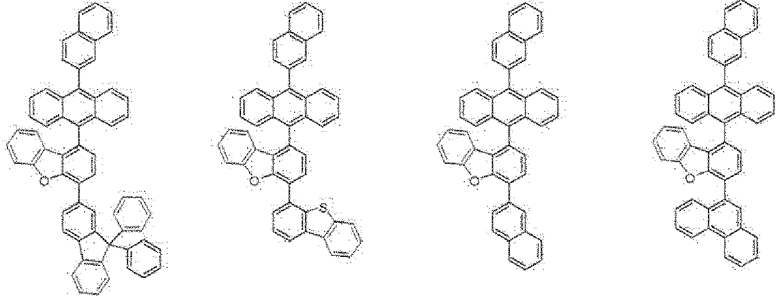

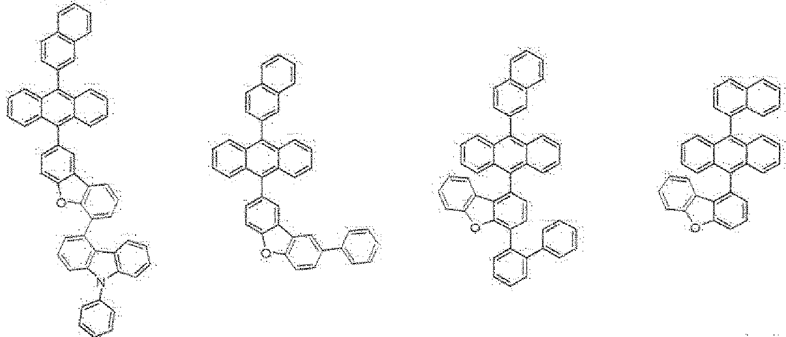

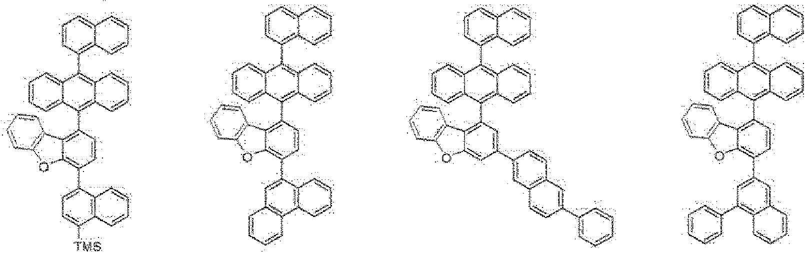

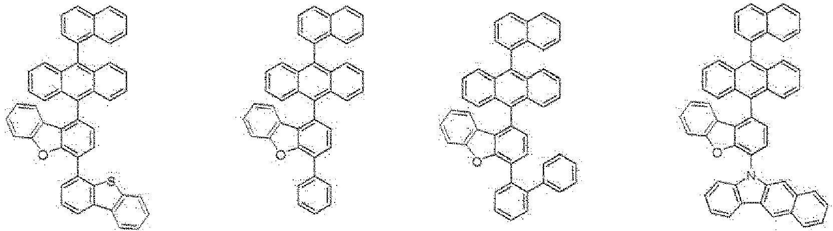

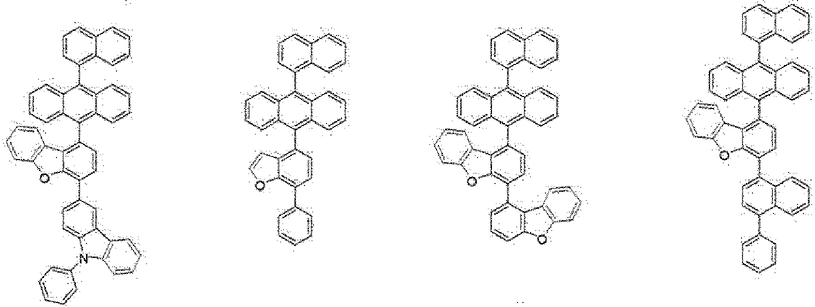

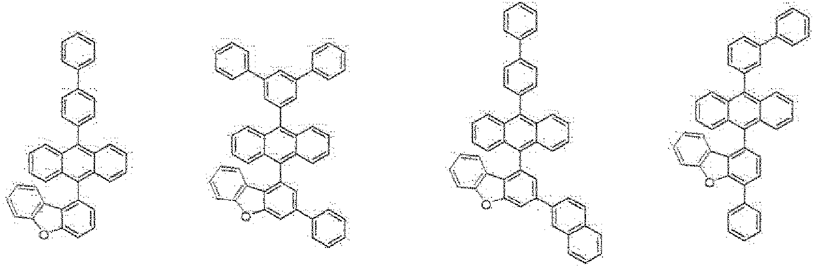

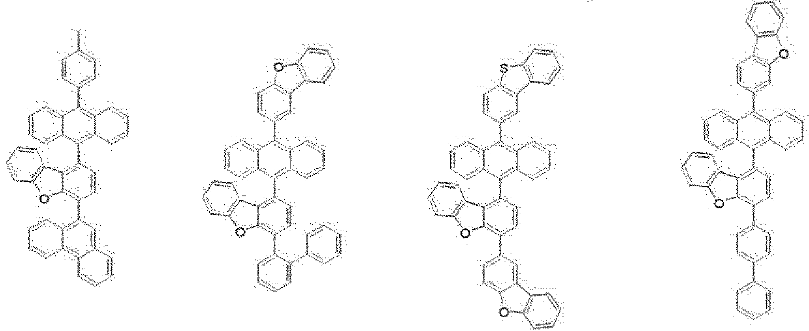

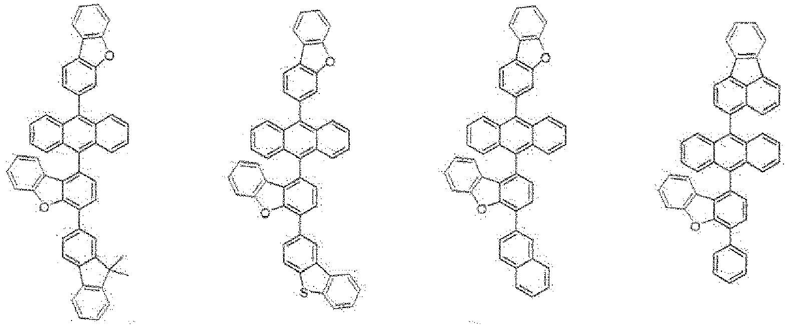

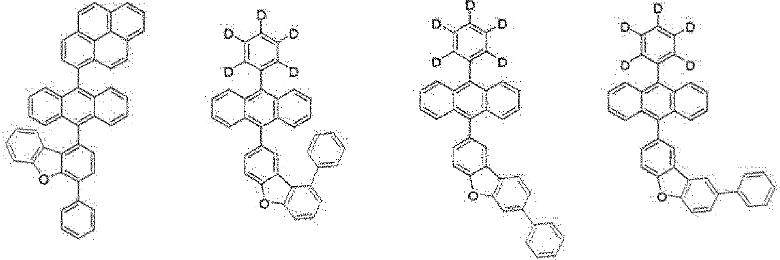

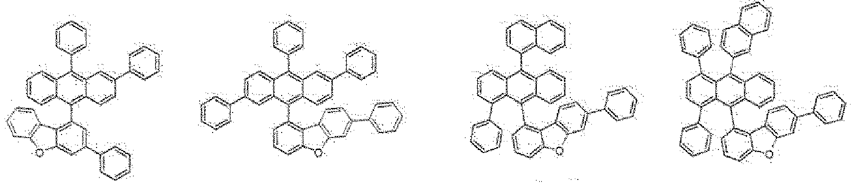

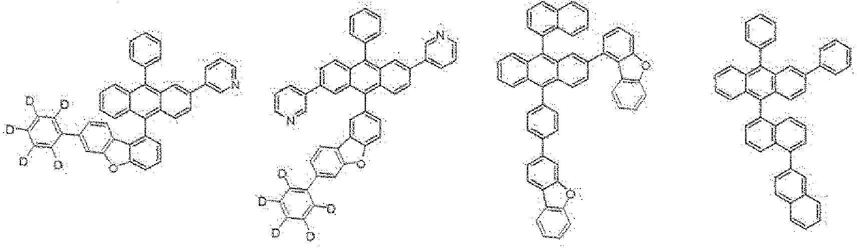

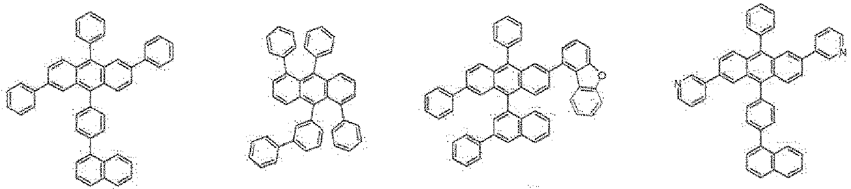

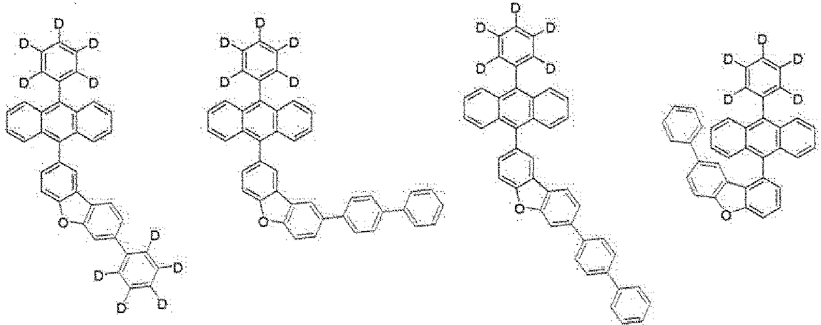

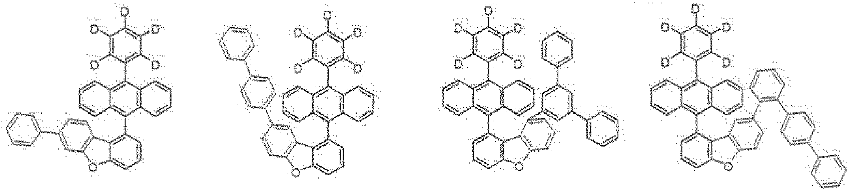

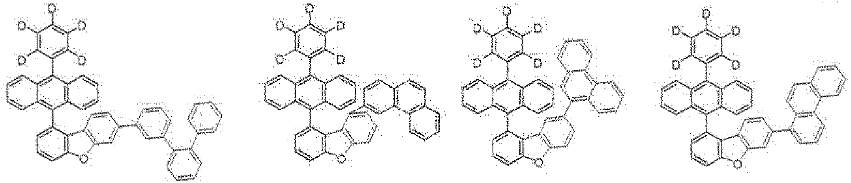

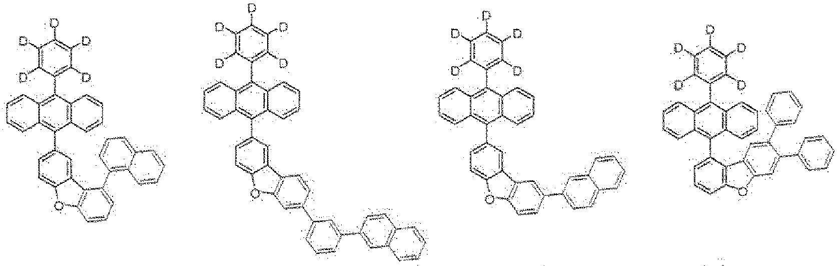

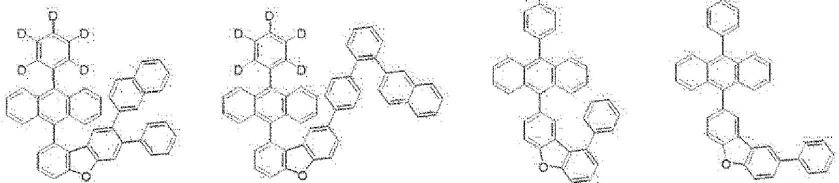

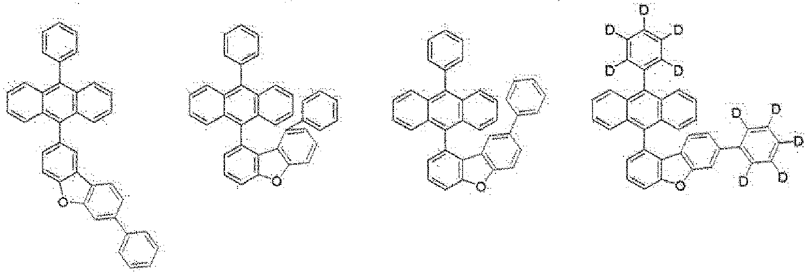

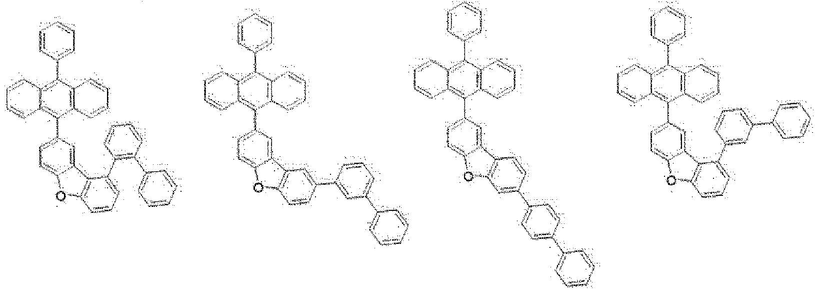

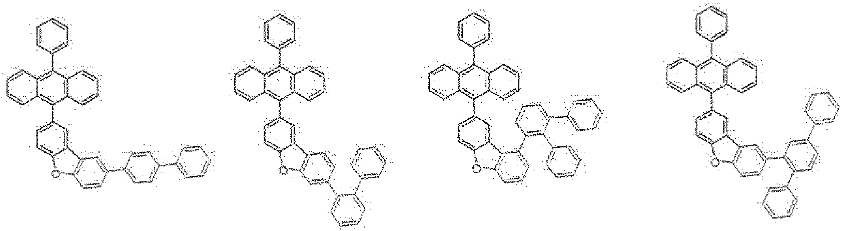

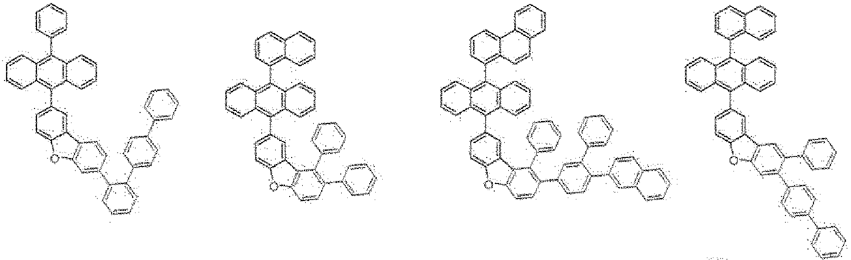

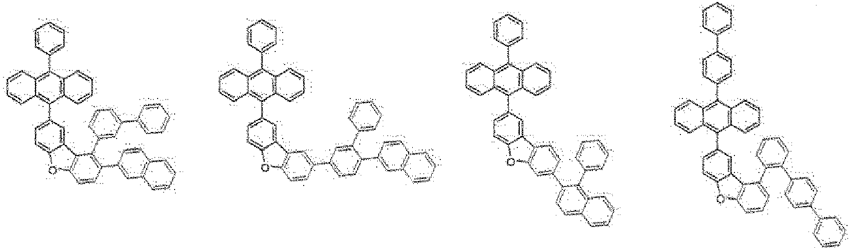

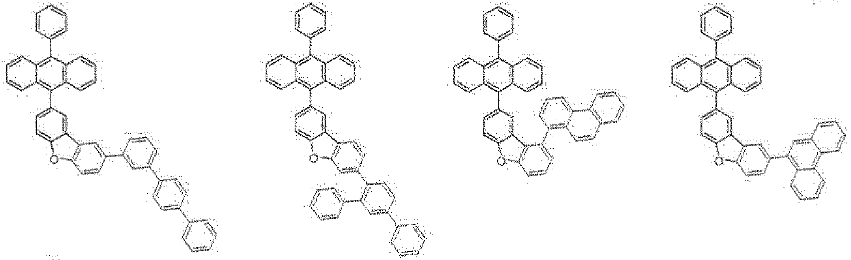

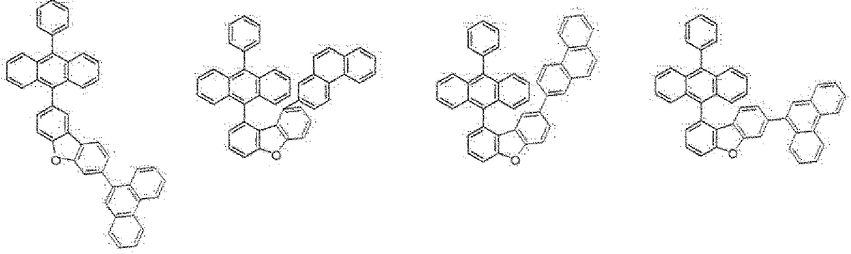

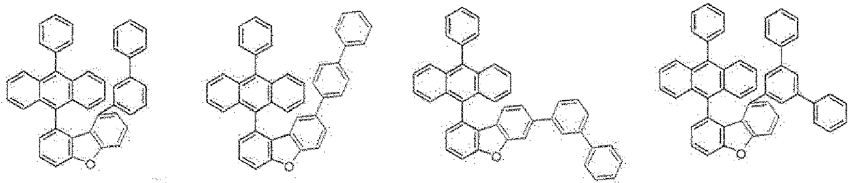

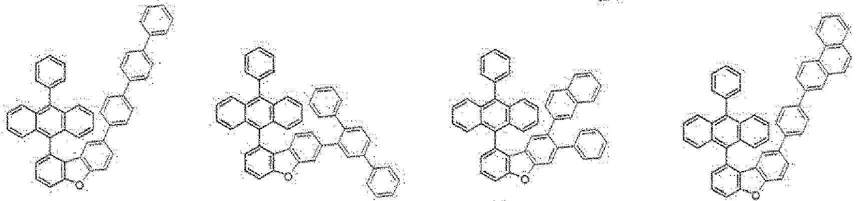

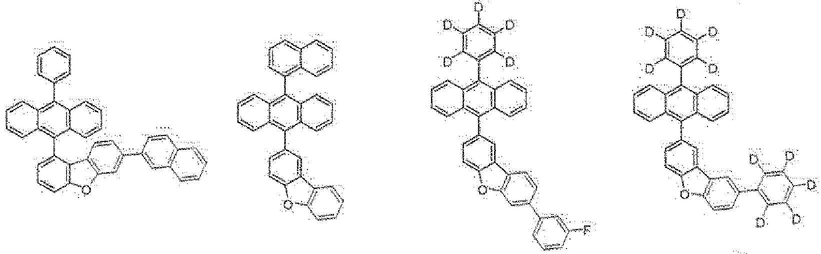

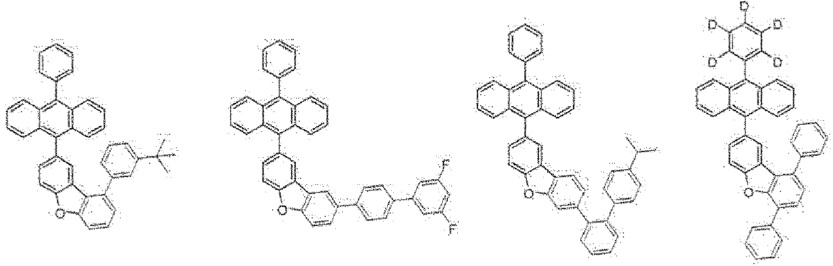

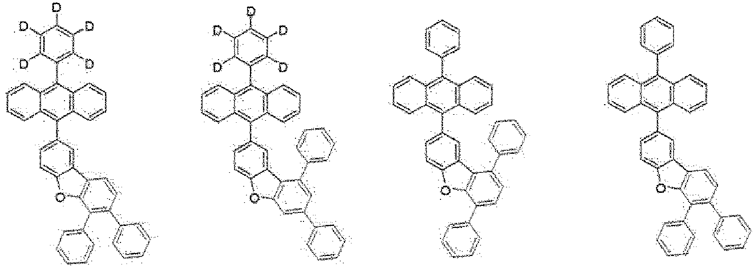

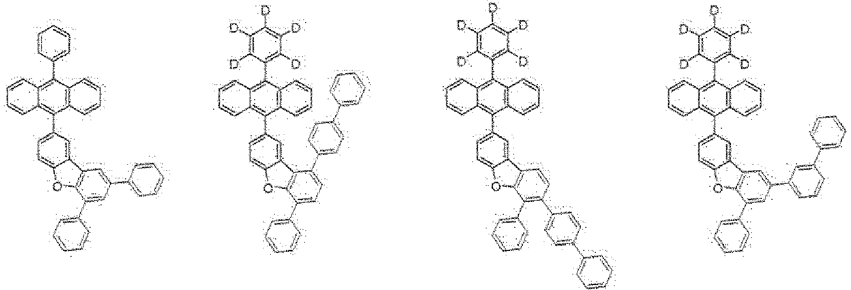

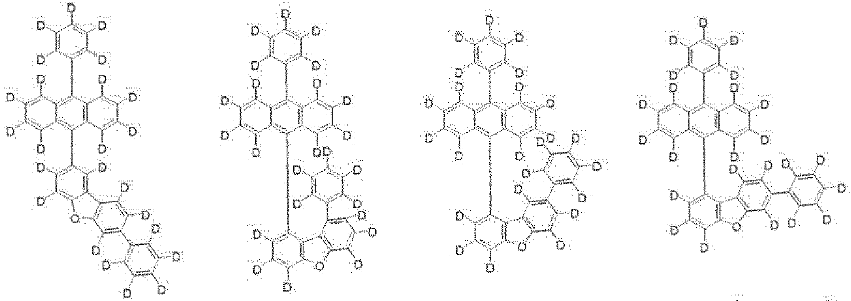

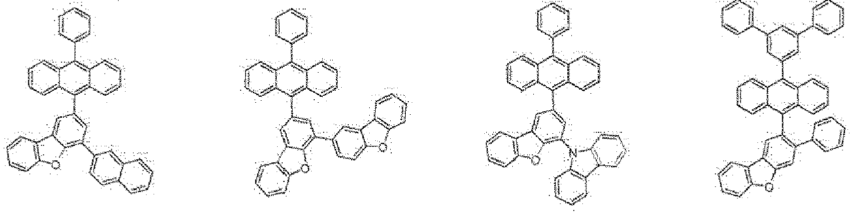

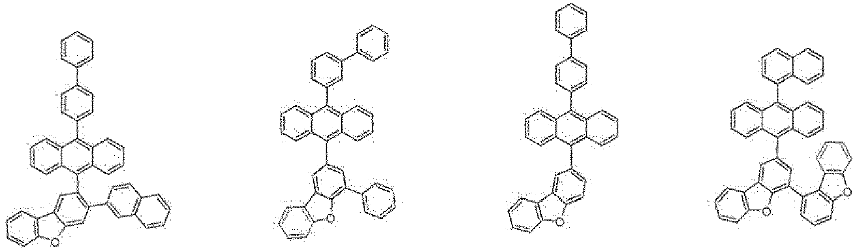

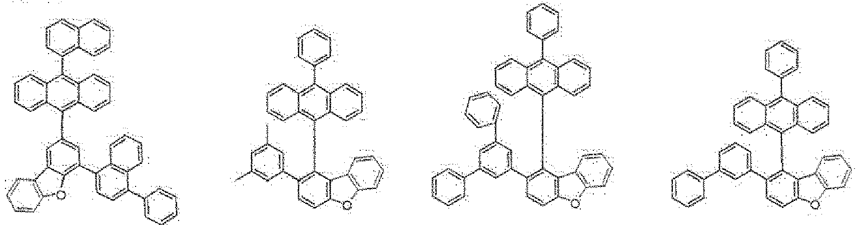

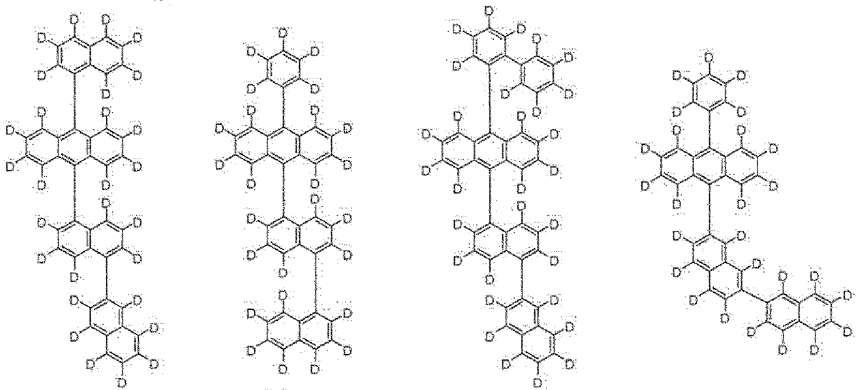

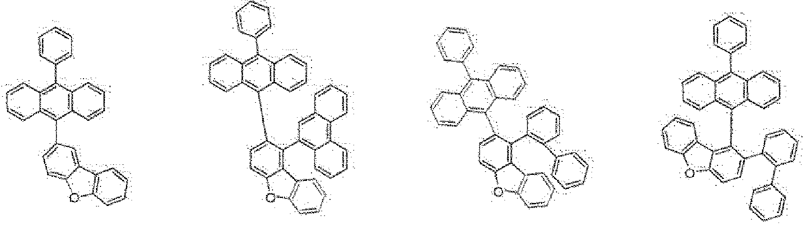

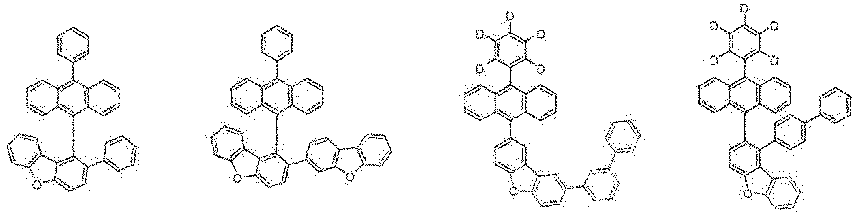

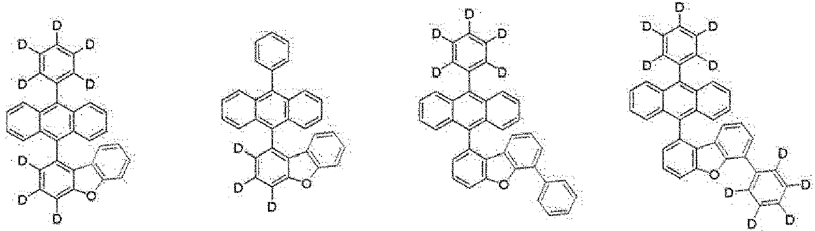

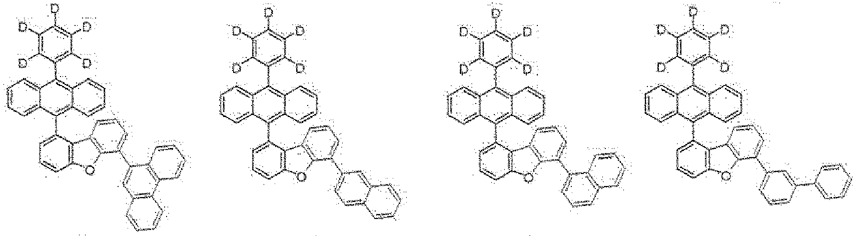

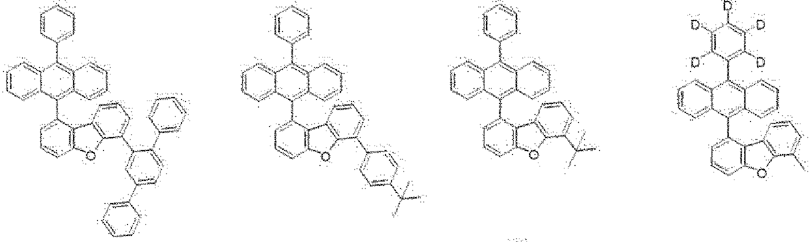

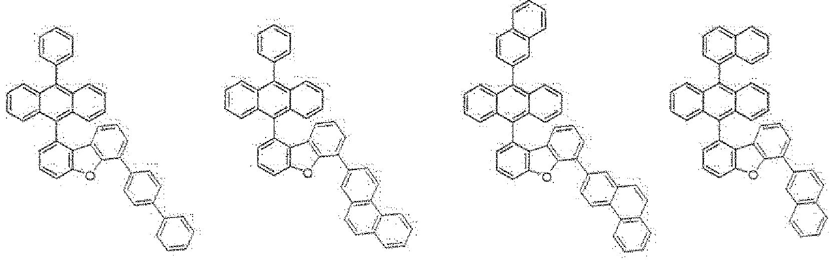

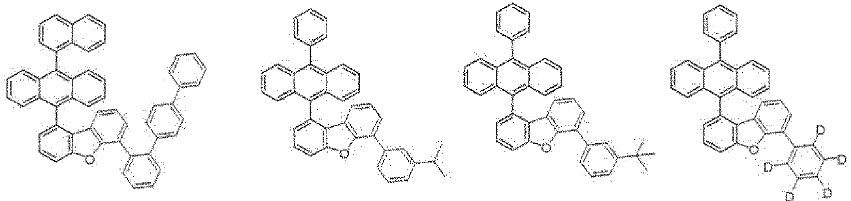

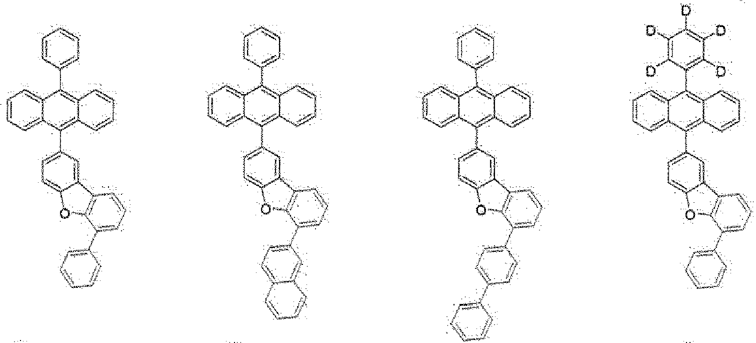

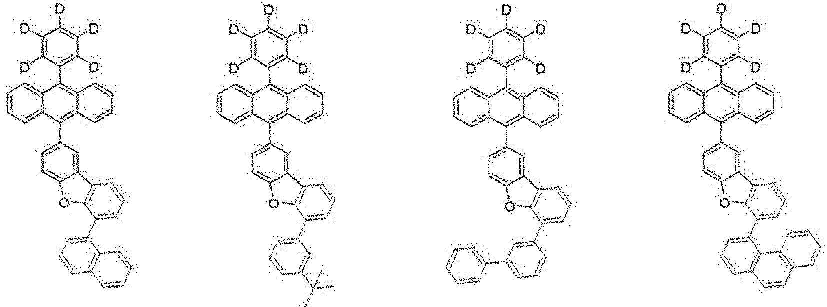

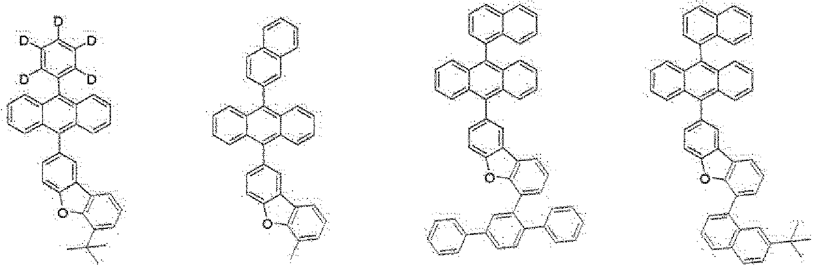

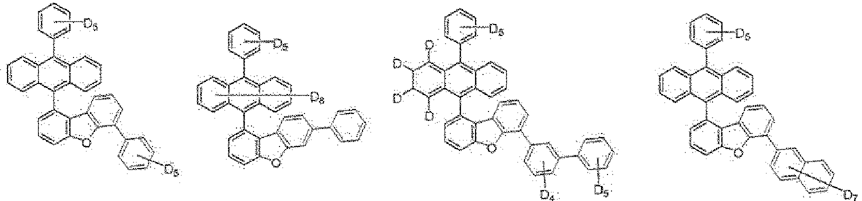

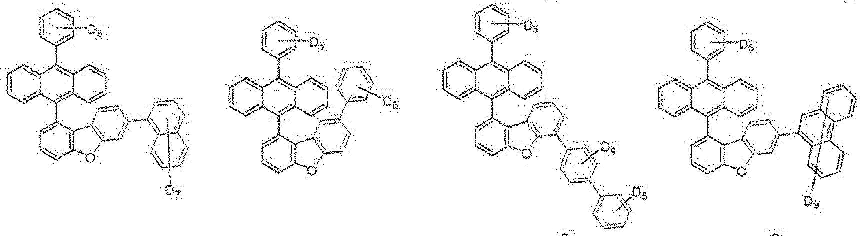

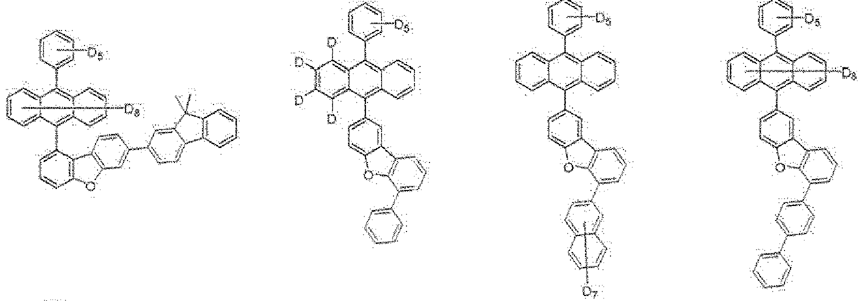

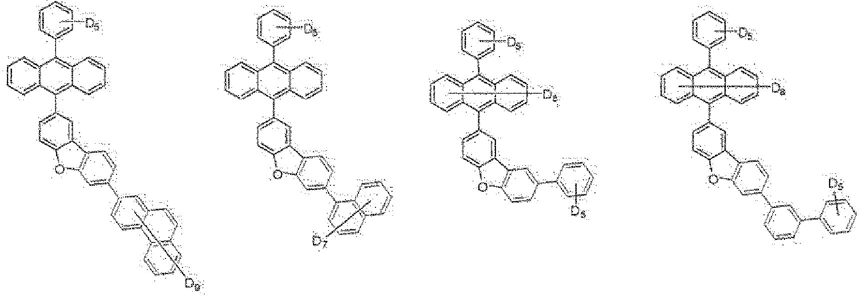

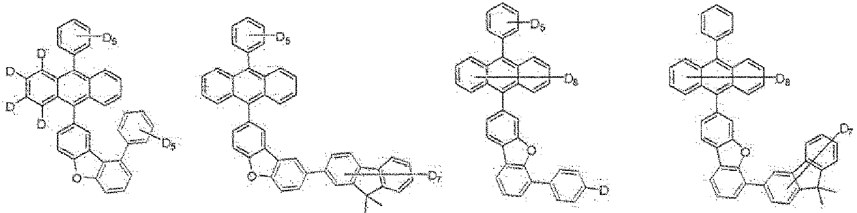

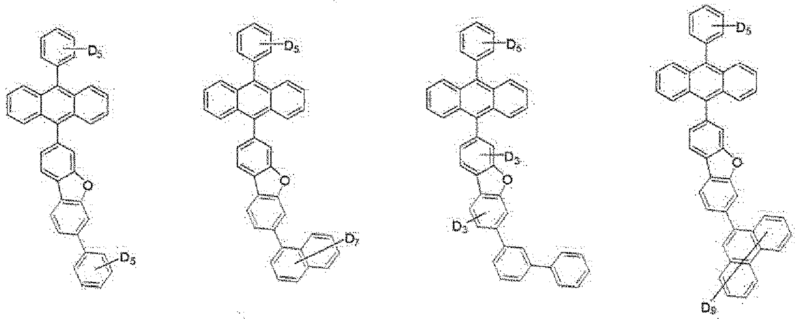

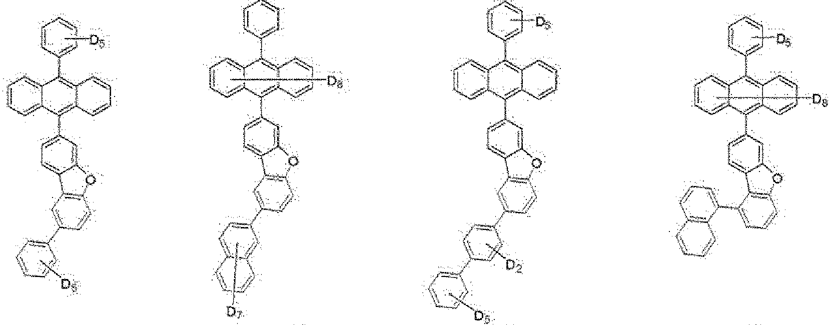

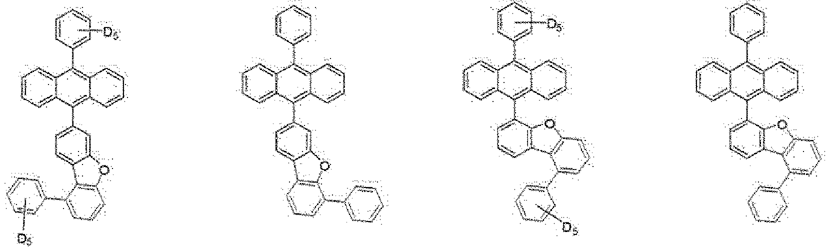

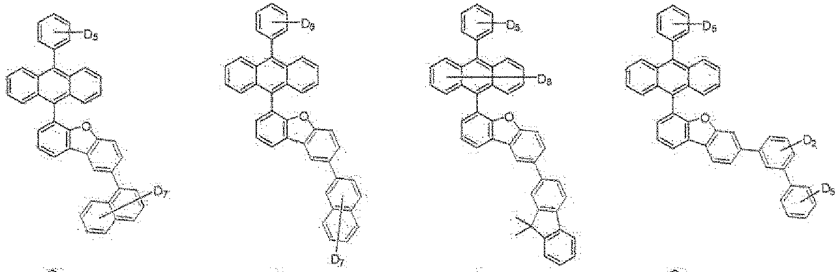

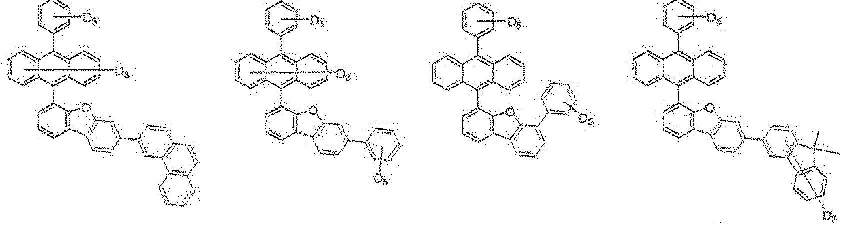

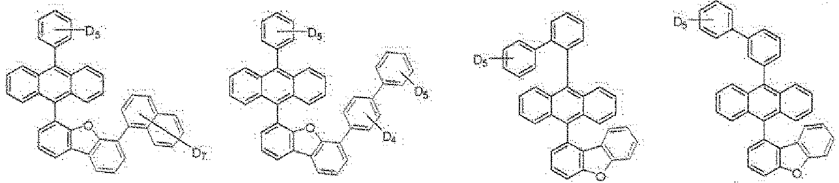

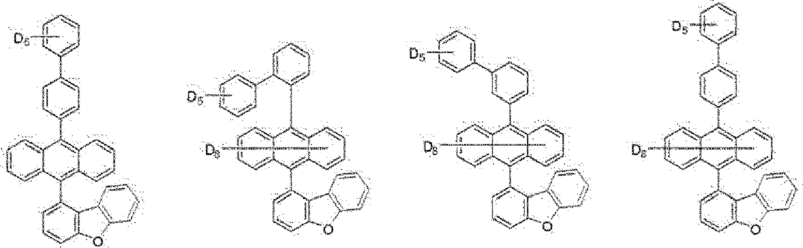

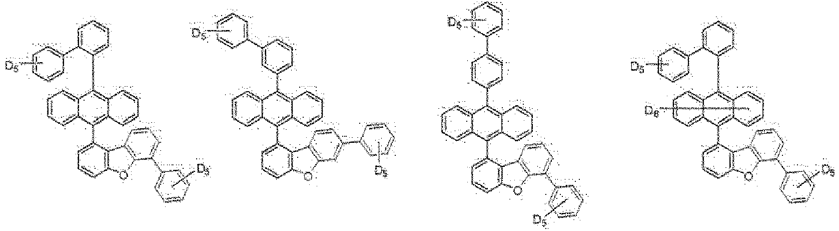

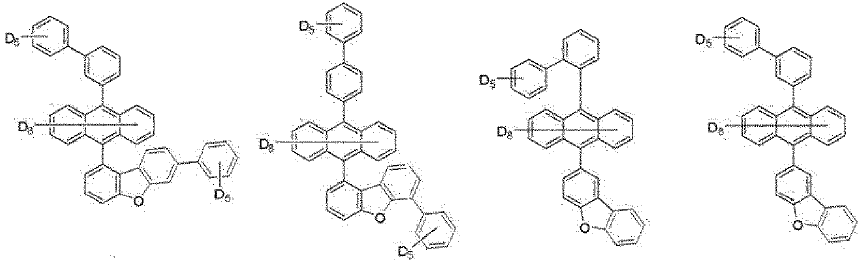

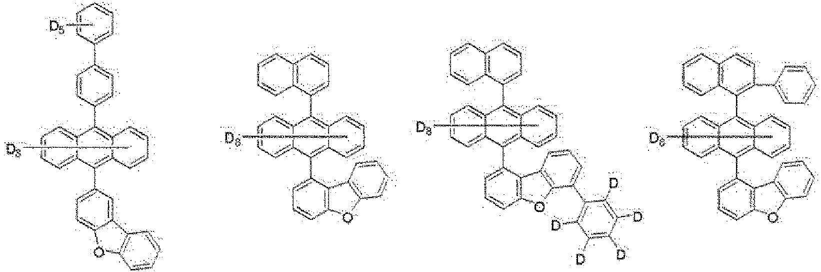

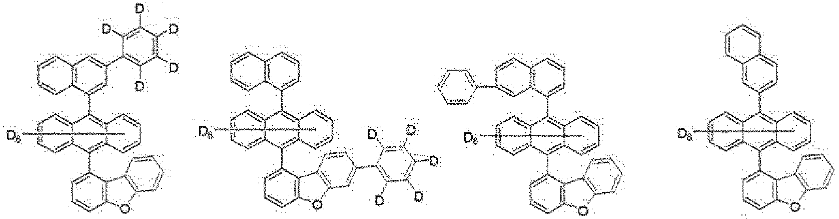

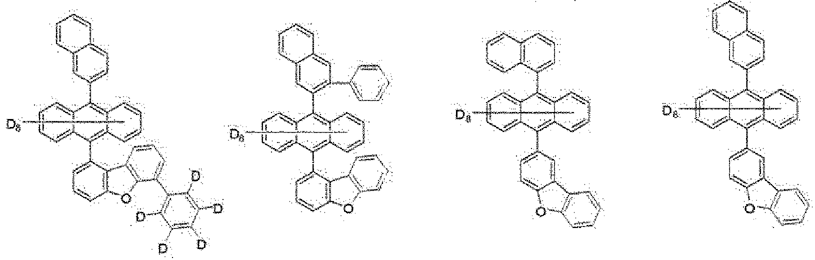

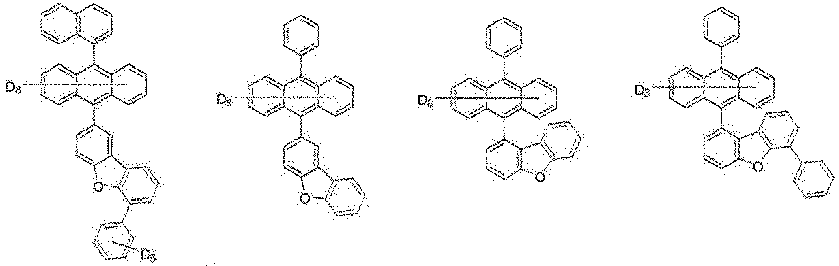

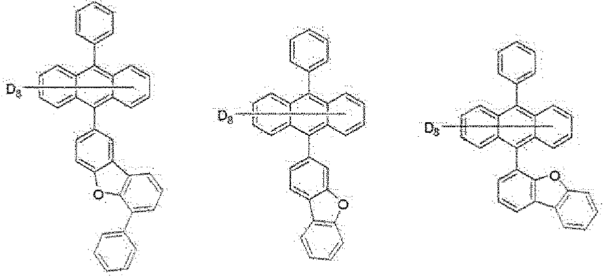

However, these compounds are not intended to limit the scope of Formula H.

The light emitting layer may further include various host materials and various dopant materials in addition to the dopant represented by Formula I and the host represented by Formula H.

According to one embodiment of the present invention, one or more host compounds other than the anthracene compound represented by Formula H may be mixed or stacked in the light emitting layer and one or more dopant compounds other than the polycyclic compound represented by Formula I may be mixed or stacked in the light emitting layer.

A specific structure of the organic light emitting device according to one embodiment of the present invention, a method for fabricating the device, and materials for the organic layers are as follows. First, an anode material is coated on a substrate to form an anode. The substrate may be any of those used in general organic light emitting devices. The substrate is preferably an organic substrate or a transparent plastic substrate that is excellent in transparency, surface smoothness, ease of handling, and waterproofness. A highly transparent and conductive metal oxide such as indium tin oxide (ITO), indium zinc oxide (IZO), tin oxide (SnO₂) or zinc oxide (ZnO) is used as the anode material.

A hole injecting material is coated on the anode by vacuum thermal evaporation or spin coating to form a hole injecting layer. Then, a hole transport material is coated on the hole injecting layer by vacuum thermal evaporation or spin coating to form a hole transport layer.

The hole injecting material is not specially limited so long as it is usually used in the art. Specific examples of such materials include 4,4',4"-tris(2-naphthylphenyl-phenylamino)triphenylamine (2-TNATA), N,N'-di(1-naphthyl)-N,N'-diphenylbenzidine (NPD), N,N'-diphenyl-N,N'-bis(3-methylphenyl)-1,1 '-biphenyl-4,4'-diamine (TPD), N,N'-diphenyl-N,N'-bis(4-(phenyl-m-tolylamino)phenyl)biphenyl-4,4'-diamine (DNTPD), and 1,4,5,8,9,11-hexaazatriphenylenehexacarbonitrile (HAT-CN).

The hole transport material is not specially limited so long as it is commonly used in the art. Examples of such materials include N,N'-bis(3-methylphenyl)-N,N'-diphenyl-(1,1-biphenyl)-4,4'-diamine (TPD) and N,N'-di(naphthalen-1-yl)-N,N'-diphenylbenzidine (α-NPD).

Subsequently, a hole auxiliary layer and a light emitting layer are sequentially laminated on the hole transport layer. A hole blocking layer may be optionally formed on the light emitting layer by vacuum thermal evaporation or spin coating. The hole blocking layer is formed as a thin film and blocks holes from entering a cathode through the organic light emitting layer. This role of the hole blocking layer prevents the lifetime and efficiency of the device from deteriorating. A material having a very low highest occupied molecular orbital (HOMO) energy level is used for the hole blocking layer. The hole blocking material is not particularly limited so long as it can transport electrons and has a higher ionization potential than the light emitting compound. Representative examples of suitable hole blocking materials include BAlq, BCP, and TPBI.

Examples of materials for the hole blocking layer include, but are not limited to, BAlq, BCP, Bphen, TPBI, NTAZ, BeBq₂, OXD-7, and Liq.

An electron transport layer is deposited on the hole blocking layer by vacuum thermal evaporation or spin coating, and an electron injecting layer is formed thereon. A cathode metal is deposited on the electron injecting layer by vacuum thermal evaporation to form a cathode, completing the fabrication of the organic light emitting device.

For example, lithium (Li), magnesium (Mg), aluminum (Al), aluminum-lithium (Al-Li), calcium (Ca), magnesium-indium (Mg-In) or magnesium-silver (Mg-Ag) may be used as the metal for the formation of the cathode. The organic light emitting device may be of top emission type. In this case, a transmissive material such as ITO or IZO may be used to form the cathode.

A material for the electron transport layer functions to stably transport electrons injected from the cathode. The electron transport material may be any of those known in the art and examples thereof include, but are not limited to, quinoline derivatives, particularly tris(8-quinolinolate)aluminum (Alq3), TAZ, Balq, beryllium bis(benzoquinolin-10-olate (Bebq2), and oxadiazole derivatives such as PBD, BMD, and BND.

Each of the organic layers can be formed by a monomolecular deposition or solution process. According to the monomolecular deposition process, the material for each layer is evaporated into a thin film under heat and vacuum or reduced pressure. According to the solution process, the material for each layer is mixed with a suitable solvent and the mixture is then formed into a thin film by a suitable method such as ink-jet printing, roll-to-roll coating, screen printing, spray coating, dip coating or spin coating.

The organic light emitting device of the present invention can be used in a display or lighting system selected from flat panel displays, flexible displays, monochromatic flat panel lighting systems, white flat panel lighting systems, flexible monochromatic lighting systems, flexible white lighting systems, displays for automotive applications, displays for virtual reality, and displays for augmented reality.

### Synthesis Example 1: Synthesis of 17

### Synthesis Example 1-1: Synthesis of A-1

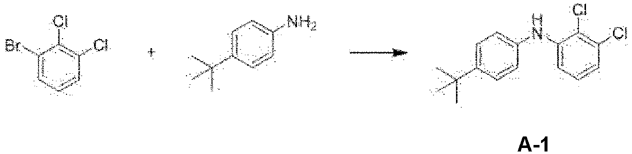

100 g of 1-bromo-2,3-dichlorobenzene, 66.1 g of 4-(tert-butyl)aniline, 1.99 g of palladium acetate(II), 5.51 g of 2,2'-bis(diphenylphosphino)-1,1'-binaphthyl, 85.1 g of sodium tert-butoxide, and 1000 mL of toluene were placed in a reactor. The mixture was stirred under reflux for 3 h. The reaction mixture was cooled to room temperature and ethyl acetate and water were added thereto. The organic layer was separated and purified by silica gel chromatography to afford **A-1** (119.5 g, 91.8%).

### Synthesis Example 1-2: Synthesis of A-2

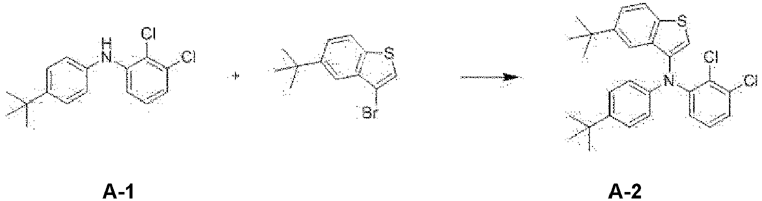

60 g of **A-1**, 65.9 g of 3-bromo-5-(tert-butyl)benzothiophene, 2.08 g of bis(tri-tert-butylphosphine)palladium(0), 39.2 g of sodium tert-butoxide, and 600 mL of toluene were placed in a reactor. The mixture was stirred under reflux for 6 h. The reaction mixture was cooled to room temperature and ethyl acetate and water were added thereto. The organic layer was separated and purified by silica gel chromatography to afford **A-2** (90 g, 91.5%).

### Synthesis Example 1-3: Synthesis of A-3

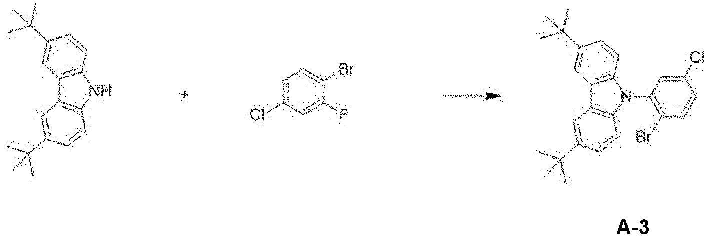

20 g of 3,6-di-tert-butyl-9H-carbazole was placed in a reactor under a nitrogen atmosphere and diluted with 250 mL of N,N-dimethylformamide. 10.5 g of potassium tert-butoxide was added to the diluted solution, followed by stirring under reflux for 20 min. To the mixture was added 16.5 g of 1-bromo-4-chloro-2-fluorobenzene. Stirring was continued under reflux for 10 h. The reaction mixture was cooled to room temperature and extracted with ethyl acetate and distilled water. The extract was dried and concentrated under reduced pressure. The resulting crude product was purified by silica gel chromatography to afford **A-3** (21.5 g, 64%).

### Synthesis Example 1-4: Synthesis of A-4

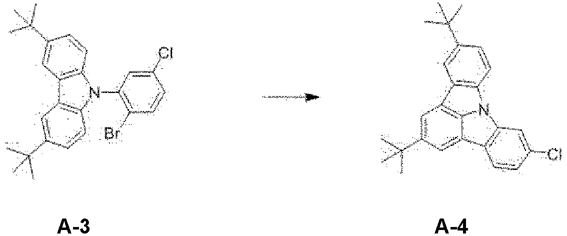

20 g of **A-3** was placed in a reactor under a nitrogen atmosphere and 0.1 g of palladium acetate(II), 0.17 g of tri-tert-butylphosphine, 11.8 g of potassium carbonate, and 400 mL of dimethylacetamide were added thereto. The mixture was stirred under reflux for 5 h. The reaction mixture was concentrated under reduced pressure to remove dimethylacetamide. The concentrate was extracted with ethyl acetate and distilled water. Thereafter, the extract was dried and concentrated under reduced pressure. The resulting crude product was purified by silica gel chromatography to afford **A-4** (11 g, 66%).

### Synthesis Example 1-5: Synthesis of A-5

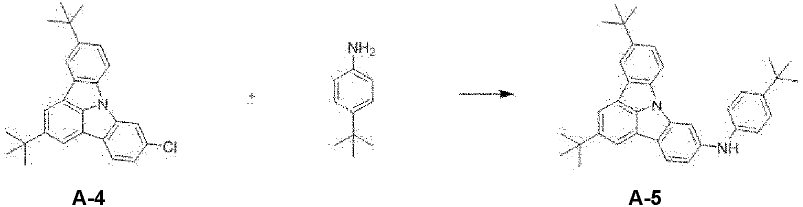

16.8 g of **A-4**, 9.7 g of 4-(tert-butyl)aniline, 0.66 g of bis(tri-tert-butylphosphine)palladium(0), 8.32 g of sodium tert-butoxide, and 170 mL of toluene were placed in a reactor. The mixture was stirred under reflux for 16 h. The reaction mixture was cooled to room temperature and ethyl acetate and water were added thereto. The organic layer was separated and purified by silica gel chromatography to afford **A-5** (14.5 g, 67%).

### Synthesis Example 1-6: Synthesis of A-6

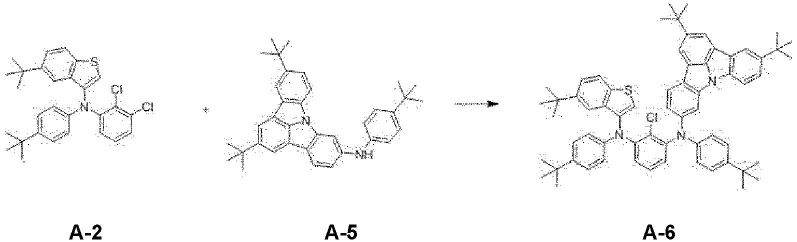

14 g of **A-2**, 14.53 g of **A-5**, 0.3 g of bis(tri-tert-butylphosphine)palladium(0), 5.6 g of sodium tert-butoxide, and 250 mL of toluene were placed in a reactor. The mixture was stirred under reflux for 16 h. The reaction mixture was cooled to room temperature and ethyl acetate and water were added thereto. The organic layer was separated and purified by silica gel chromatography to afford **A-6** (24.1 g, 87.7%).

### Synthesis Example 1-7: Synthesis of 17

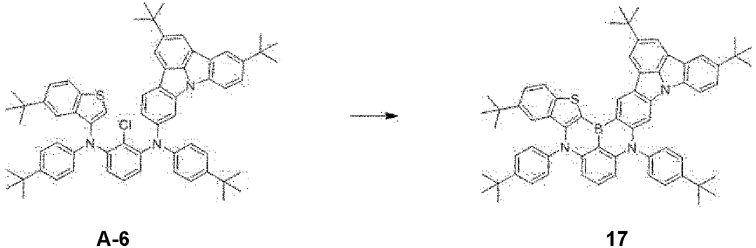

24 g of **A-6** and 300 mL of tert-butylbenzene were placed in a reactor and 42 mL of a 1.7 M tert-butyllithium pentane solution was added dropwise thereto at -78 °C. The mixture was heated to 60 °C, followed by stirring for 2 h. Then, nitrogen was blown into the mixture at 60 °C to completely remove pentane. After cooling to -78 °C, 4.0 mL of boron tribromide was added dropwise. The resulting mixture was allowed to warm to room temperature, followed by stirring for 2 h. After cooling to 0 °C, 8.0 mL of N,N-diisopropylethylamine was added dropwise. The mixture was heated to 120 °C, followed by stirring for 16 h. The reaction mixture was cooled to room temperature and a 10% aqueous solution of sodium acetate and ethyl acetate were added thereto. The organic layer was separated, concentrated under reduced pressure, and purified by silica gel chromatography to afford **17** (2.8 g, 12%).
MS (MALDI-TOF): m/z 919.51 [M⁺]

### Synthesis Example 2: Synthesis of 31

### Synthesis Example 2-1: Synthesis of 31

**31** (yield 10.6%) was synthesized in the same manner as in Synthesis Example 1, except that 4-chloroindolo[3,2,1-jk]carbazole was used instead of **A-4** in Synthesis Example 1-5.
MS (MALDI-TOF): m/z 807.38 [M⁺]

### Synthesis Example 3: Synthesis of 38

### Synthesis Example 3-1: Synthesis of 38

**38** (yield 9.9%) was synthesized in the same manner as in Synthesis Example 1, except that 7-chloroindolo[3,2,1-jk]carbazole was used instead of **A-4** in Synthesis Example 1-5.
MS (MALDI-TOF): m/z 807.38 [M⁺]

### Synthesis Example 4: Synthesis of 68

### Synthesis Example 4-1: Synthesis of 68

**68** (yield 10.1%) was synthesized in the same manner as in Synthesis Example 1, except that dibenzo[b,d]furan-4-amine was used instead of 4-(tert-butyl)aniline in Synthesis Example 1-5.
MS (MALDI-TOF): m/z 953.46 [M⁺]

### Synthesis Examples 1-4: Fabrication of organic light emitting devices

ITO glass was patterned to have a light emitting area of 2 mm × 2 mm, followed by cleaning. After torr (wherein 1 torr = 133.322 Pa). the cleaned ITO glass was mounted in a vacuum chamber, the base pressure was adjusted to 1 × 10⁻⁷ The compound represented by Acceptor-1 as an electron acceptor and the compound represented by Formula F were deposited in a ratio of 2:98 on the ITO to form a 100 Å thick hole injecting layer. The compound represented by Formula F was used to form a 550 Å thick hole transport layer. Subsequently, the compound represented by Formula G was used to form a 50 Å thick electron blocking layer. A mixture of the host represented by BH-1 and the inventive compound (2 wt-%) shown in Table 1 was used to form a 200 Å thick light emitting layer. Thereafter, the compound represented by Formula H was used to form a 50 Å hole blocking layer on the light emitting layer. A mixture of the compound represented by Formula E-1 and the compound represented by Formula E-2 in a ratio of 1:1 was used to form a 250 Å thick electron transport layer on the hole blocking layer. The compound represented by Formula E-2 was used to form a 10 Å thick electron injecting layer on the electron transport layer. AI was used to form a 1000 Å thick Al electrode on the electron injecting layer, completing the fabrication of an organic light emitting device. The luminescent properties of the organic light emitting device were measured at 10 mA/cm².

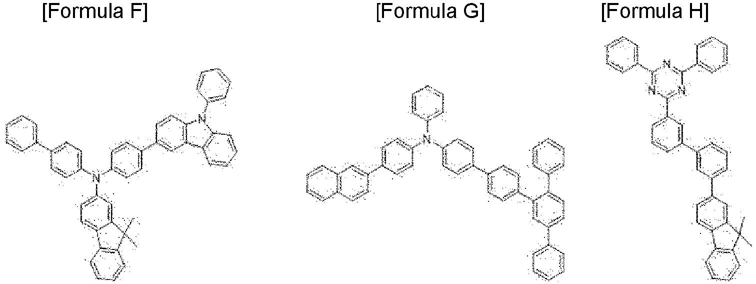

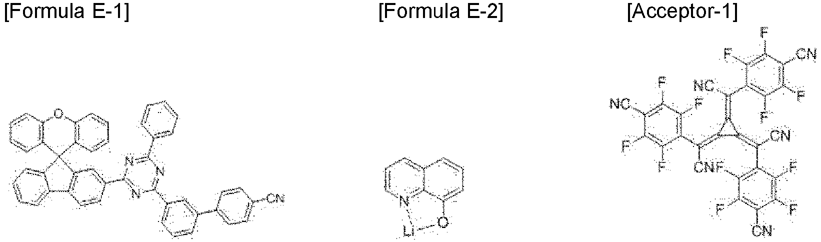

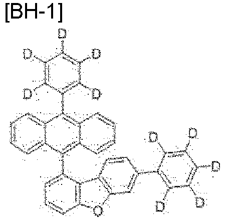

### Comparative Example 1

An organic light emitting device was fabricated in the same manner as in Examples 1-4, except that BD1 was used as a dopant compound instead of the inventive compound. The luminescent properties of the organic light emitting device were measured at 10 mA/cm². The structure of BD1 is as follow:

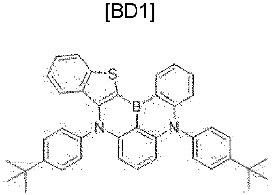

**[Table 1]**

| Example No. | Dopant | Current density (mA/cm²) | Efficiency (EQE, %) | Lifetime (T97, hr) |
|---|---|---|---|---|
| Example 1 | 17 | 10 | 9.81 | 169 |
| Example 2 | 31 | 10 | 9.12 | 129 |
| Example 3 | 38 | 10 | 8.95 | 126 |
| Example 4 | 68 | 10 | 10.24 | 180 |
| Comparative Example 1 | BD-1 | 10 | 7.92 | 85 |

As can be seen from the results in Table 1, the organic light emitting devices of Examples 1-4, each of which employed the inventive compound as a dopant compound in the light emitting layer, showed significantly improved life characteristics and high external quantum efficiencies compared to the device of Comparative Example 1, which employed a compound whose structural features are contrasted with those of the inventive compound. These results concluded that the use of the inventive compounds makes the organic light emitting devices highly efficient and long lasting. The polycyclic compound of the present invention can be employed in an organic layer of an organic light emitting device to achieve high efficiency and long lifetime of the device. Therefore, the polycyclic compound of the present invention can find useful industrial applications in various displays, including flat panel displays, flexible displays, displays for automotive applications, displays for virtual reality, and displays for augmented reality, and lighting systems, including monochromatic flat panel lighting systems, white flat panel lighting systems, flexible monochromatic lighting systems, and flexible white lighting systems.

## Claims

1. A polycyclic compound represented by Formula I: 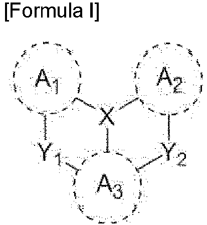
wherein X is B, P=O, P=S or Al, Y₁ and Y₂ are each independently NR₁, O, S, CRR₂R₃ or SiR₄R₅, and A₁ to A₃ are each independently selected from substituted or unsubstituted C₅-C₅₀ aromatic hydrocarbon rings, substituted or unsubstituted C₂-C₅₀ aromatic heterocyclic rings, substituted or unsubstituted C₃-C₃₀ aliphatic rings, and substituted or unsubstituted C₃-C₃₀ mixed aliphatic-aromatic rings, and comprising the structure represented by Structural Formula A: 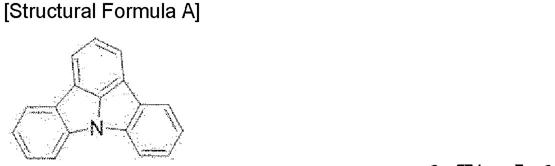
with the proviso that at least one of A₁ to A₃ is the structure represented by Structural Formula A, the structure represented by Structural Formula A is optionally substituted with one or more radicals R, R and R₁ to R₅ are the same as or different from each other and are each independently selected from hydrogen, deuterium, substituted or unsubstituted C₁-C₃₀ alkyl, substituted or unsubstituted C₂-C₃₀ alkenyl, substituted or unsubstituted C₆-C₅₀ aryl, substituted or unsubstituted C₃-C₃₀ cycloalkyl, substituted or unsubstituted C₃-C₃₀ heterocycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted C₃-C₃₀ mixed aliphatic-aromatic cyclic groups, nitro, cyano, and halogen, the substituents of each of the rings A₁ to A₃ are optionally linked to each other to form an alicyclic or aromatic monocyclic or polycyclic ring, each of R₁ to R₅ is optionally linked to an adjacent substituent of at least one of the rings A₁ to A₃ to form an alicyclic or aromatic monocyclic or polycyclic ring, the radicals R are optionally linked to each other to form an alicyclic or aromatic monocyclic or polycyclic ring, R₂ and R₃ are optionally linked to each other to form an alicyclic or aromatic monocyclic or polycyclic ring, and R₄ and R₅ are optionally linked to each other to form an alicyclic or aromatic monocyclic or polycyclic ring,
the term "substituted" in the definition of the rings A₁ to A₃, R, R₁ to R₅, etc. indicates substitution with one or more substituents selected from deuterium, cyano, halogen, hydroxyl, nitro, alkyl, cycloalkyl, haloalkyl, alkenyl, alkynyl, heteroalkyl, heterocycloalkyl, aryl, arylalkyl, heteroaryl, heteroarylalkyl, alkoxy, alkylamine, arylamine, heteroarylamine, alkylsilyl, arylsilyl, and aryloxy, or a combination thereof.

2. The polycyclic compound according to claim 1, wherein the polycyclic compound is represented by one of Formulas I-1 and I-2: 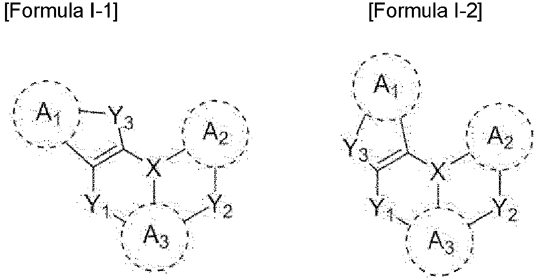 wherein Y₃ is NR₁, O, S, CRR₂R₃ or SiR₄R₅, R₁ to R₅ are as defined in Formula I, and X, Y₁, Y₂, and A₁ to A₃ are as defined in Formula I.

3. The polycyclic compound according to claim 1, wherein the polycyclic compound is selected from the following compounds:

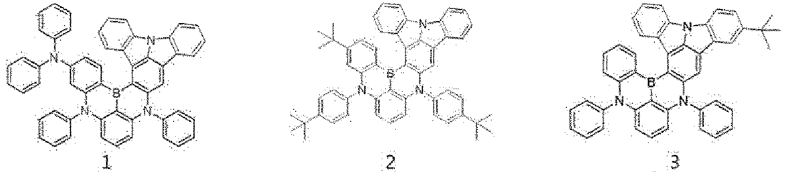

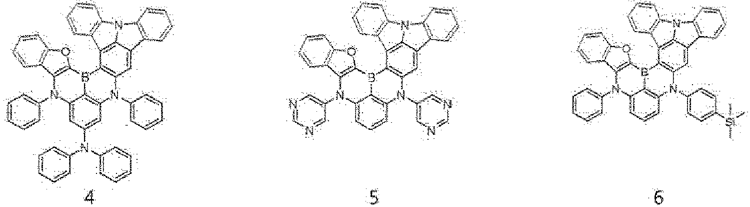

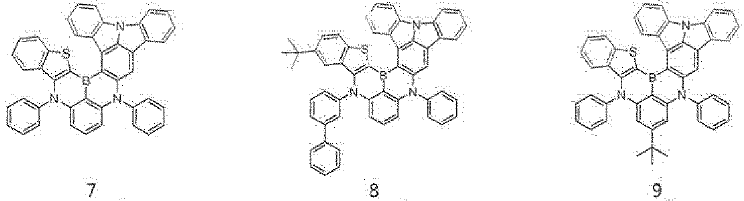

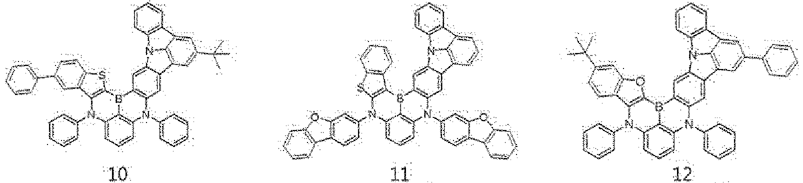

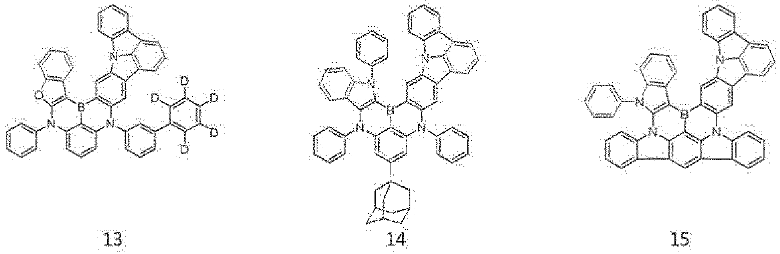

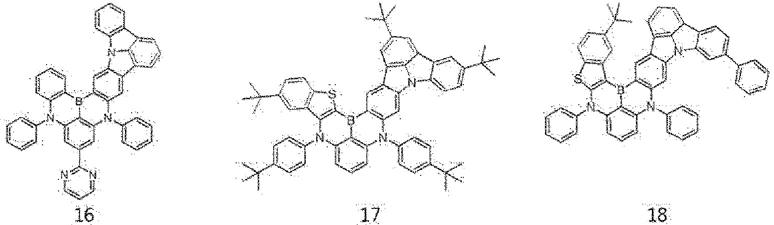

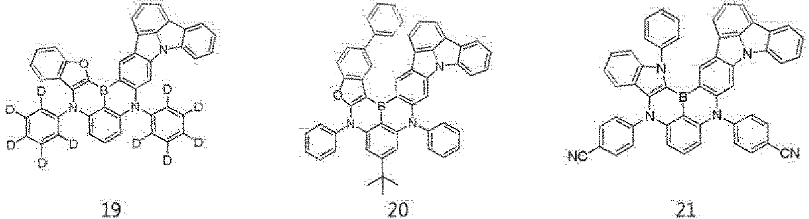

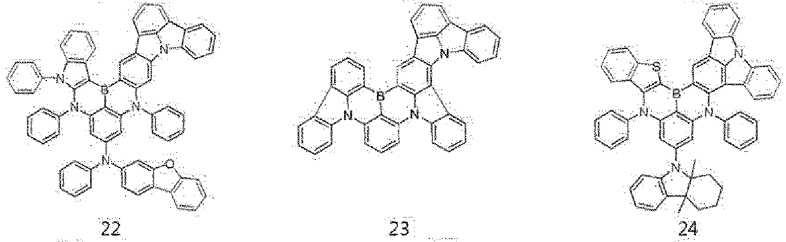

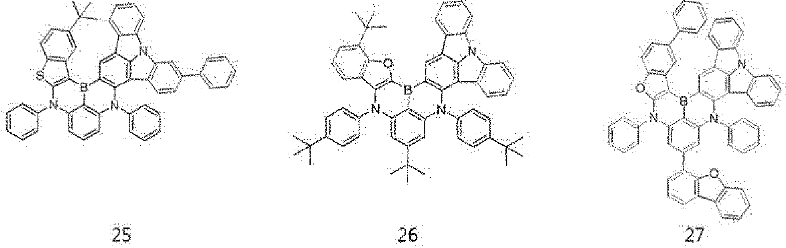

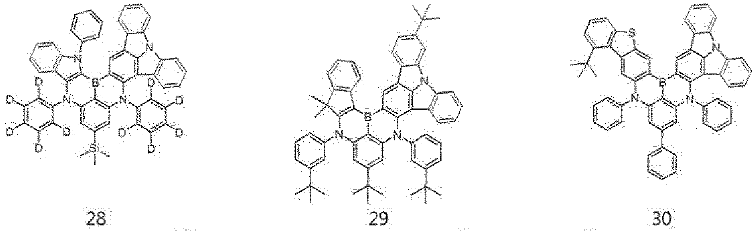

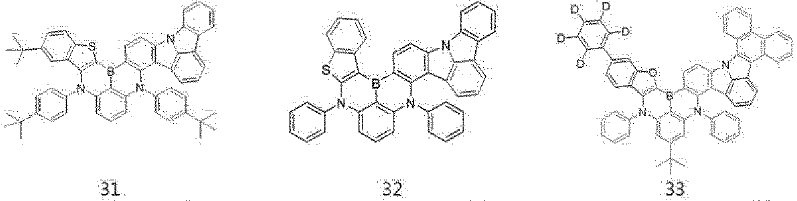

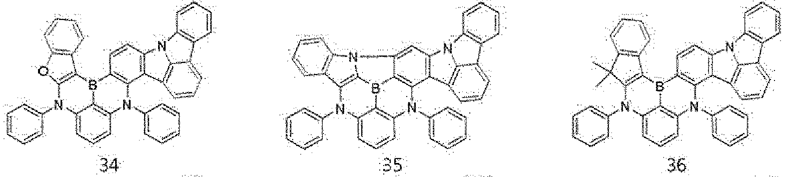

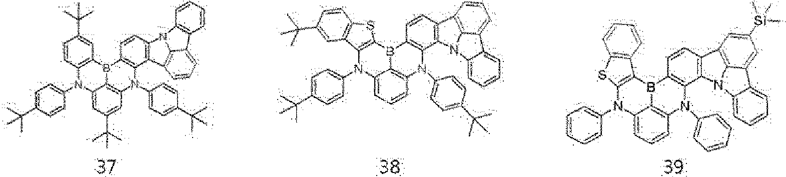

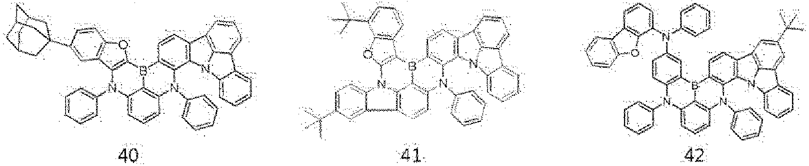

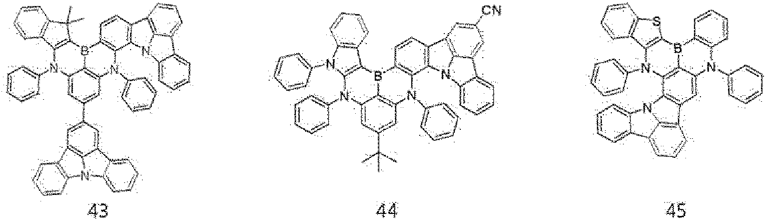

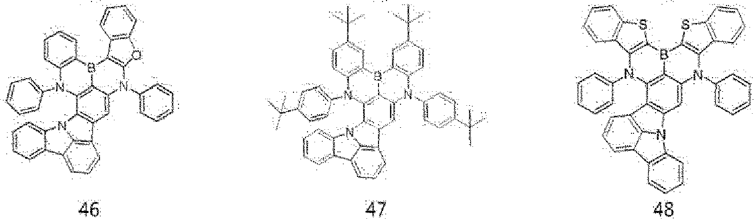

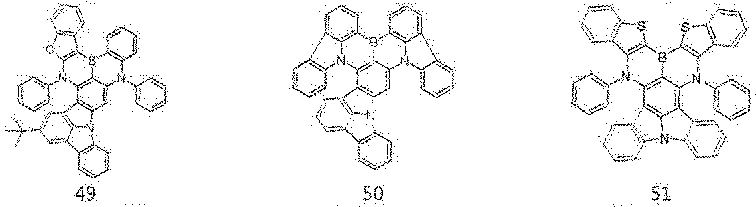

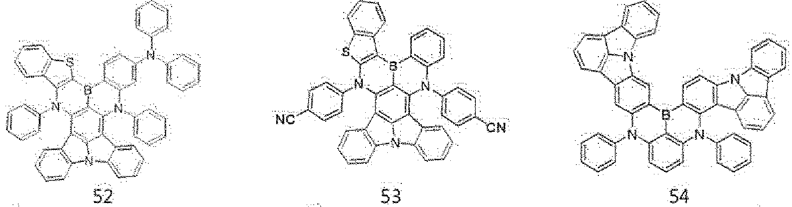

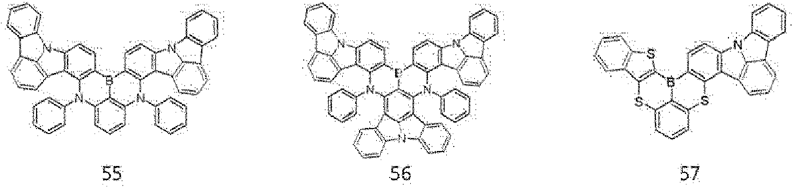

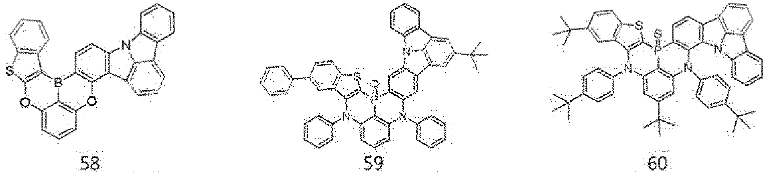

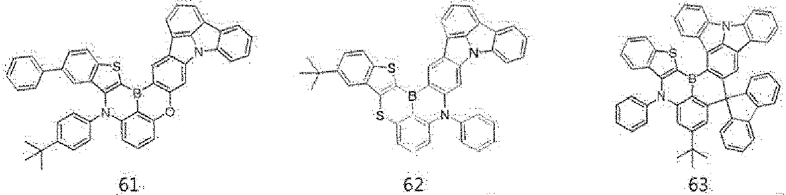

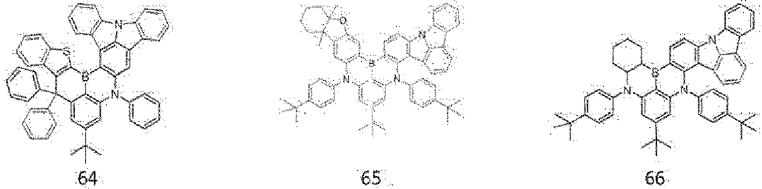

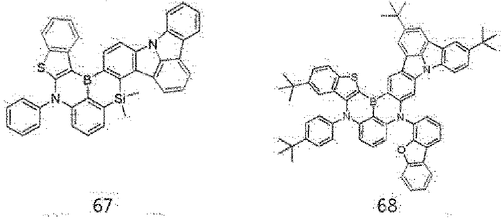

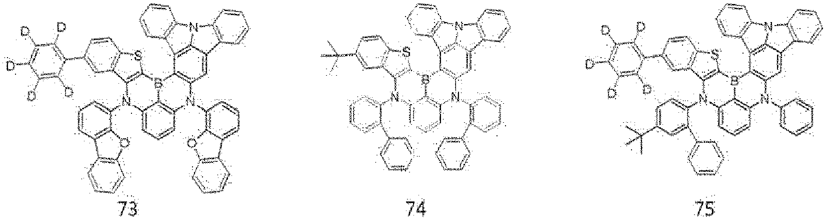

4. An organic light emitting device comprising a first electrode, a second electrode opposite to the first electrode, and one or more organic layers interposed between the first and second electrodes wherein one of the organic layers comprises the polycyclic compounds represented by Formula I according to claim 1.

5. The organic light emitting device according to claim 4, wherein the organic layers comprise an electron injecting layer, an electron transport layer, a hole injecting layer, a hole transport layer, an electron blocking layer, a hole blocking layer, and/or a light emitting layer, at least one of which comprises the organic light emitting compound represented by Formula I.

6. The organic light emitting device according to claim 5, wherein the light emitting layer is composed of a host and the compound represented by Formula I as a dopant.

7. The organic light emitting device according to claim 6, wherein the host is an anthracene compound represented by Formula H: 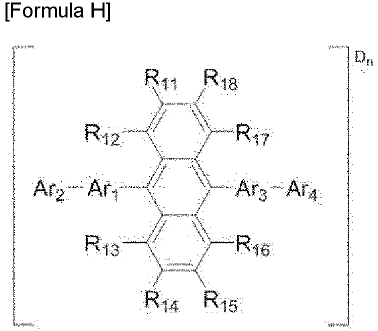 **wherein** R₁₁ to R₁₈ are the same as or different from each other and are each independently selected from hydrogen, substituted or unsubstituted C₁-C₃₀ alkyl, substituted or unsubstituted C₂-C₃₀ alkenyl, substituted or unsubstituted C₆-C₅₀ aryl, substituted or unsubstituted C₃-C₃₀ cycloalkyl, substituted or unsubstituted C₃-C₃₀ heterocycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted C₃-C₂₀ mixed aliphatic-aromatic cyclic groups, nitro, cyano, and halogen, Ar₁ and Ar₃ are the same as or different from each other and are each independently substituted or unsubstituted C₆-C₃₀ arylene or substituted or unsubstituted C₅-C₃₀ heteroarylene, Ar₂ and Ar₄ are the same as or different from each other and are each independently selected from hydrogen, substituted or unsubstituted C₆-C₅₀ aryl, substituted or unsubstituted C₃-C₃₀ cycloalkyl, substituted or unsubstituted C₃-C₃₀ heterocycloalkyl, substituted or unsubstituted C₂-C₅₀ heteroaryl, and substituted or unsubstituted C₃-C₂₀ mixed aliphatic-aromatic cyclic groups, Dₙ represents the number of deuterium atoms replacing hydrogen atoms, and n is an integer from 0 to 50.

8. The organic light emitting device according to claim 7, wherein the compound represented by Formula H is selected from the group consisting of the following compounds:

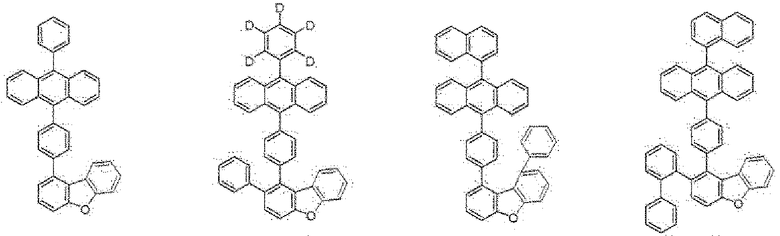

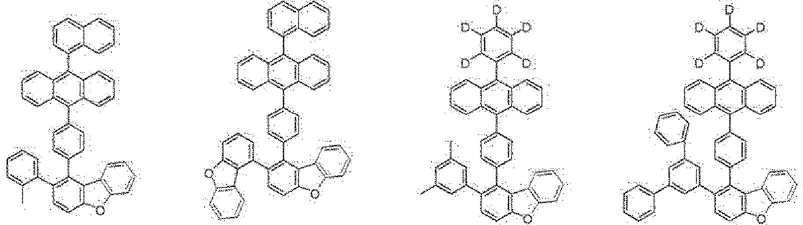

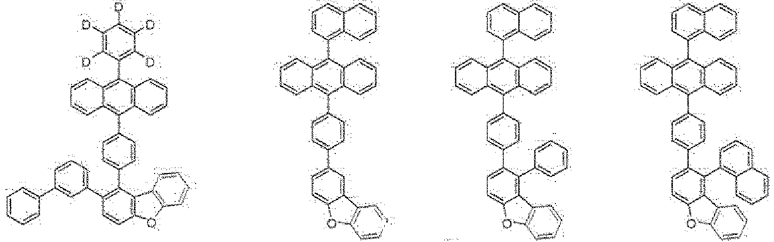

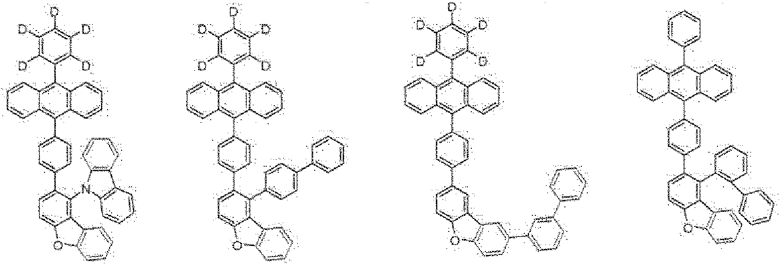

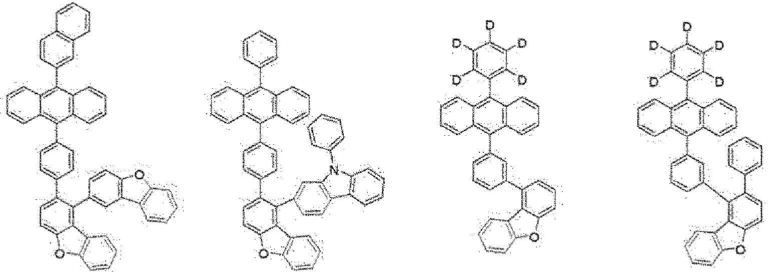

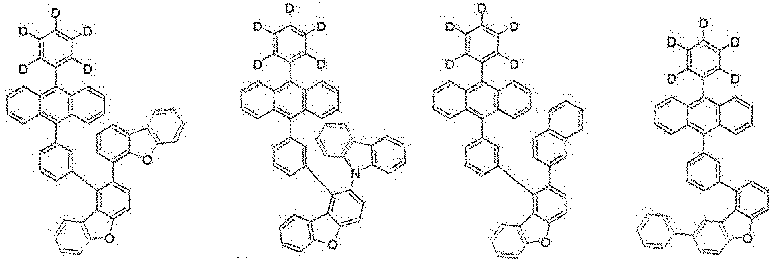

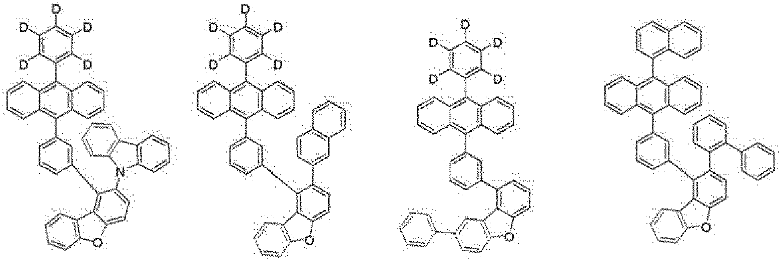

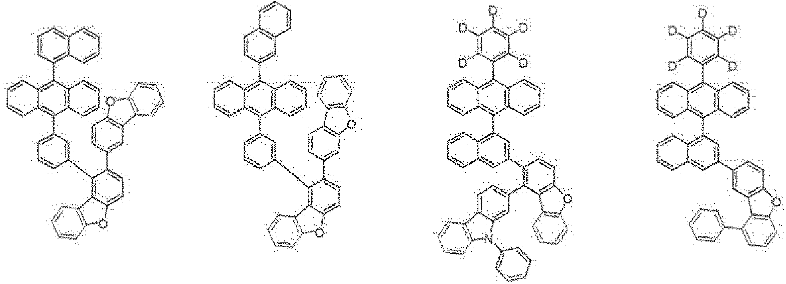

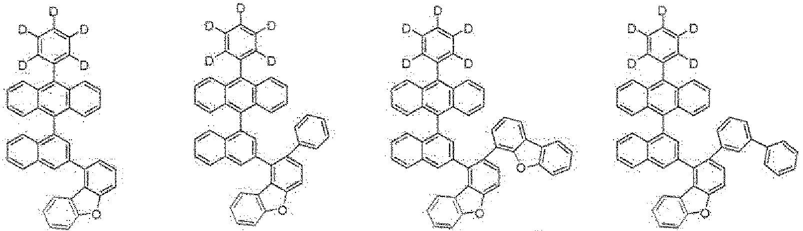

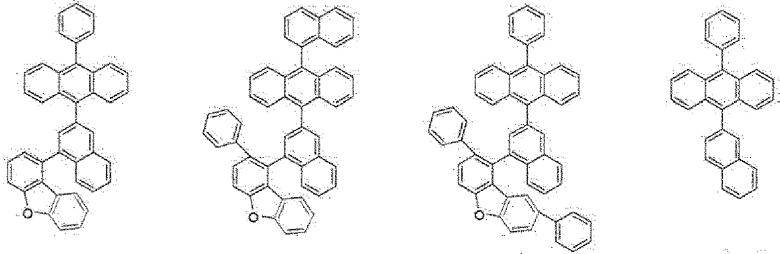

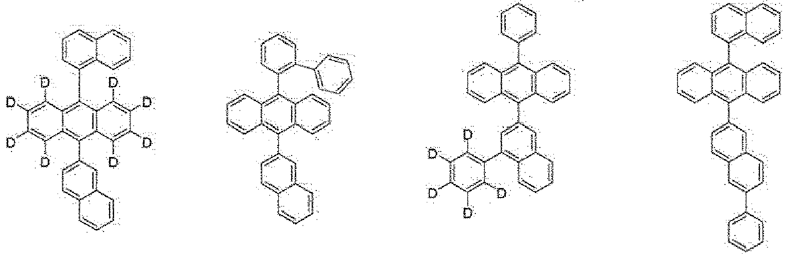

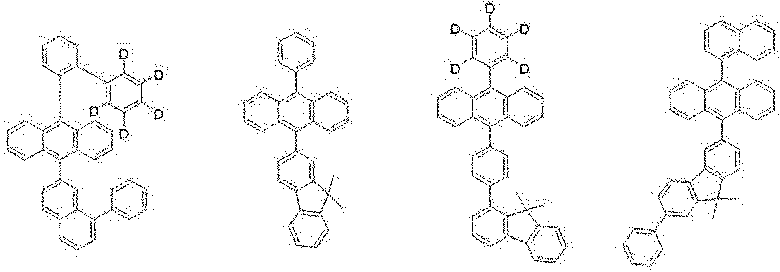

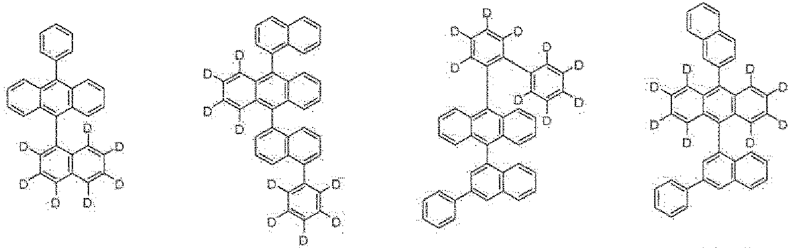

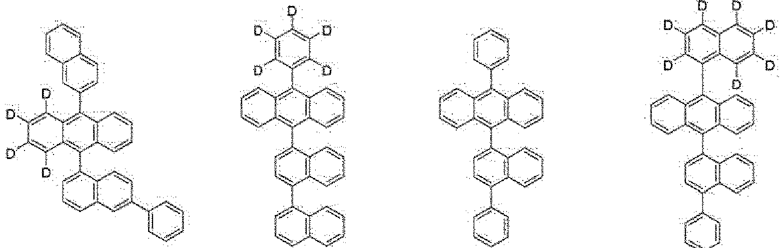

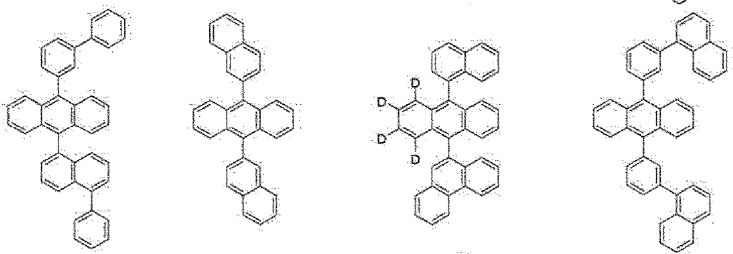

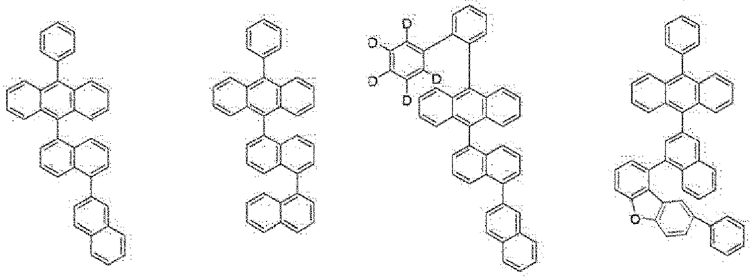

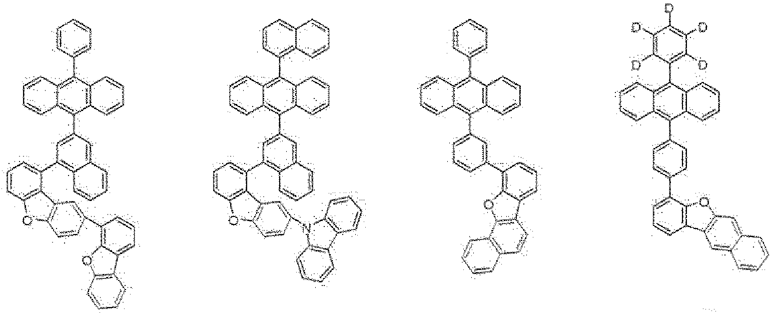

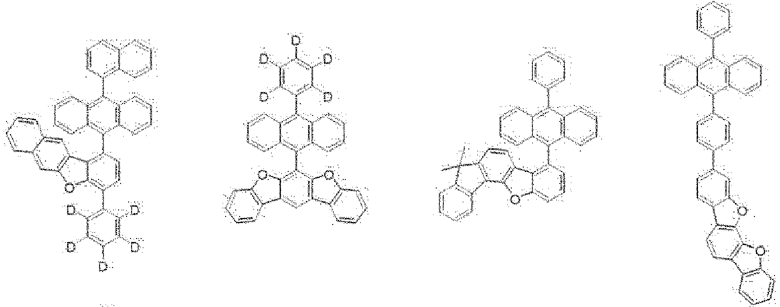

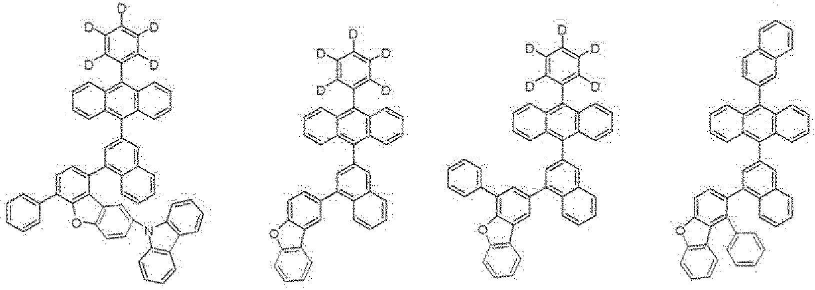

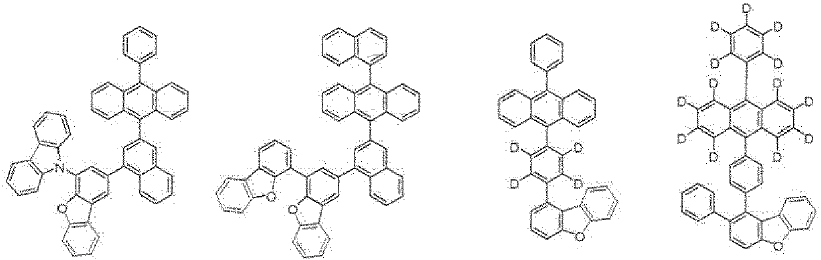

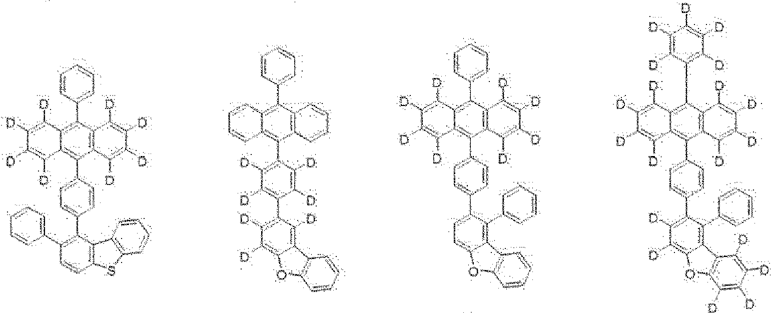

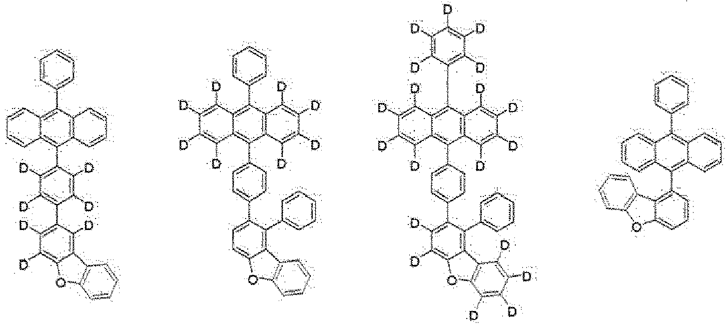

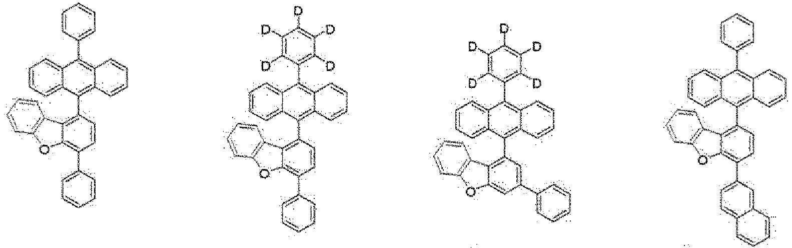

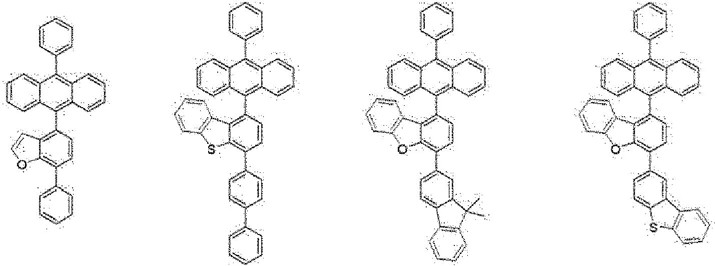

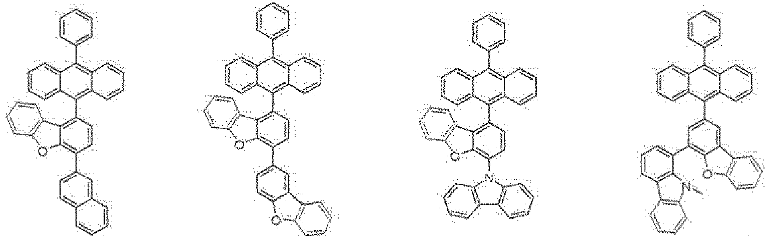

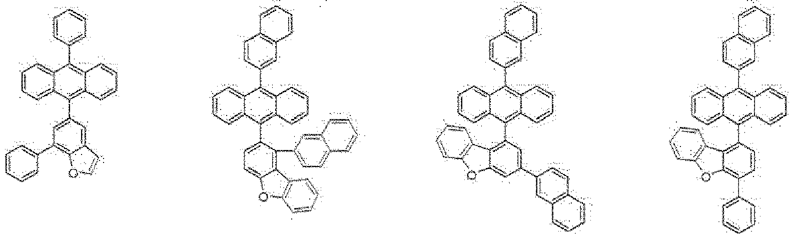

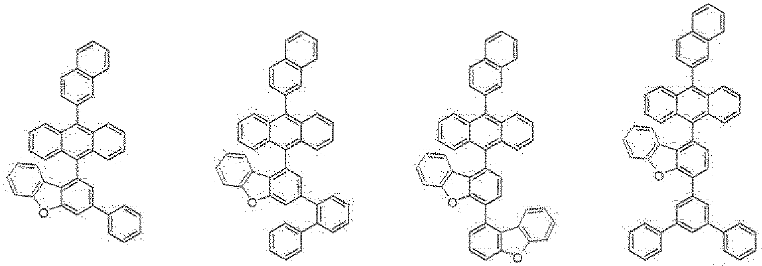

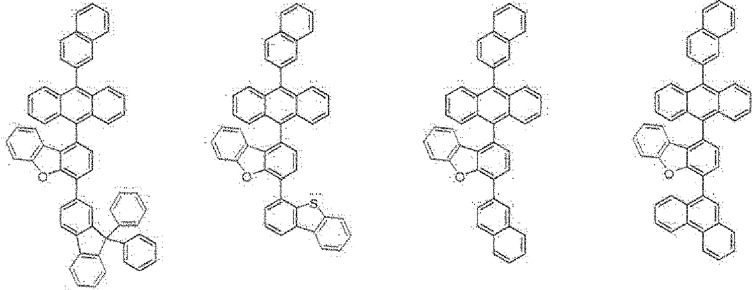

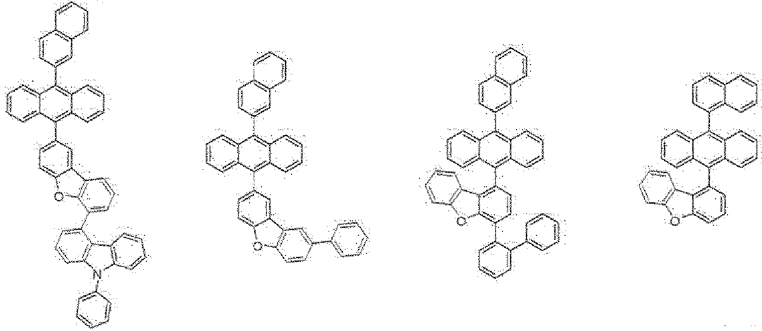

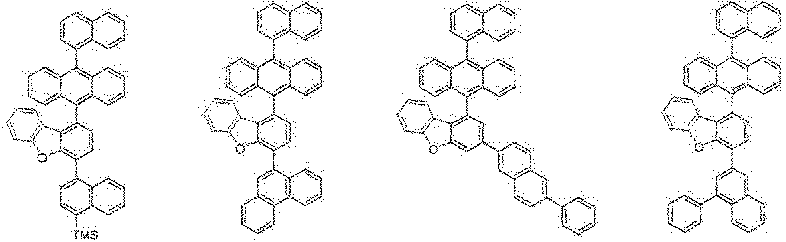

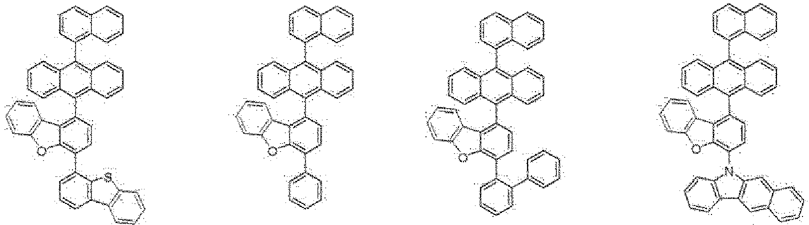

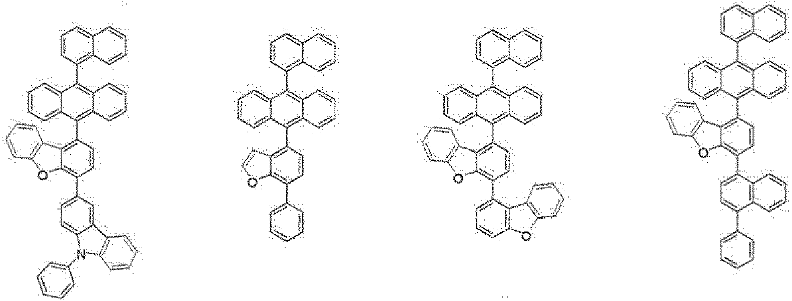

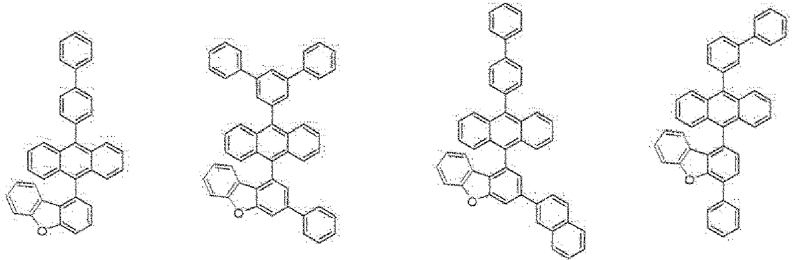

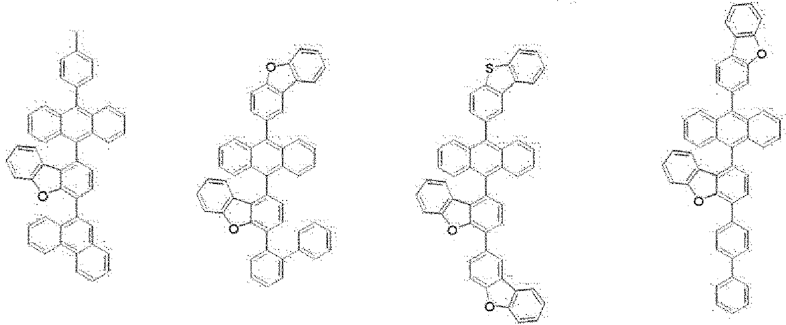

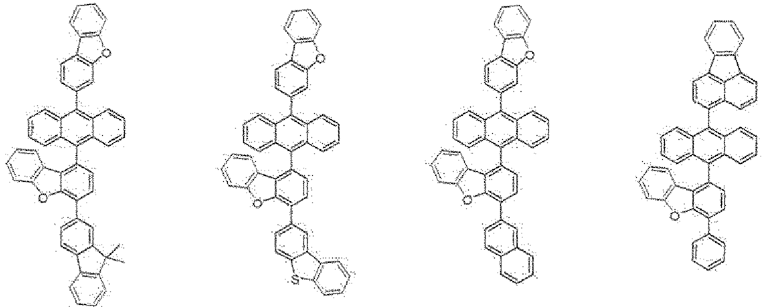

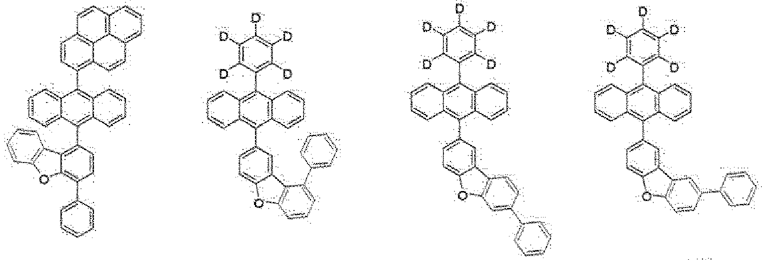

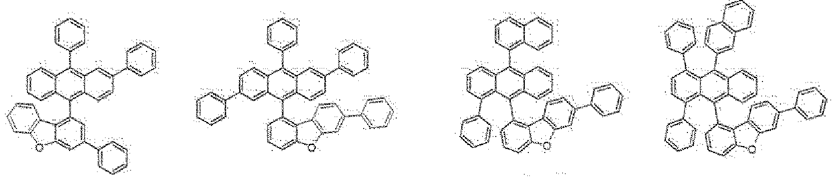

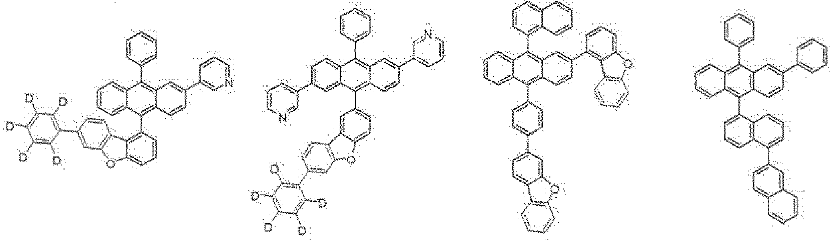

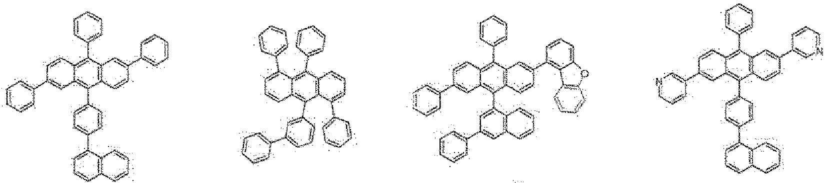

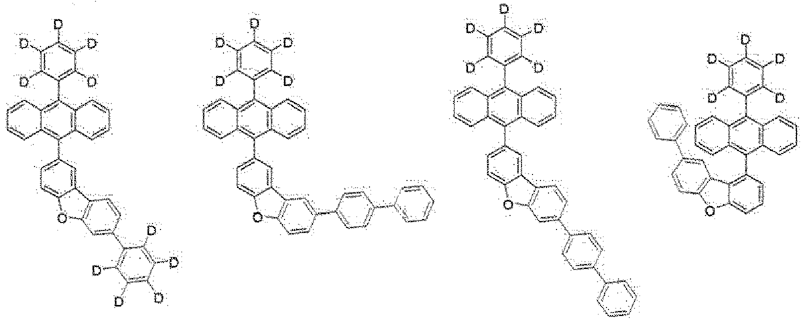

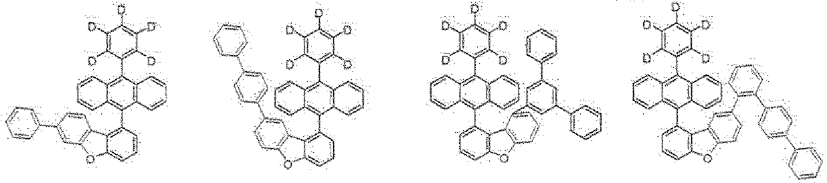

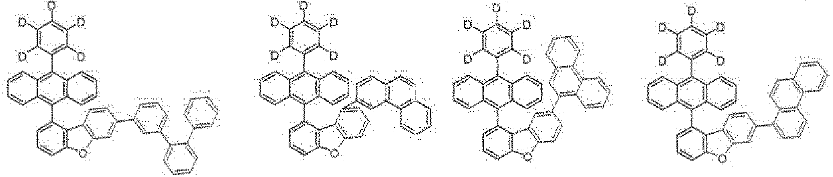

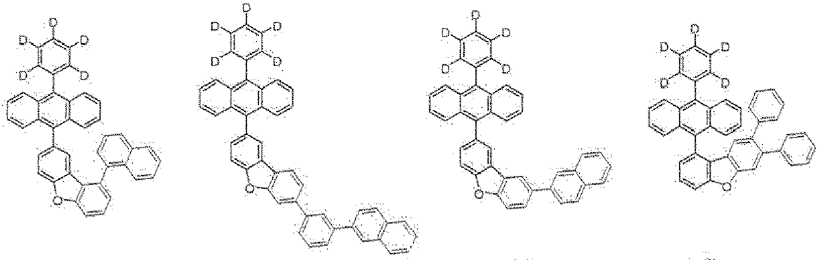

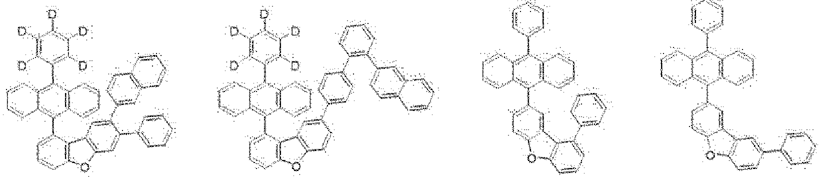

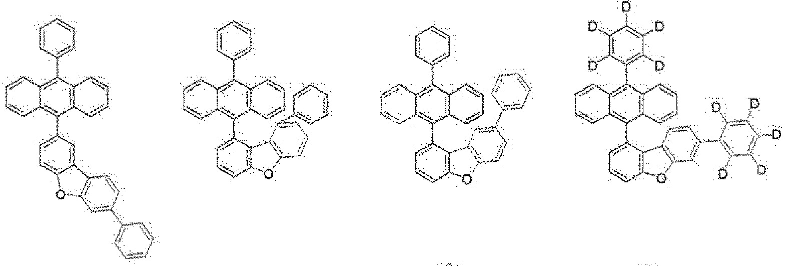

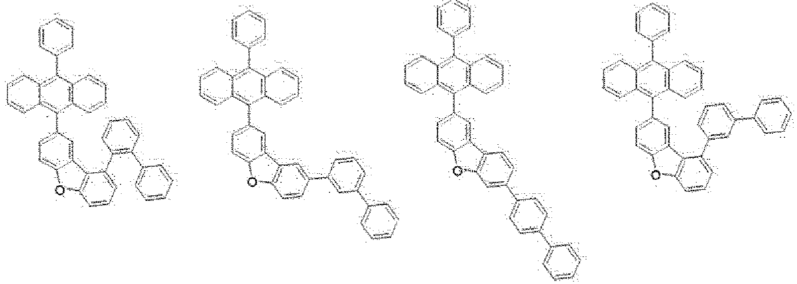

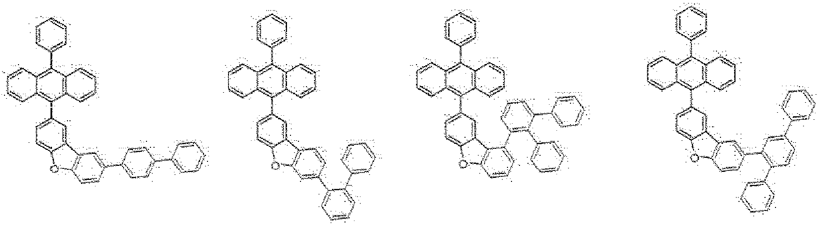

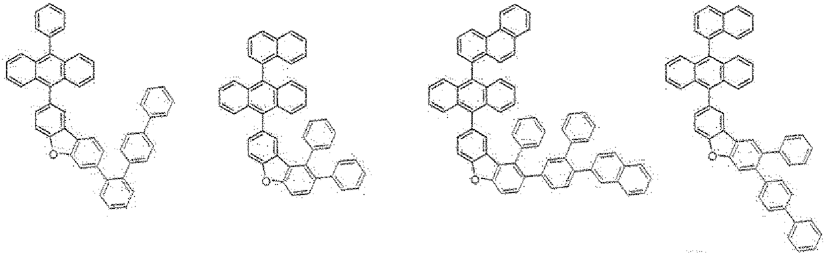

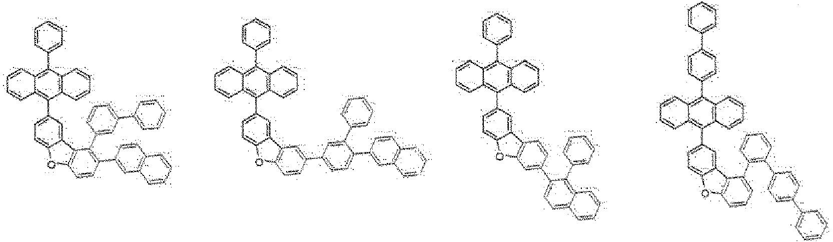

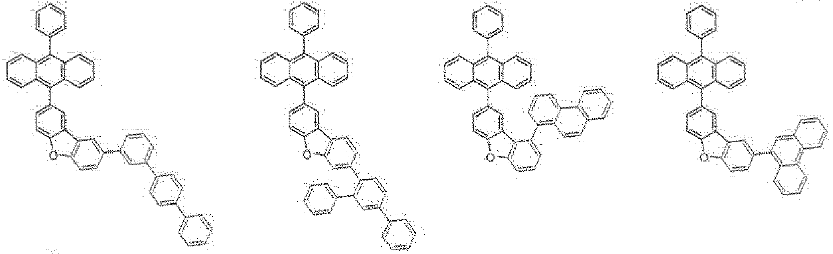

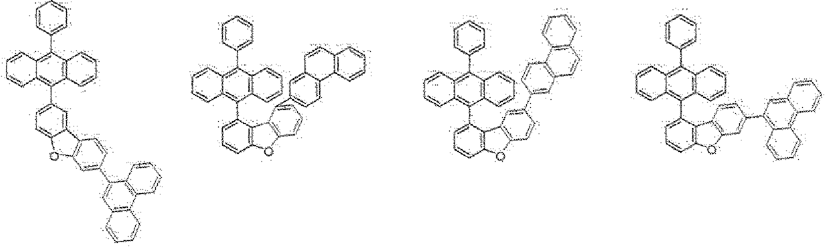

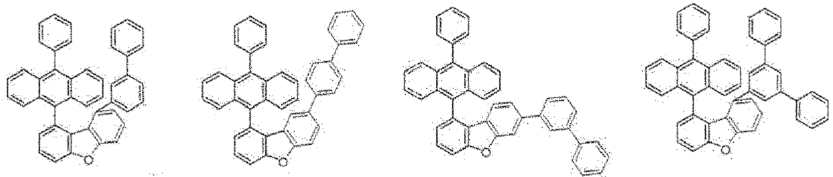

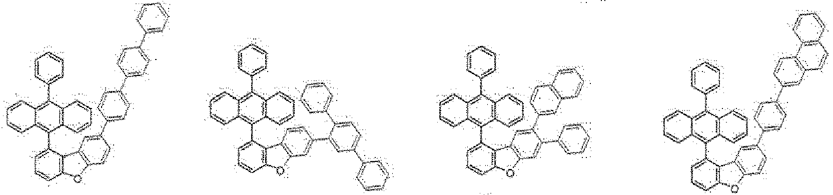

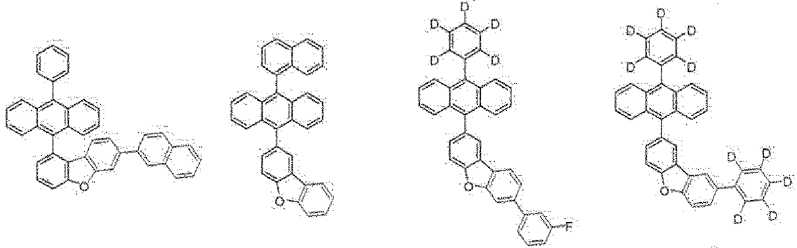

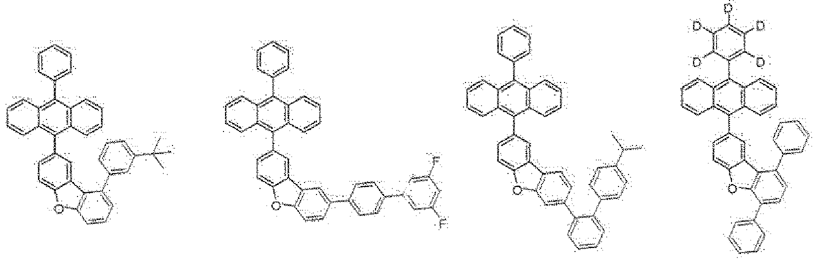

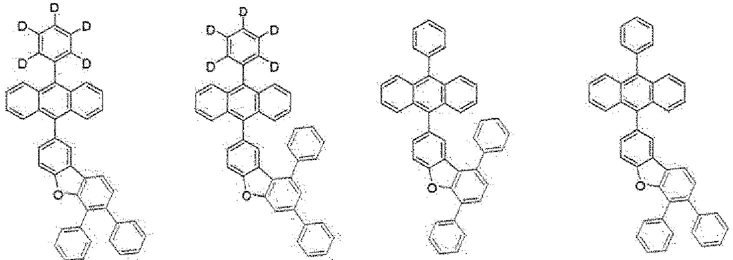

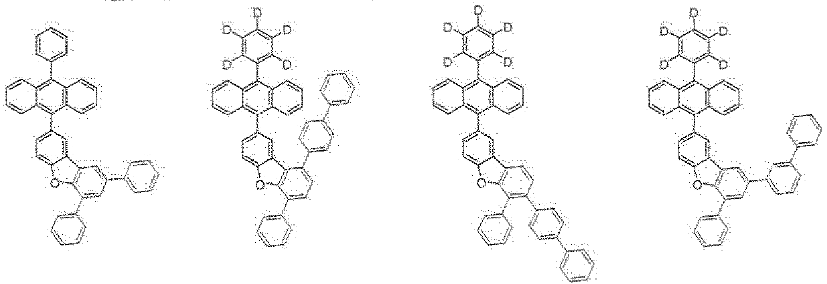

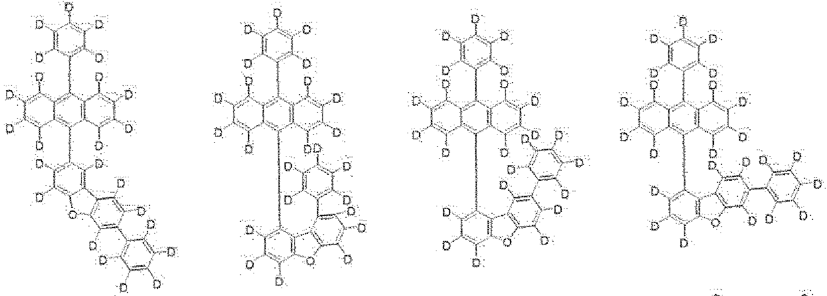

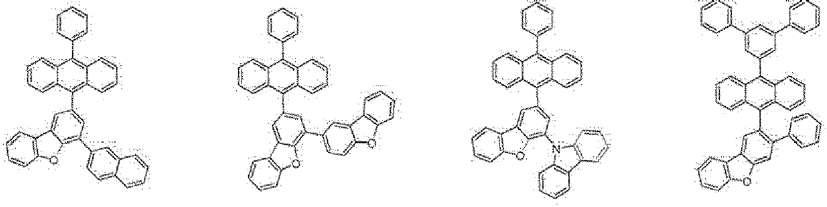

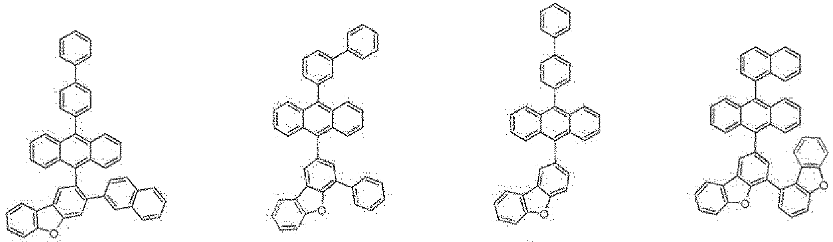

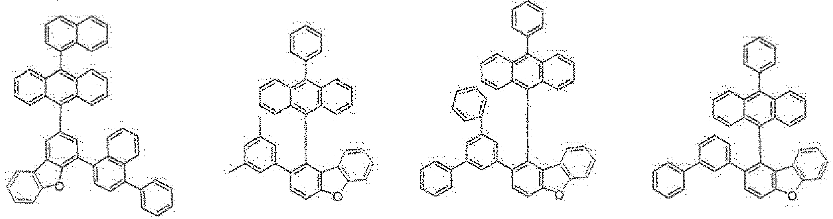

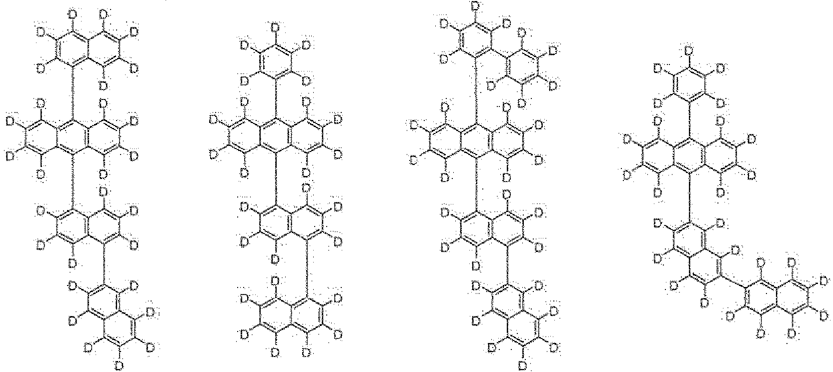

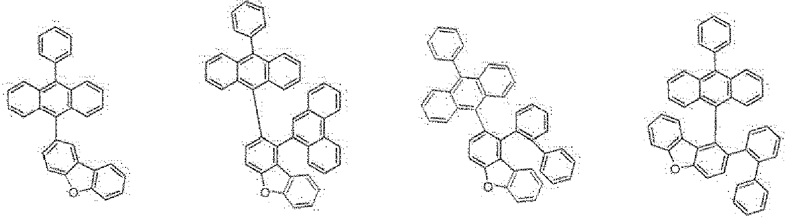

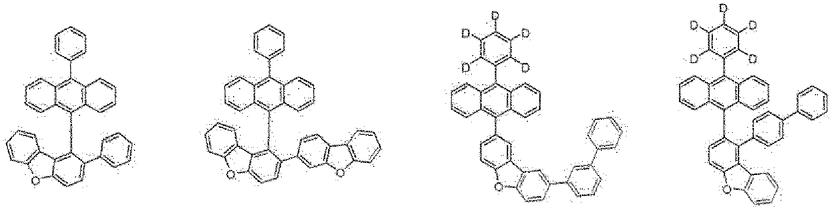

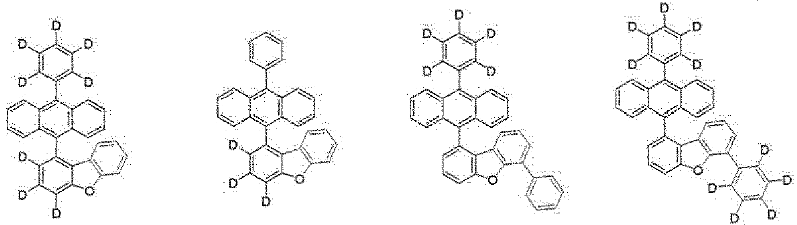

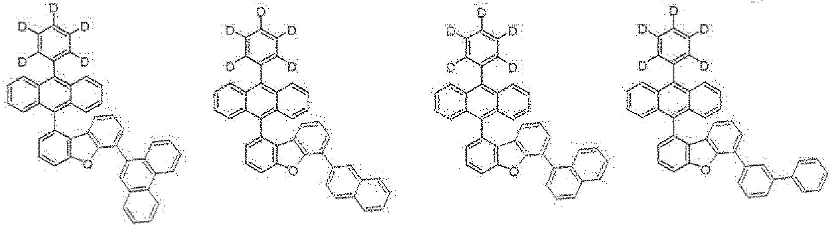

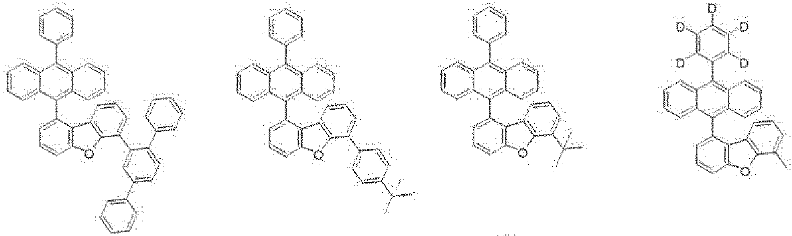

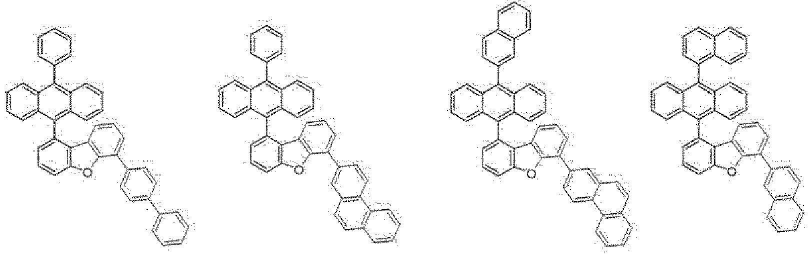

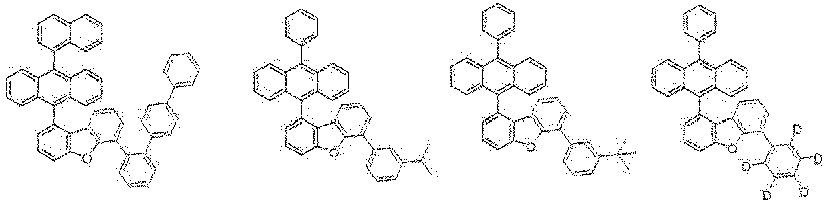

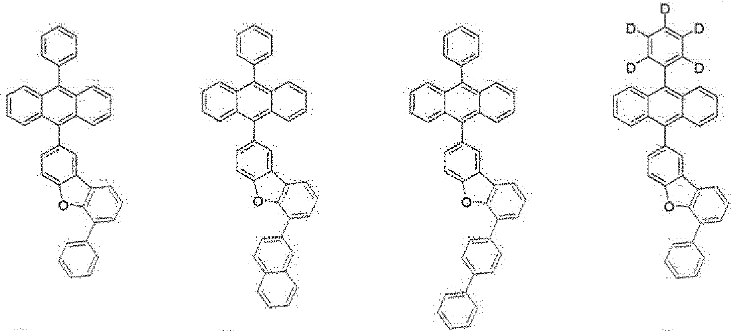

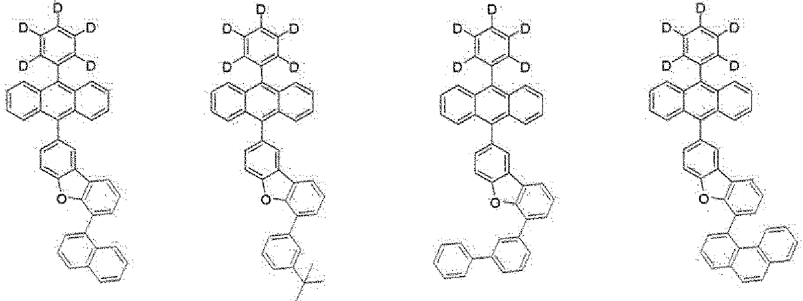

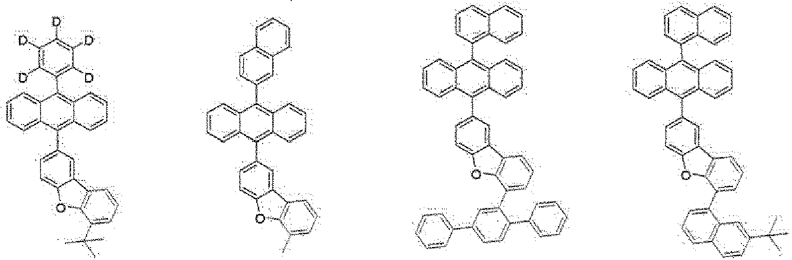

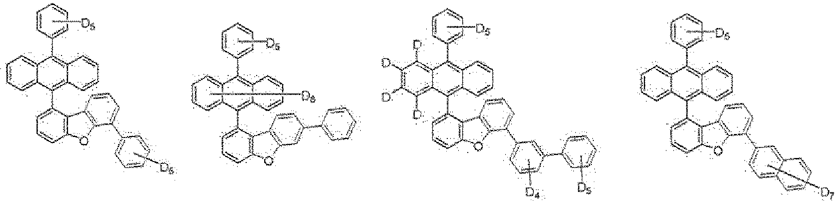

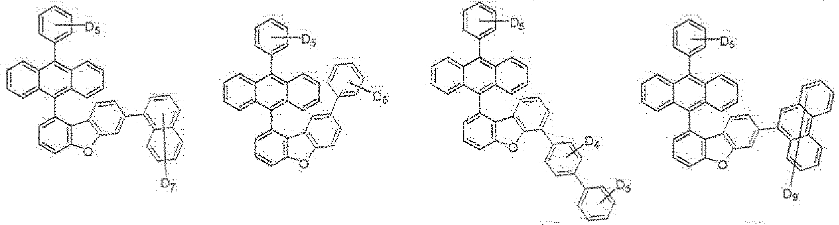

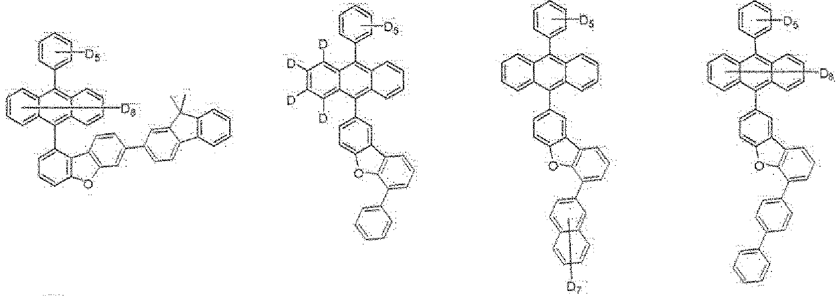

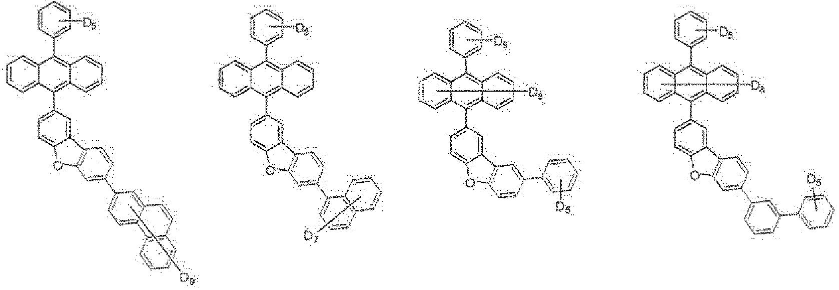

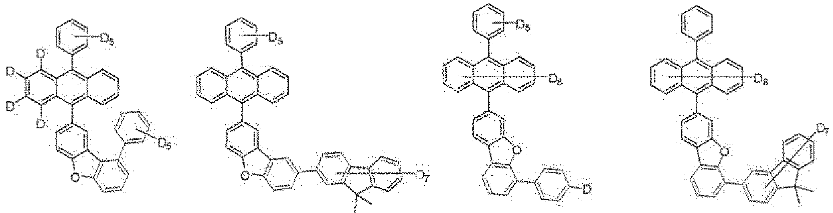

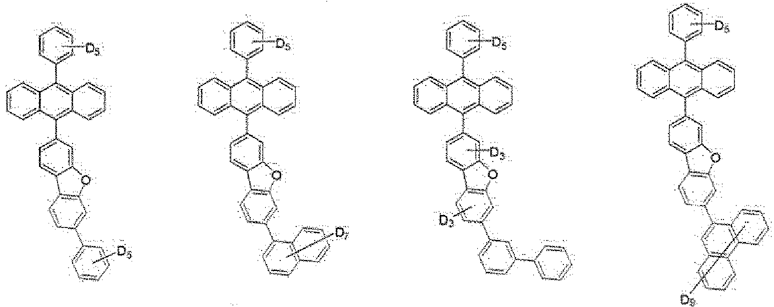

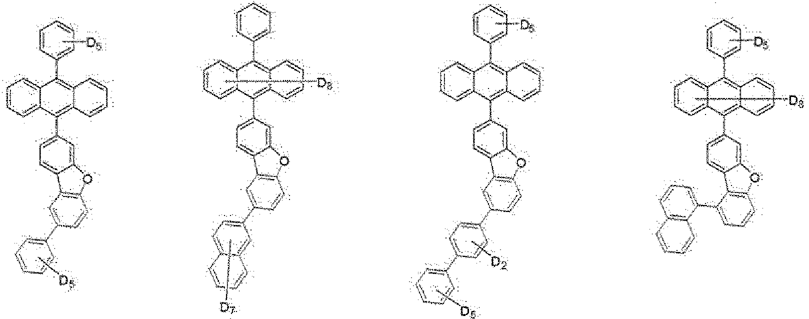

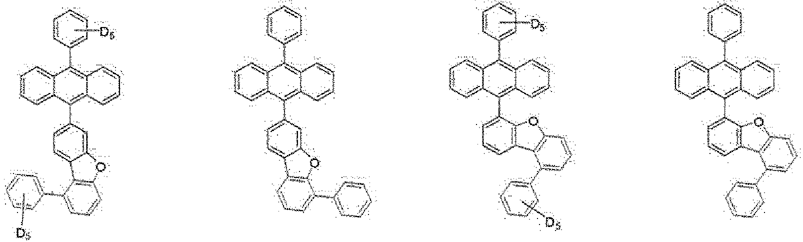

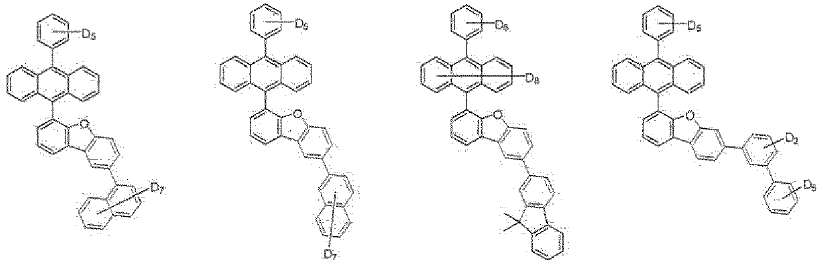

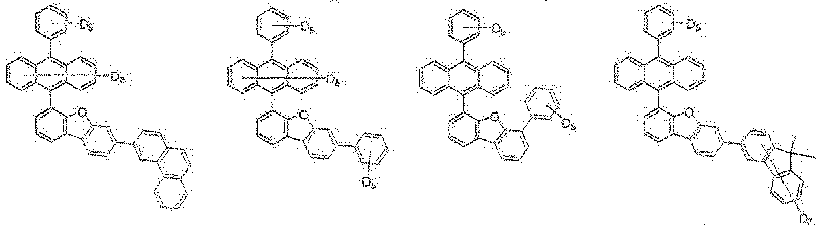

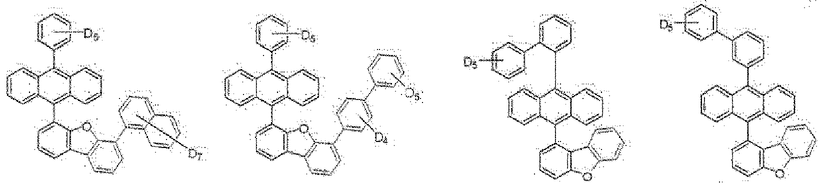

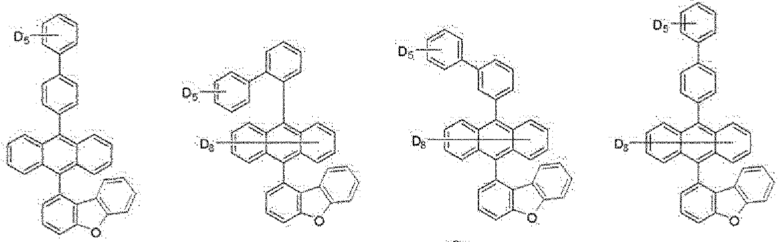

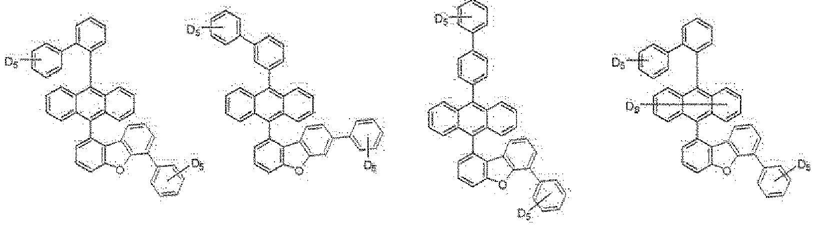

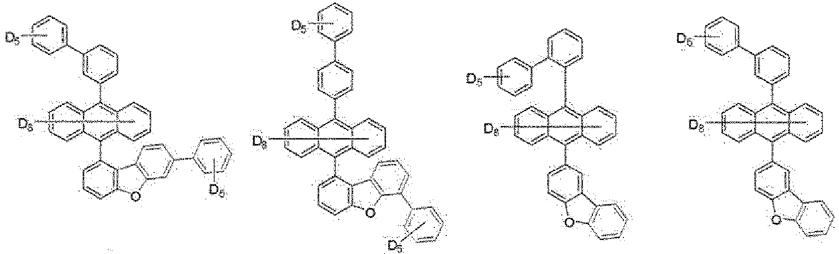

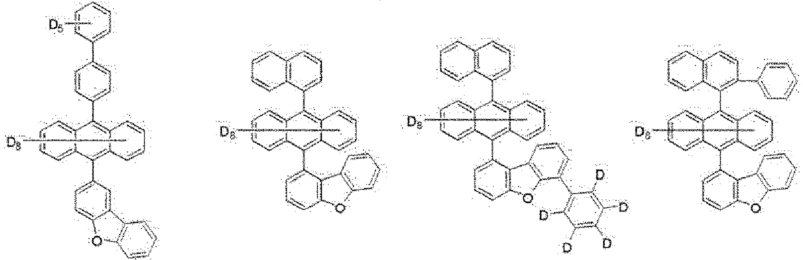

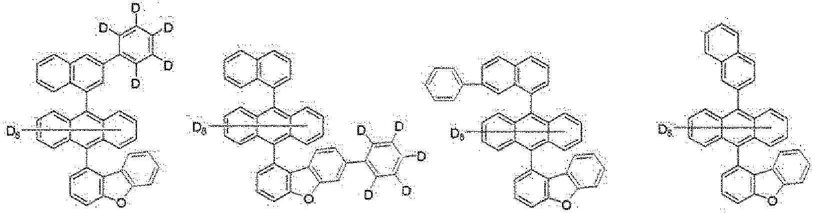

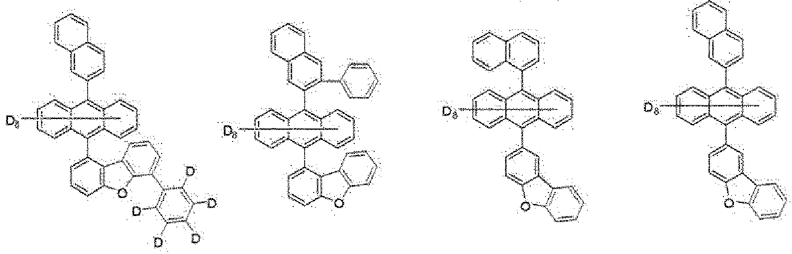

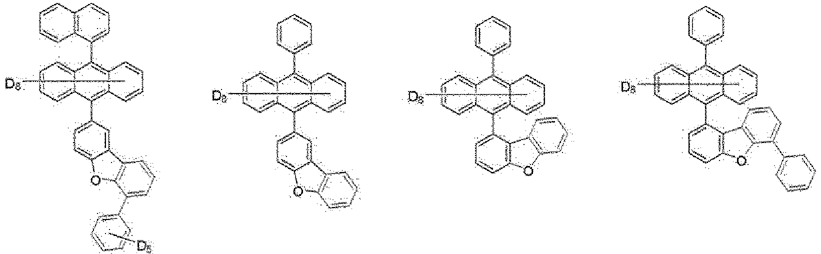

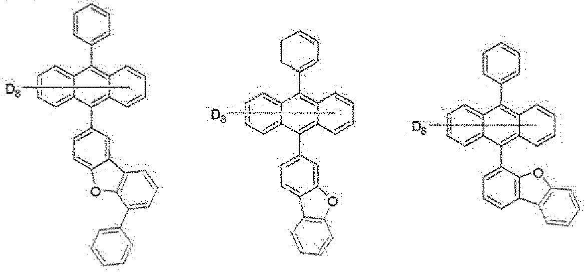

9. The organic light emitting device according to claim 6, wherein one or more host compounds other than the anthracene compound represented by Formula H are mixed or stacked in the light emitting layer.

10. The organic light emitting device according to claim 6, wherein one or more dopant compounds other than the polycyclic compound represented by Formula I are mixed or stacked in the light emitting layer.

11. The organic light emitting device according to claim 5, wherein one or more of the layers are formed by a deposition or solution process.

12. The organic light emitting device according to claim 4, wherein the organic light emitting device is used in a display or lighting system selected from flat panel displays, flexible displays, monochromatic flat panel lighting systems, white flat panel lighting systems, flexible monochromatic lighting systems, flexible white lighting systems, displays for automotive applications, displays for virtual reality, and displays for augmented reality.

## Patentansprüche

1. Eine polyzyklische Verbindung, dargestellt durch Formel I: 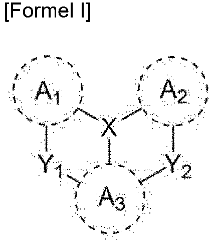
wobei X B, P=O, P=S oder Al ist, Y₁ und Y₂ jeweils unabhängig voneinander NR₁, O, S, CRR₂R₃ oder SiR₄R₅ sind, und A₁ bis A₃ jeweils unabhängig voneinander ausgewählt sind aus substituierten oder unsubstituierten aromatischen C₅-C₅₀-Kohlenwasserstoffringen, substituierten oder unsubstituierten aromatischen C₂-C₅₀-heterocyclischen Ringen, substituierten oder unsubstituierten aliphatischen C₃-C₃₀-Ringen, und substituierten oder unsubstituierten gemischten aliphatisch-aromatischen C₃-C₃₀-Ringen und die durch die Strukturformel A dargestellte Struktur aufweisEN: 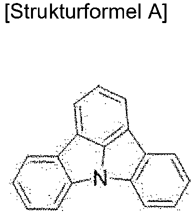
mit der Maßgabe, dass mindestens eines von A₁ bis A₃ die durch die Strukturformel A dargestellte Struktur ist, wobei die durch die Strukturformel A dargestellte Struktur optional mit einem oder mehreren Resten R substituiert ist, R und R₁ bis R₅ gleich oder voneinander verschieden sind und jeweils unabhängig voneinander ausgewählt sind aus Wasserstoff, Deuterium, substituiertem oder unsubstituiertem C₁-C₃₀-Alkyl, substituiertem oder unsubstituiertem C₂-C₃₀-Alkenyl, substituiertem oder unsubstituiertem C₆-C₅₀-Aryl, substituiertem oder unsubstituiertem C₃-C₃₀-Cycloalkyl, substituiertem oder unsubstituiertem C₃-C₃₀-Hetero-cycloalkyl, substituiertem oder unsubstituiertem C₂-C₅₀-Heteroaryl, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₅-C₃₀-Arylthioxy, substituiertem oder unsubstituiertem Amin, substituiertem oder unsubstituiertem Silyl, substituierten oder unsubstituierten gemischt aliphatischen-aromatischen cyclische C₃-C₃₀-Gruppen, Nitro, Cyano und Halogen, wobei die Substituenten jedes der Ringe A₁ bis A₃ optional miteinander verbunden sind, um einen alicyclischen oder aromatischen monocyclischen oder polycyclischen Ring zu bilden, jedes von R₁ bis R₅ optional mit einem benachbarten Substituenten mindestens eines der Ringe A₁ bis A₃ verbunden ist, um einen alicyclischen oder aromatischen monocyclischen oder polycyclischen Ring zu bilden, die Reste R optional miteinander verbunden sind, um einen alicyclischen oder aromatischen monocyclischen oder polycyclischen Ring zu bilden, R₂ und R₃ optional miteinander verbunden sind, um einen alicyclischen oder aromatischen monocyclischen oder polycyclischen Ring zu bilden, und R₄ und R₅ optional miteinander verbunden sind, um einen alicyclischen oder aromatischen monocyclischen oder polycyclischen Ring zu bilden,
wobei der Begriff "substituiert" in der Definition der Ringe A₁ bis A₃, R, R₁ bis R₅ usw. die Substitution mit einem oder mehreren Substituenten, ausgewählt aus Deuterium, Cyano, Halogen, Hydroxyl, Nitro, Alkyl, Cycloalkyl, Halogenalkyl, Alkenyl, Alkinyl, Heteroalkyl, Heterocycloalkyl, Aryl, Arylalkyl, Heteroaryl, Heteroarylalkyl, Alkoxy, Alkylamin, Arylamin, Heteroarylamin, Alkylsilyl, Arylsilyl und Aryloxy oder einer Kombination davon bezeichnet.

2. Die polyzyklische Verbindung gemäß Anspruch 1, wobei die polyzyklische Verbindung durch eine der Formeln I-1 und I-2 dargestellt ist: 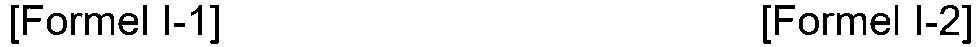 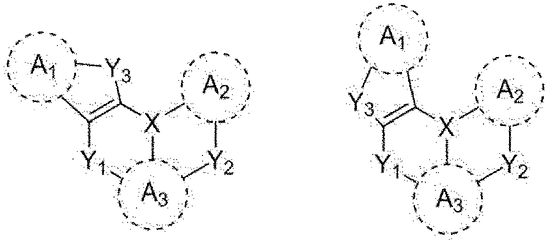 wobei Y₃ NR₁, O, S, CRR₂R₃ oder SiR₄R₅ ist, R₁ bis R₅ wie in Formel I definiert sind und X, Y₁, Y₂ und A₁ bis A₃ wie in Formel I definiert sind.

3. Die polyzyklische Verbindung gemäß Anspruch 1, wobei die polyzyklische Verbindung aus den folgenden Verbindungen ausgewählt ist:

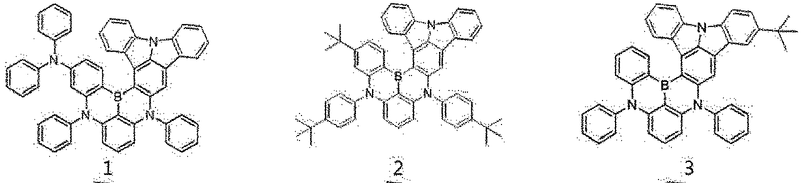

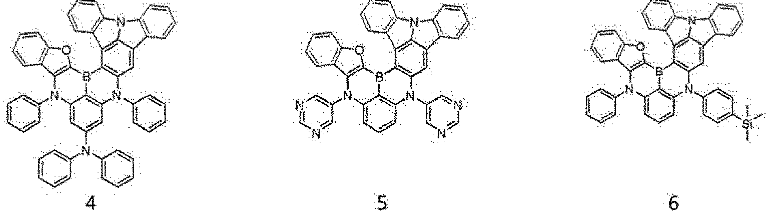

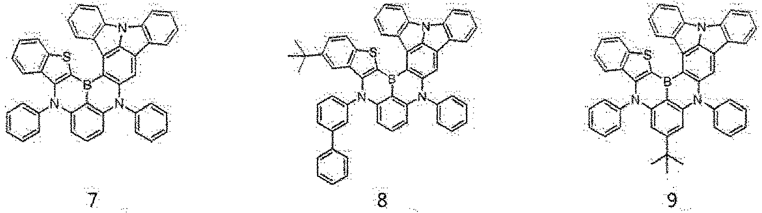

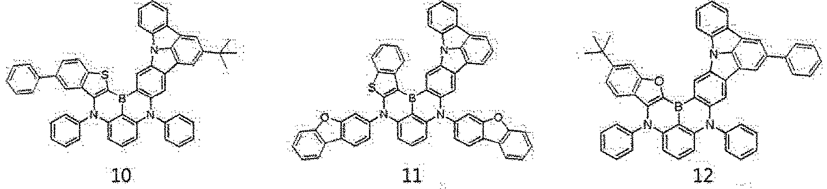

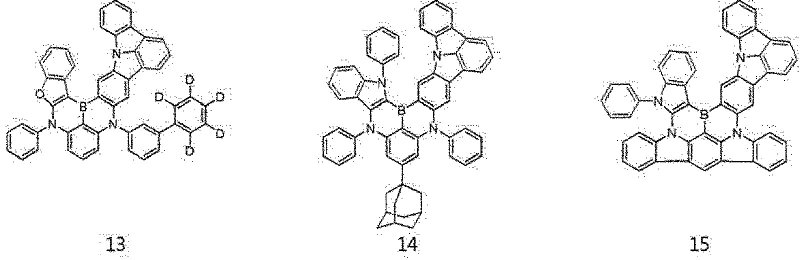

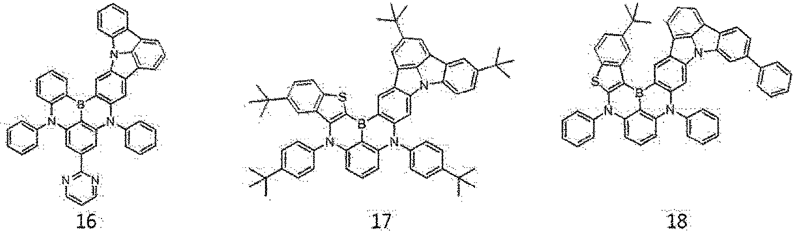

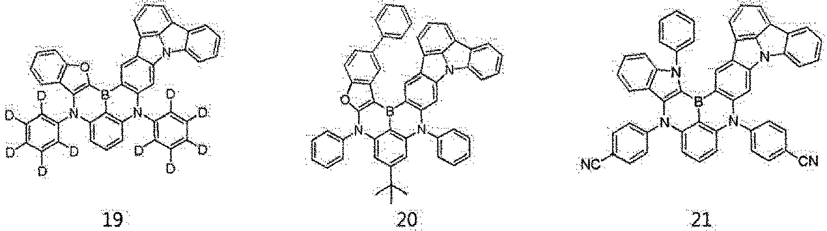

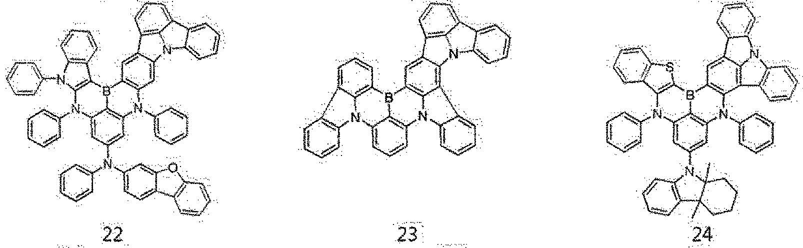

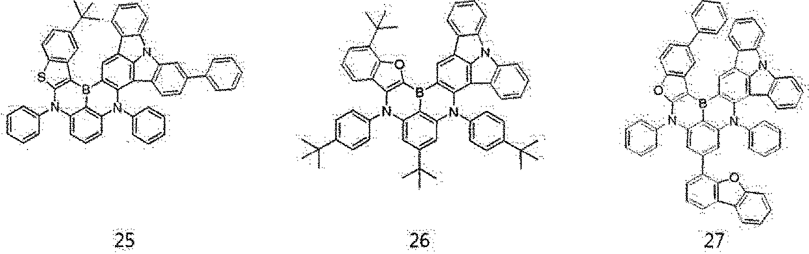

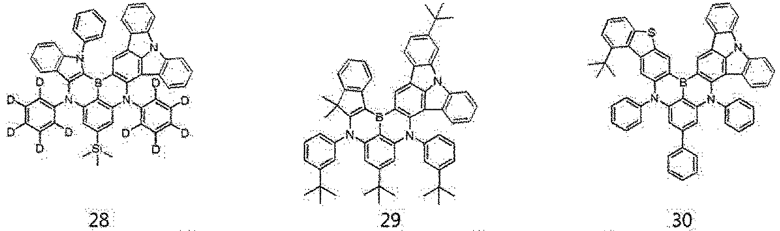

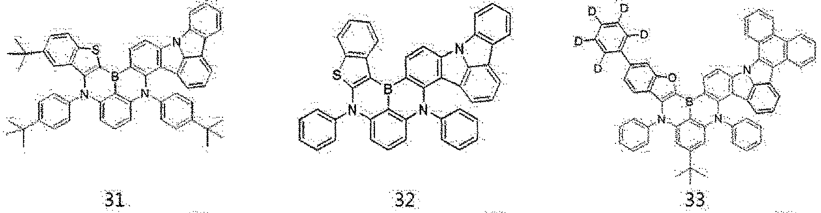

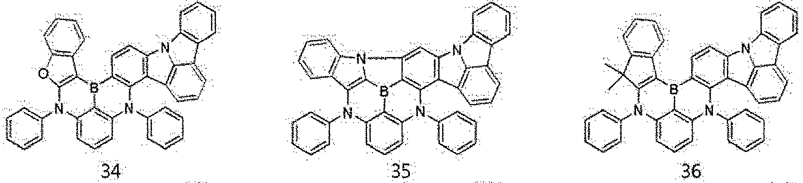

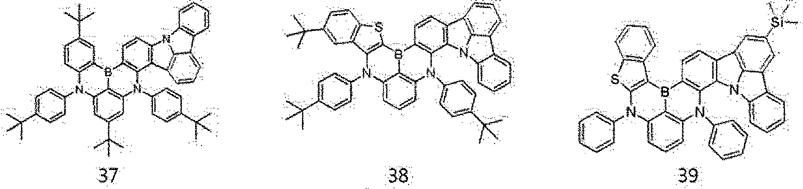

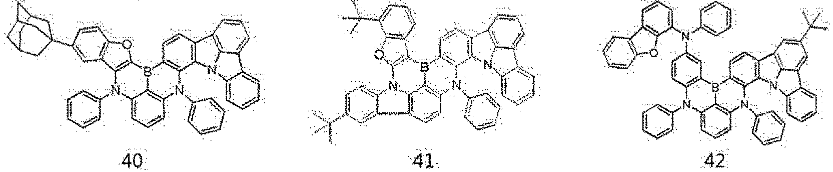

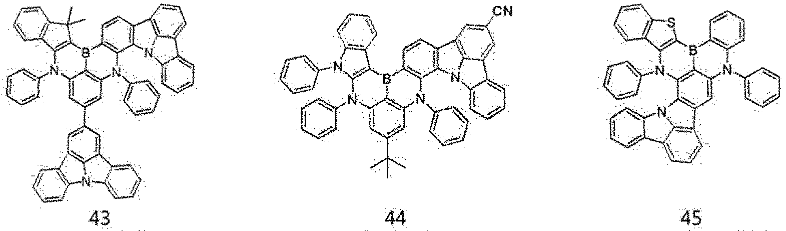

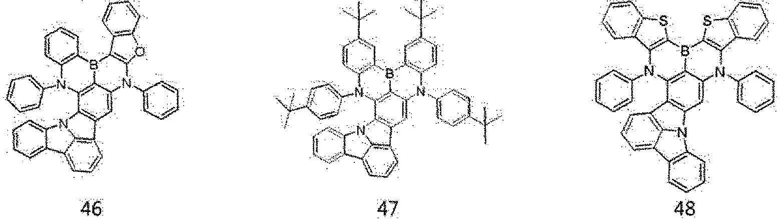

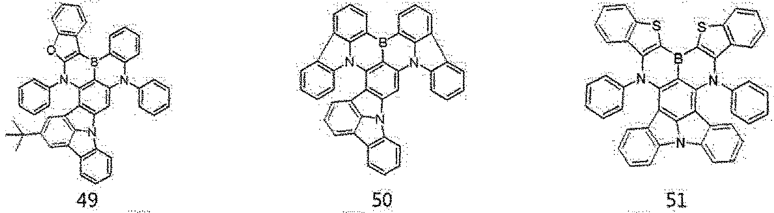

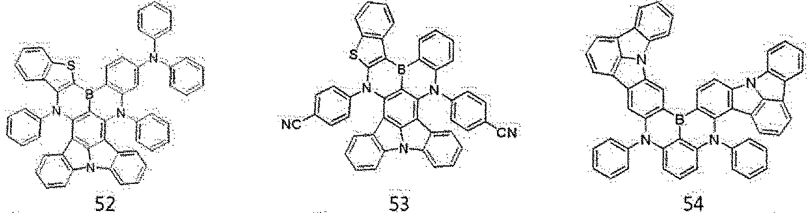

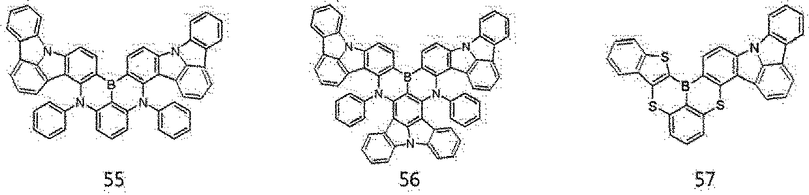

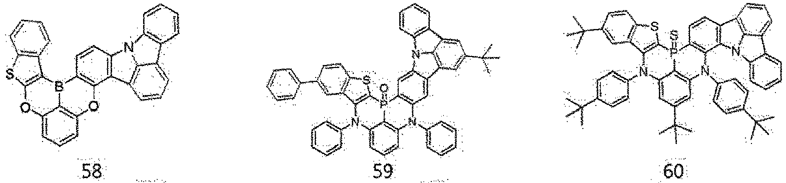

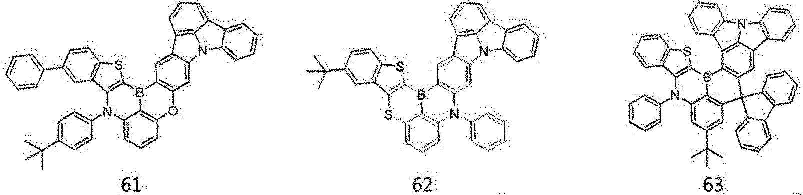

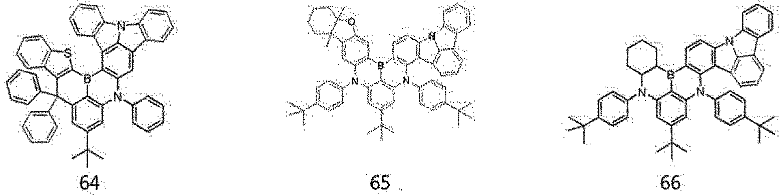

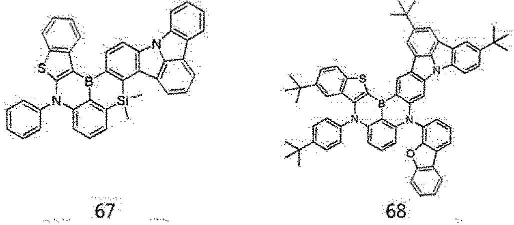

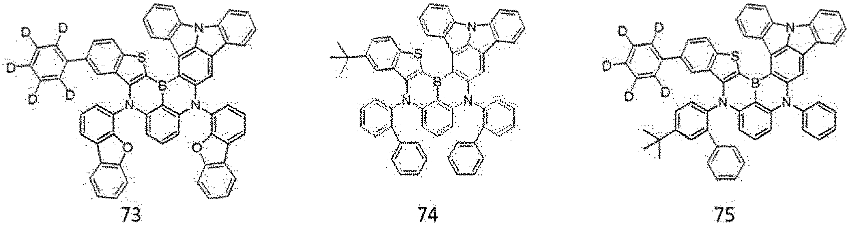

4. Eine organische lichtemittierende Vorrichtung, die eine erste Elektrode, eine zweite Elektrode, die der ersten Elektrode gegenüberliegt, und eine oder mehrere organische Schichten umfasst, die zwischen der ersten und der zweiten Elektrode angeordnet sind, wobei eine der organischen Schichten die durch Formel I gemäß Anspruch 1 dargestellten polyzyklischen Verbindungen umfasst.

5. Die organische lichtemittierende Vorrichtung gemäß Anspruch 4, wobei die organischen Schichten eine Elektroneninjektionsschicht, eine Elektronentransportschicht, eine Lochinjektionsschicht, eine Lochtransportschicht, eine Elektronenblockierschicht, eine Lochblockierschicht und/oder eine lichtemittierende Schicht umfassen, von denen mindestens eine die durch Formel I dargestellte organische lichtemittierende Verbindung umfasst.

6. Die organische lichtemittierende Vorrichtung gemäß Anspruch 5, wobei die lichtemittierende Schicht aus einem Wirtsmaterial und der durch Formel I dargestellten Verbindung als Dotierstoff zusammengesetzt ist.

7. Die organische lichtemittierende Vorrichtung gemäß Anspruch 6, wobei der Wirtsstoff eine Anthracenverbindung ist, die durch die Formel H dargestellt wird: 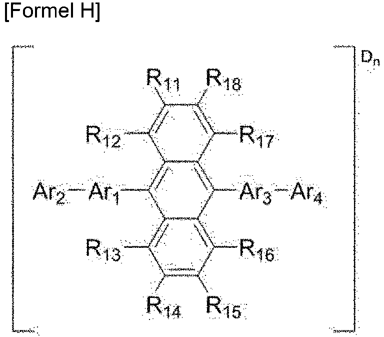 wobei R₁₁ bis R₁₈ gleich oder voneinander verschieden sind und jeweils unabhängig voneinander ausgewählt sind aus Wasserstoff, substituiertem oder unsubstituiertem C₁-C₃₀-Alkyl, substituiertem oder unsubstituiertem C₂-C₃₀-Alkenyl, substituiertem oder unsubstituiertem Cₐ-C₅₀-Aryl, substituiertem oder unsubstituiertem C₃-C₃₀-Cycloalkyl, substituiertem oder unsubstituiertem C₃-C₃₀-Hetero-cycloalkyl, substituiertem oder unsubstituiertem C₂-C₅₀-Heteroaryl, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₅-C₃₀-Arylthioxy, substituiertem oder unsubstituiertem Amin, substituiertem oder unsubstituiertem Silyl, substituierten oder unsubstituierten gemischt aliphatisch-aromatischen cyclischen C₃-C₂₀-Gruppen, Nitro, Cyano und Halogen, Ar₁ und Ar₃ gleich oder voneinander verschieden sind und jeweils unabhängig voneinander substituiertes oder unsubstituiertes C₆-C₃₀-Arylen oder substituiertes oder unsubstituiertes C₅-C₃₀-Heteroarylen sind, Ar₂ und Ar₄ gleich oder voneinander verschieden sind und jeweils unabhängig voneinander ausgewählt sind aus Wasserstoff, substituiertem oder unsubstituiertem C₆-C₅₀-Aryl, substituiertem oder unsubstituiertem C₃-C₃₀-Cycloalkyl, substituiertem oder unsubstituiertem C₃-C₃₀-Heterocycloalkyl, substituiertem oder unsubstituiertem C₂-C₅₀-Heteroaryl und substituierten oder unsubstituierten gemischt aliphatisch-aromatischen cyclischen C₃-C₂₀-Gruppen, Dₙ die Anzahl der Deuteriumatome darstellt, die Wasserstoffatome ersetzen, und n eine ganze Zahl von 0 bis 50 ist.

8. Die organische lichtemittierende Vorrichtung gemäß Anspruch 7, wobei die durch Formel H dargestellte Verbindung aus der Gruppe ausgewählt ist, die aus den folgenden Verbindungen besteht:

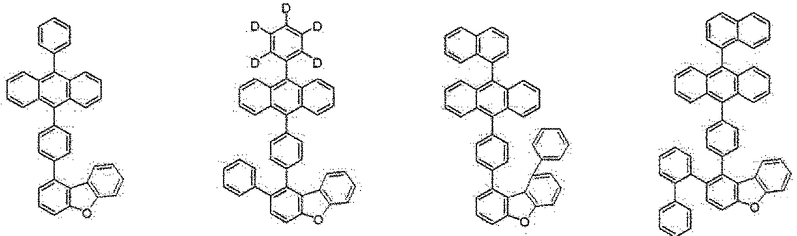

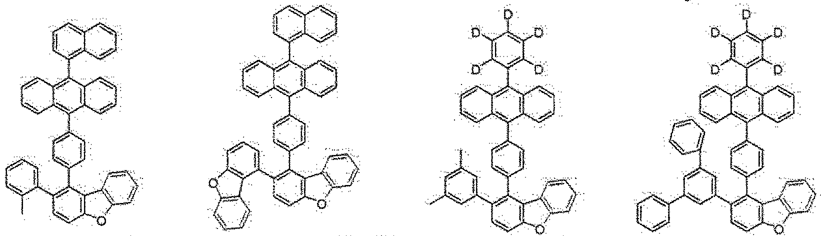

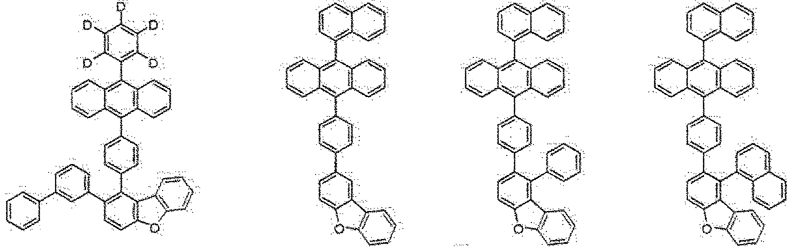

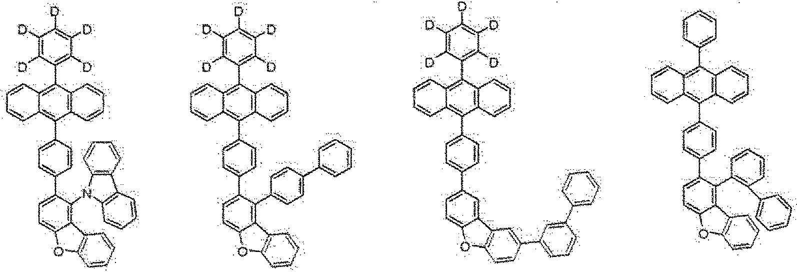

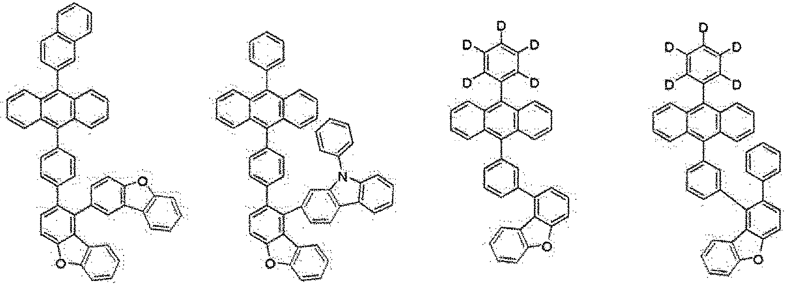

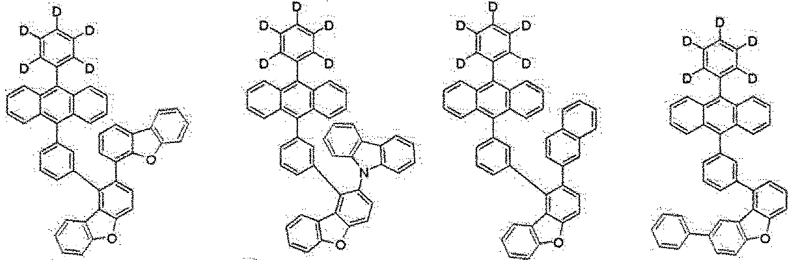

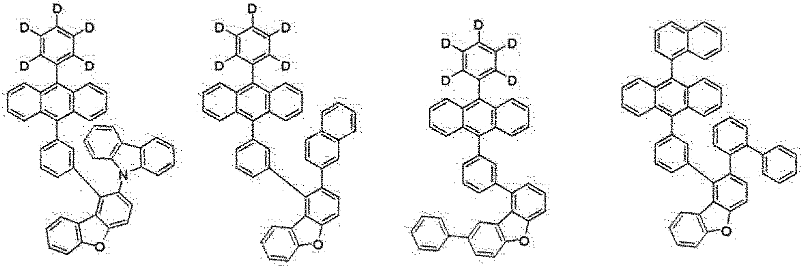

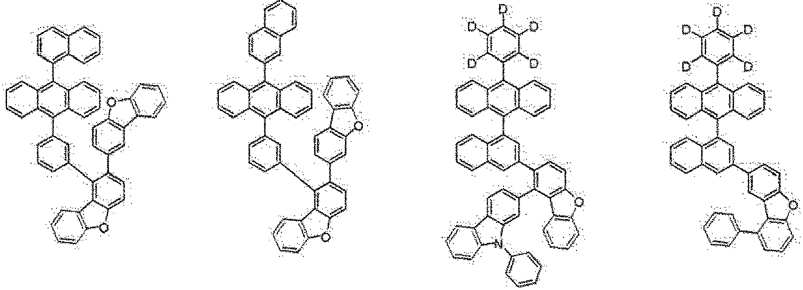

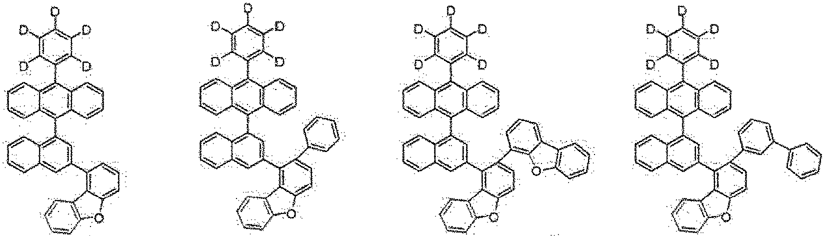

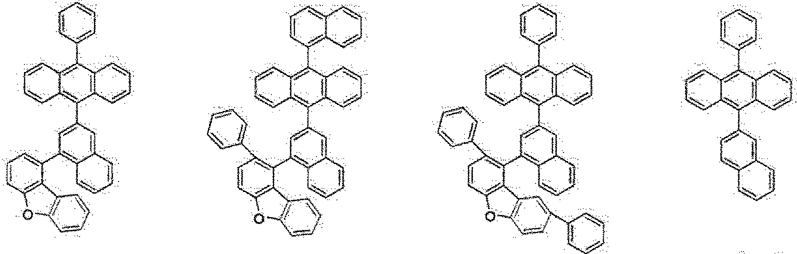

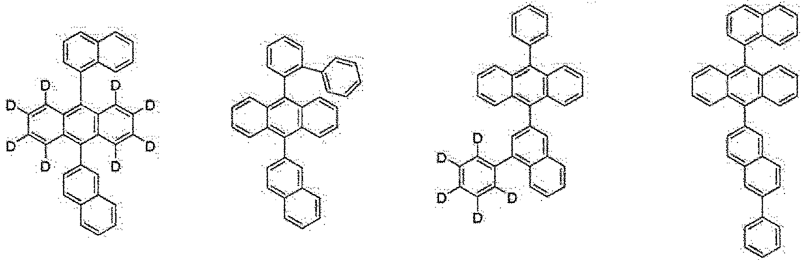

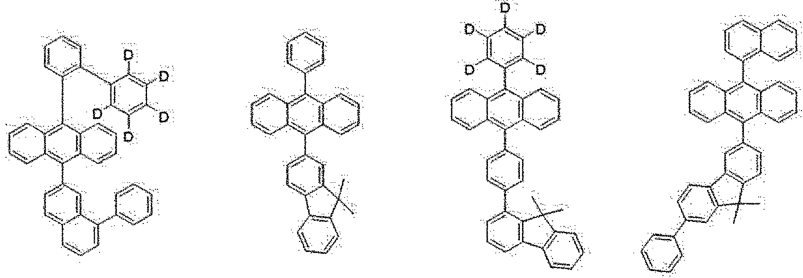

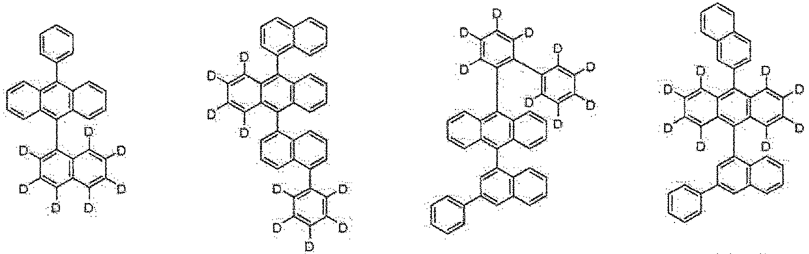

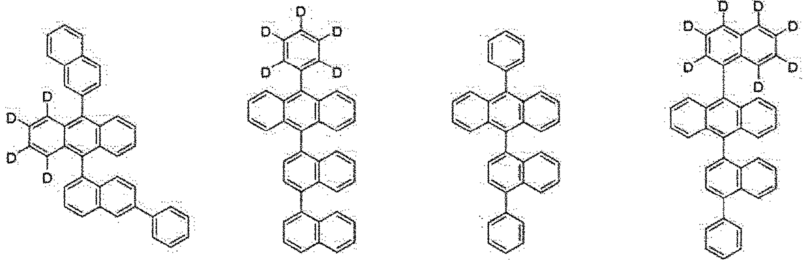

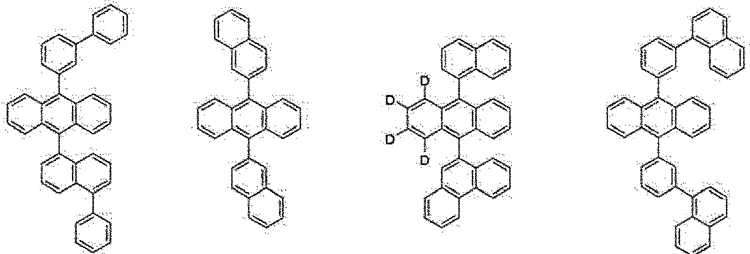

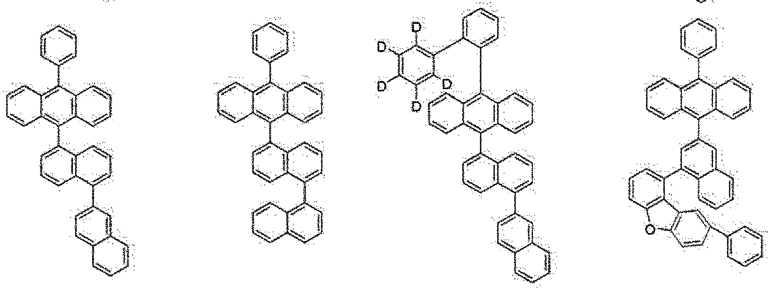

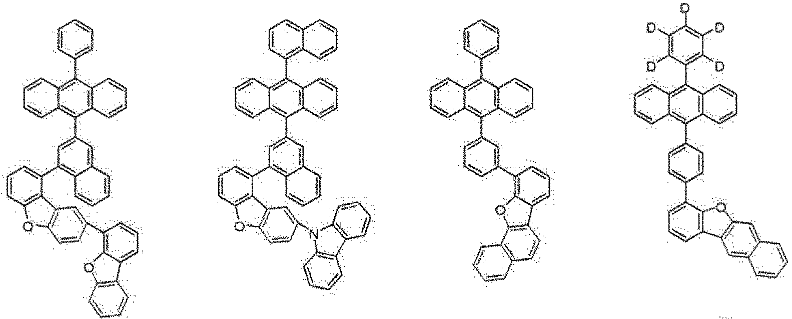

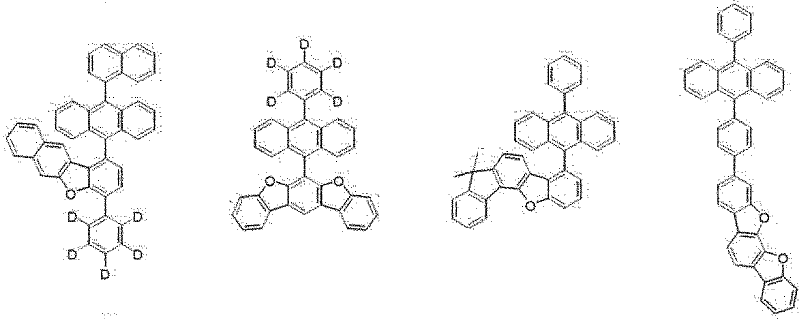

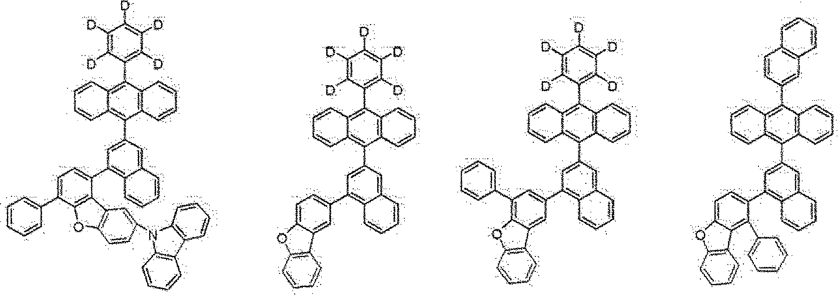

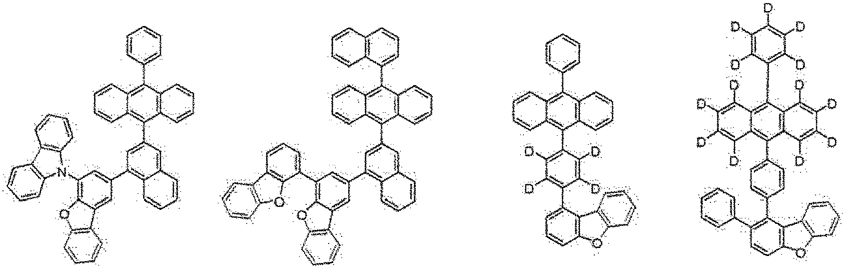

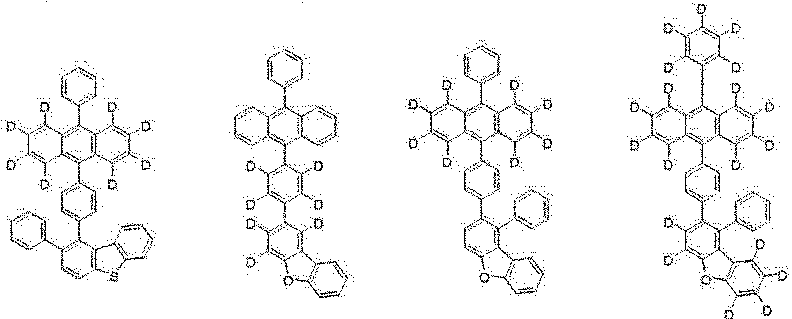

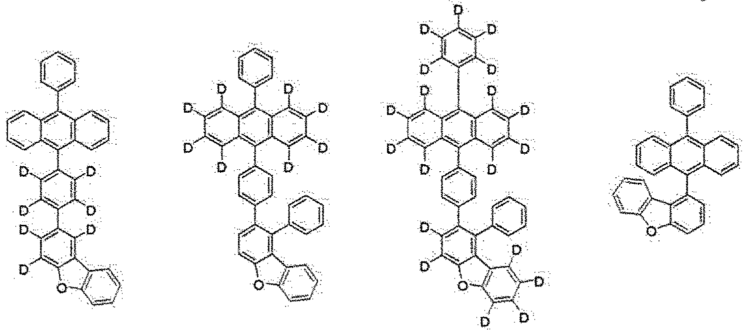

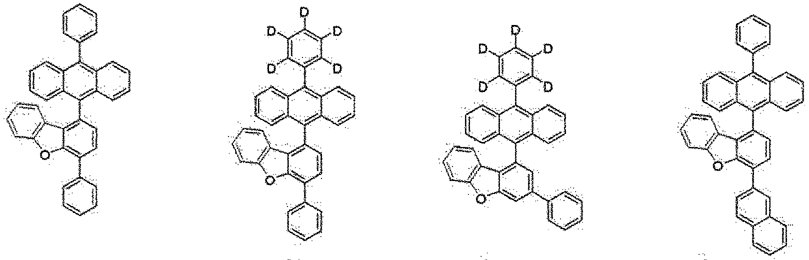

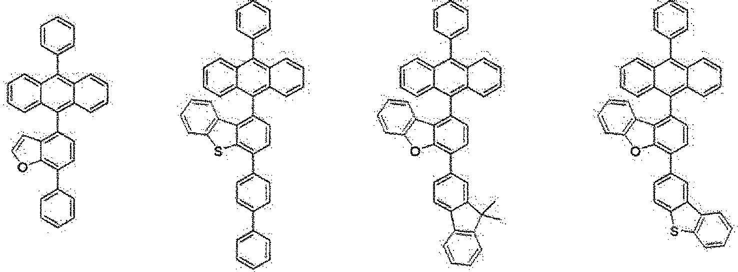

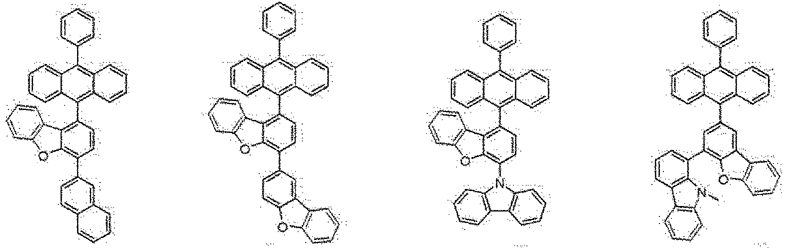

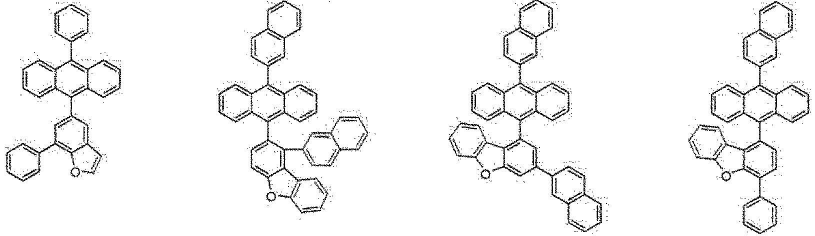

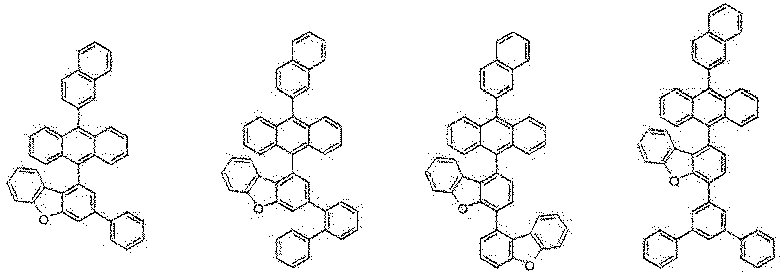

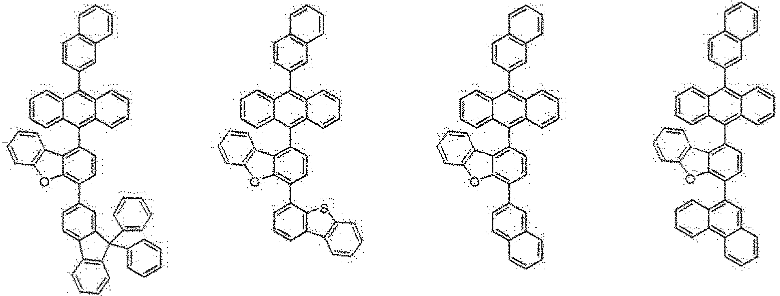

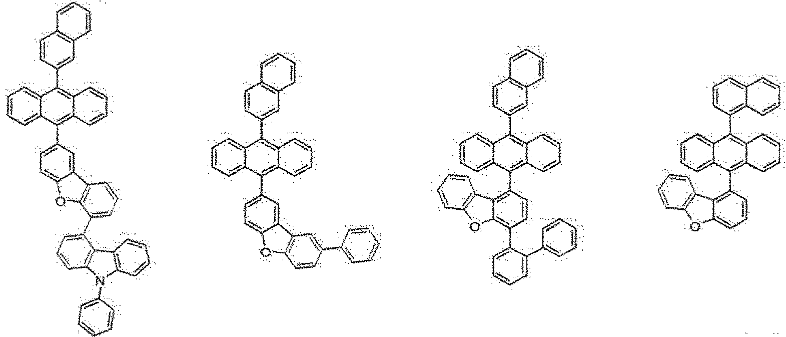

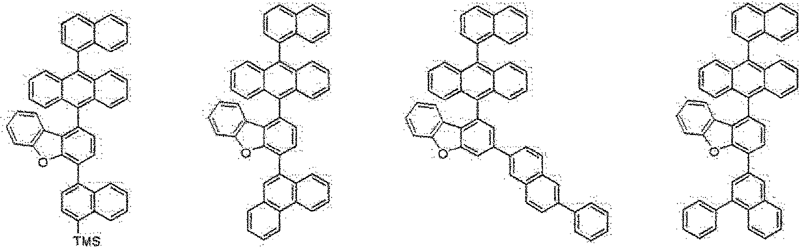

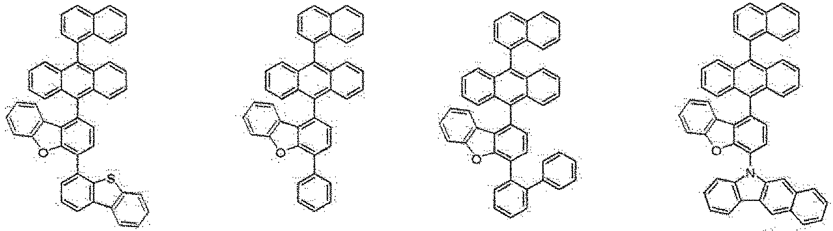

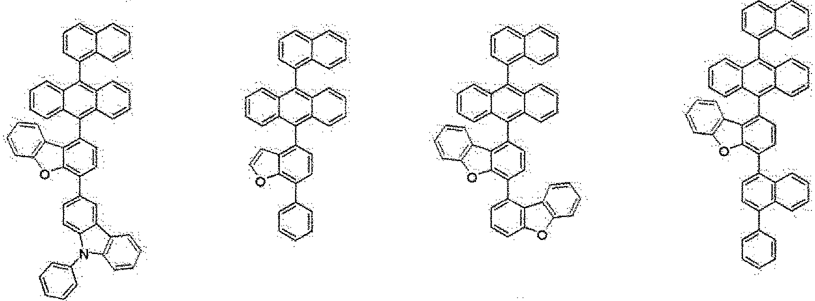

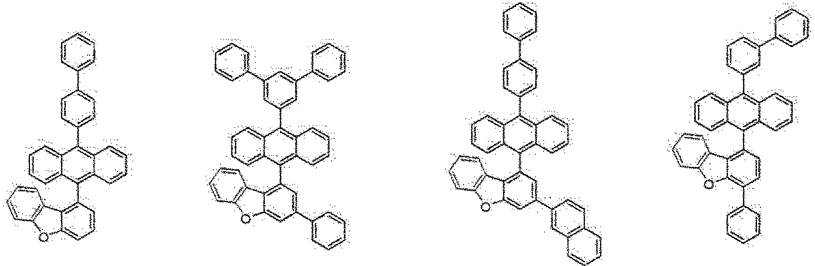

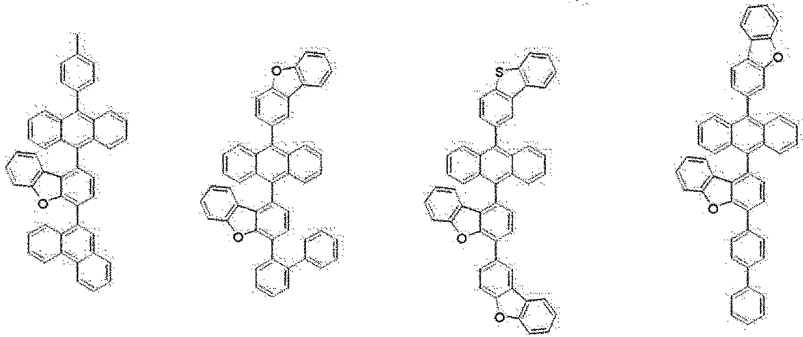

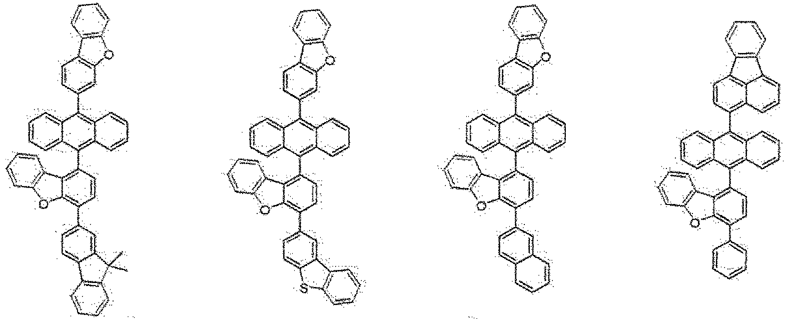

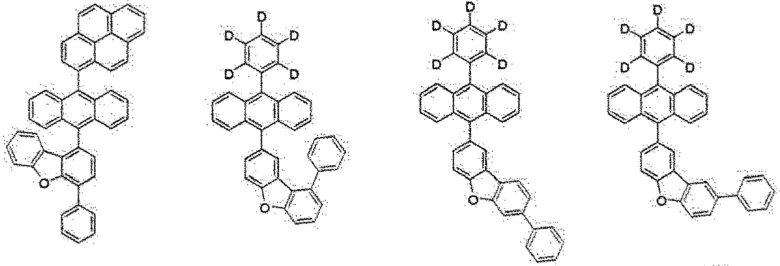

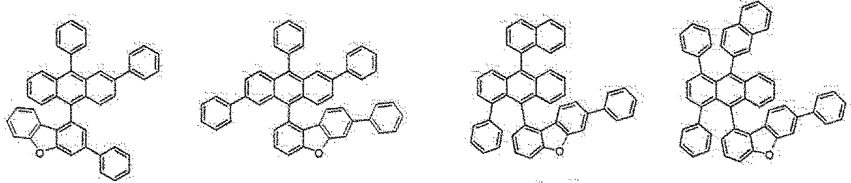

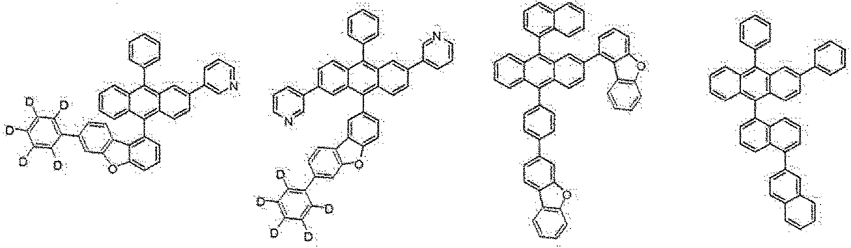

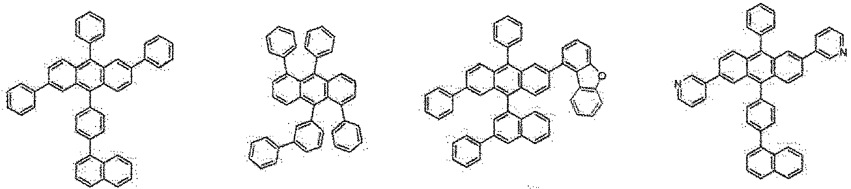

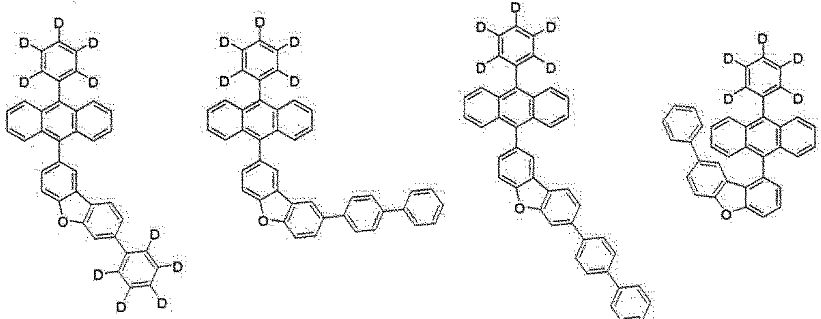

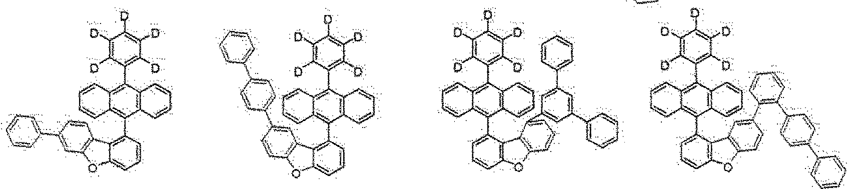

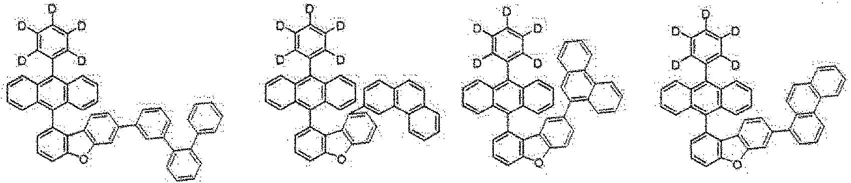

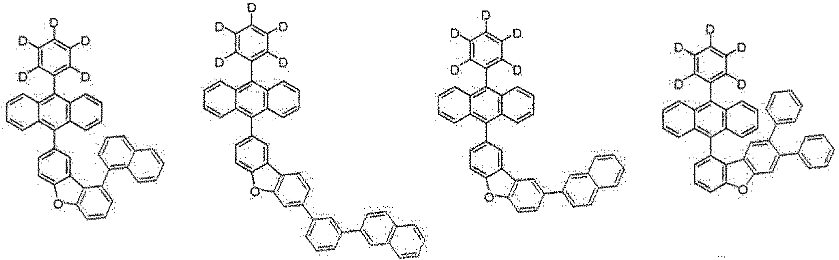

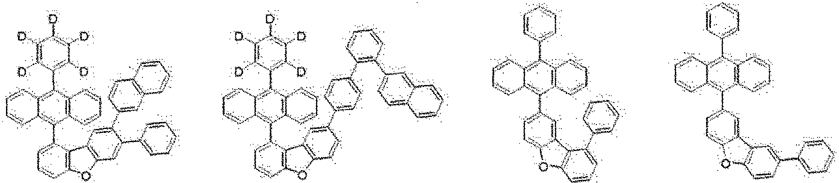

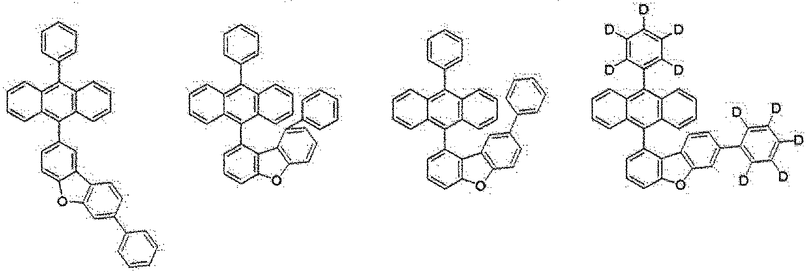

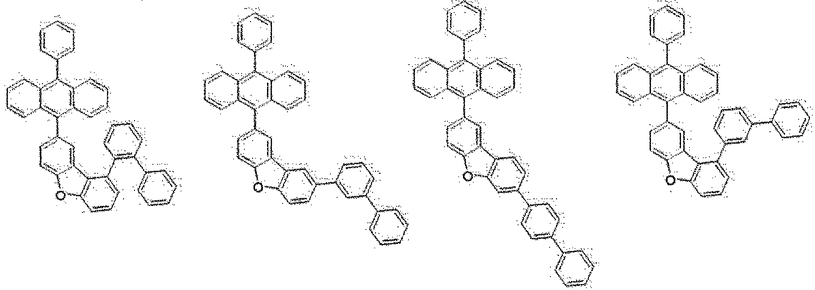

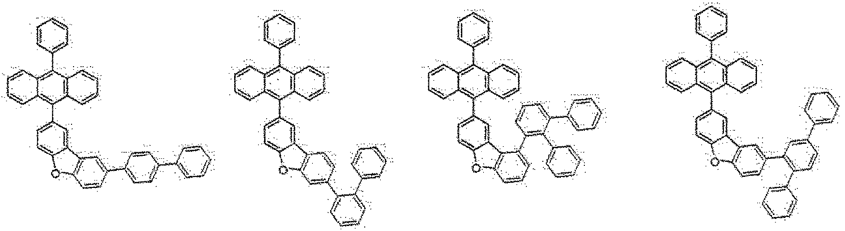

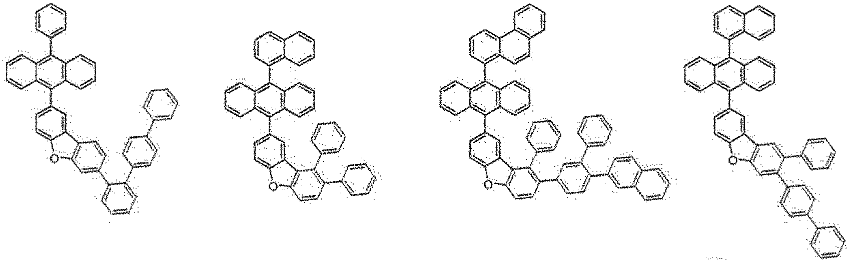

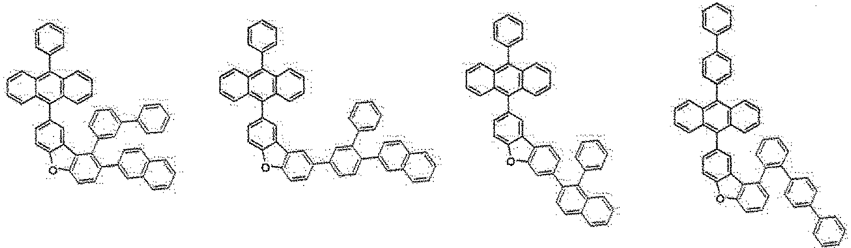

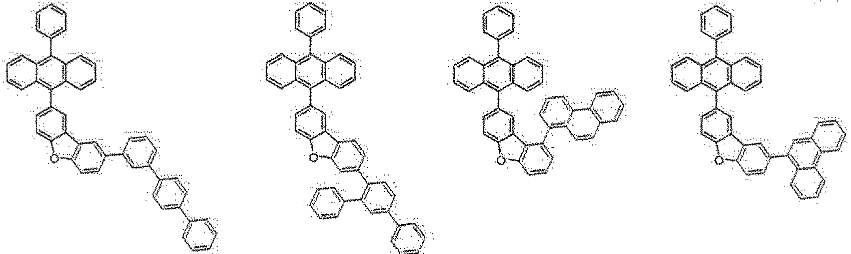

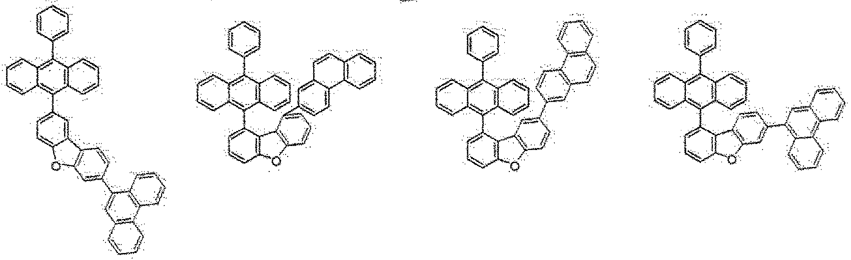

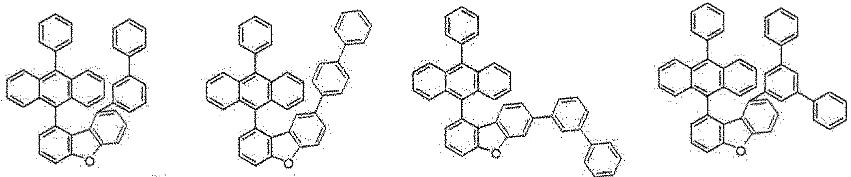

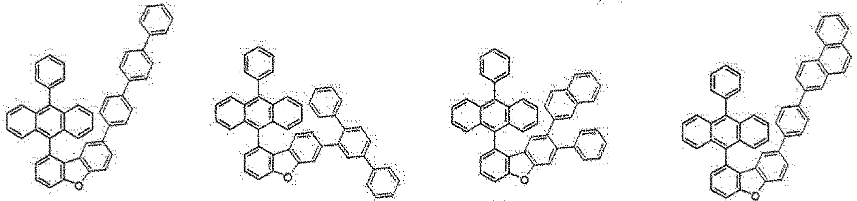

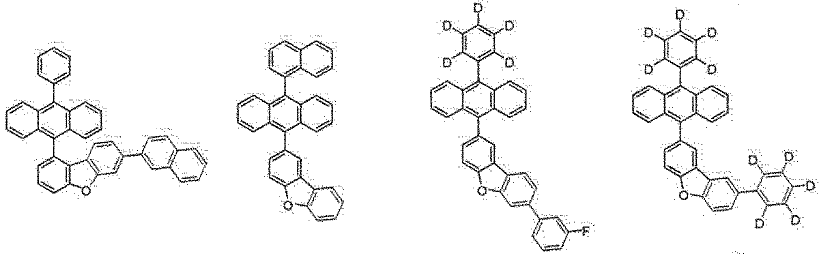

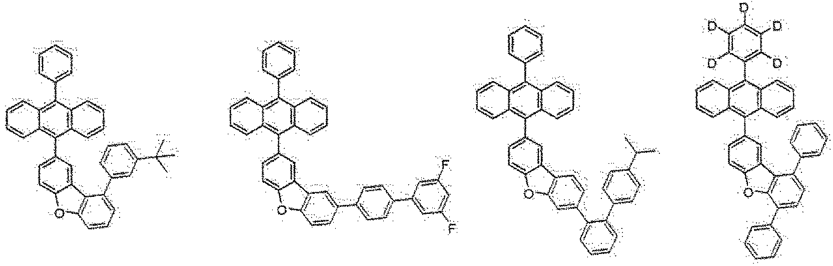

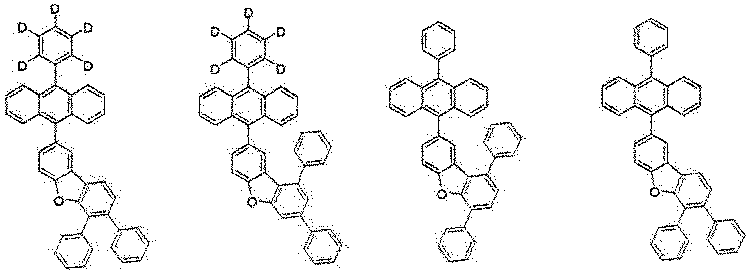

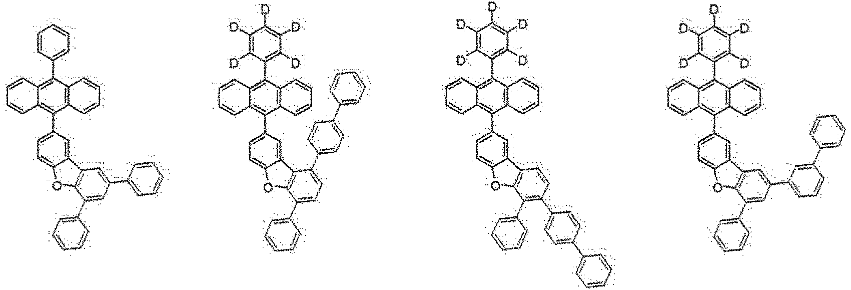

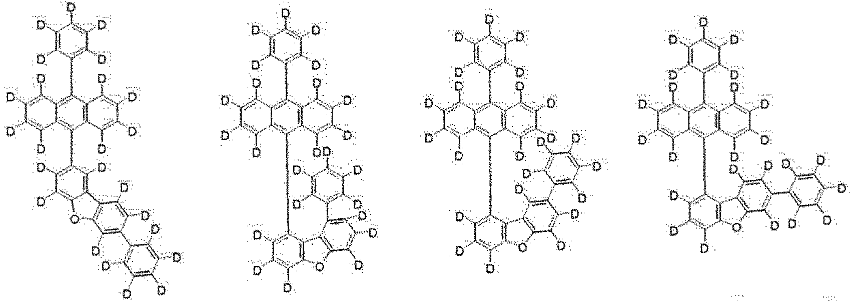

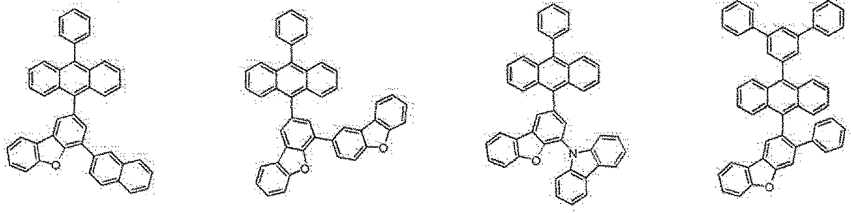

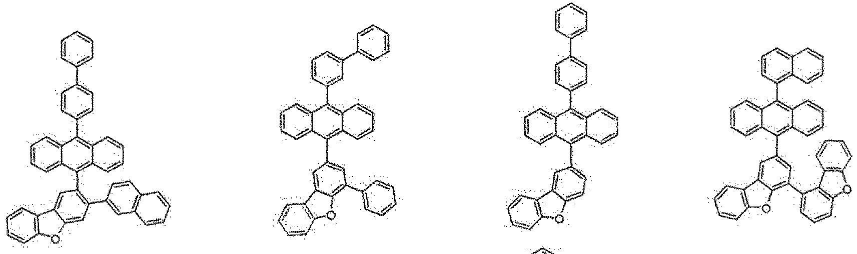

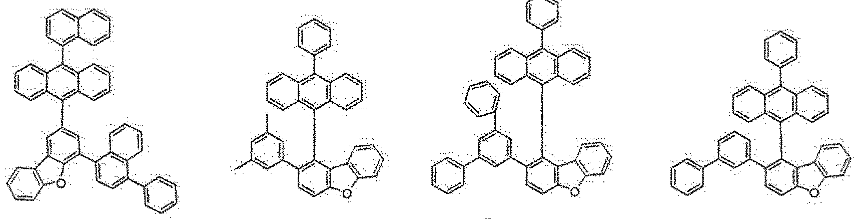

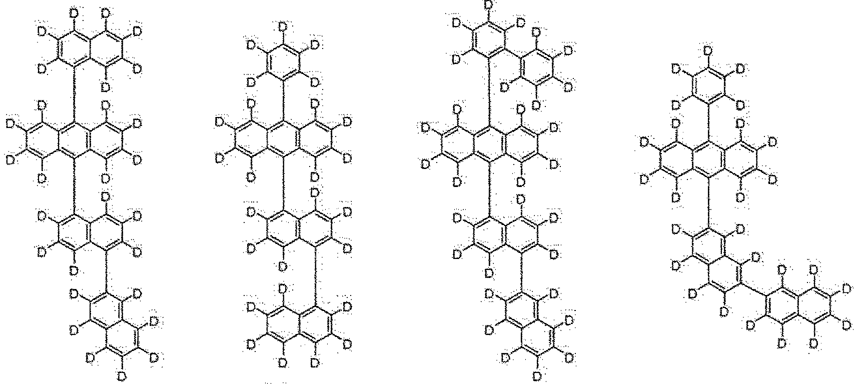

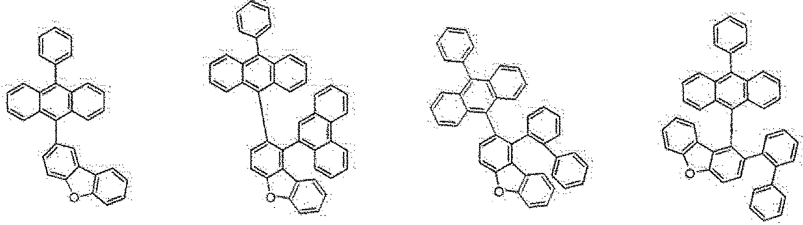

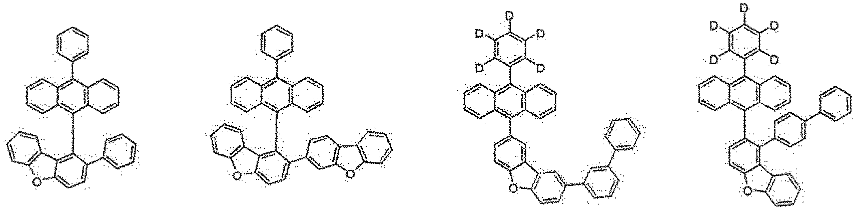

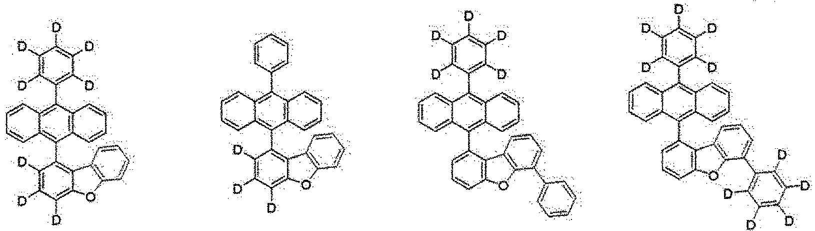

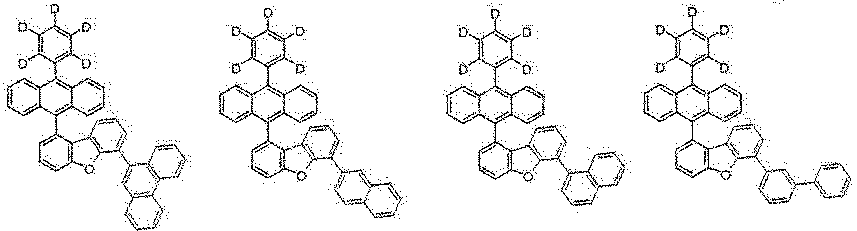

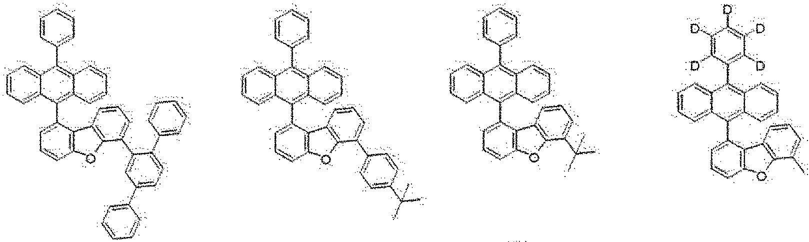

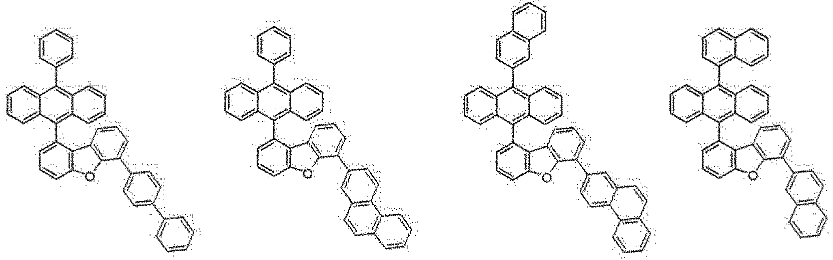

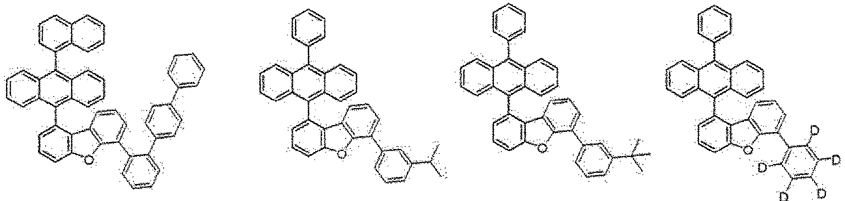

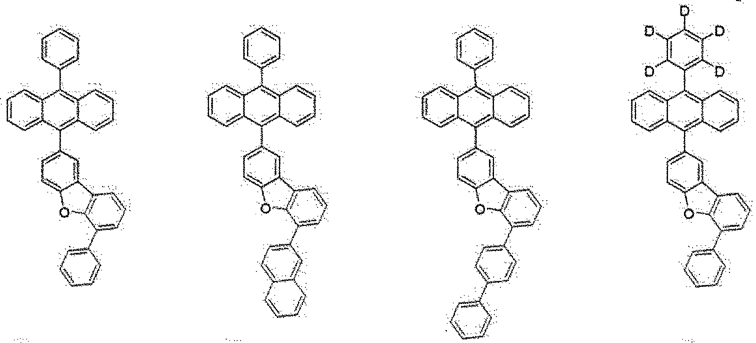

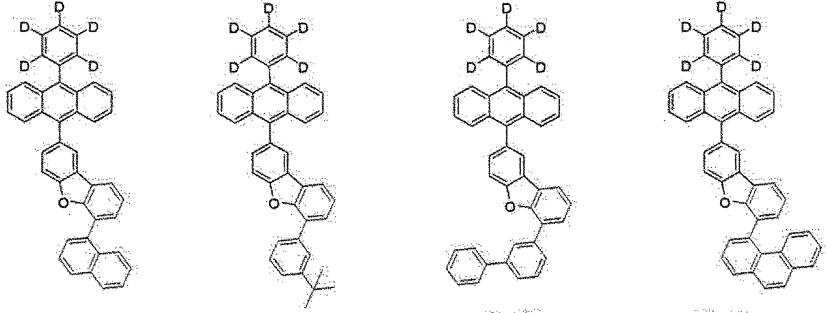

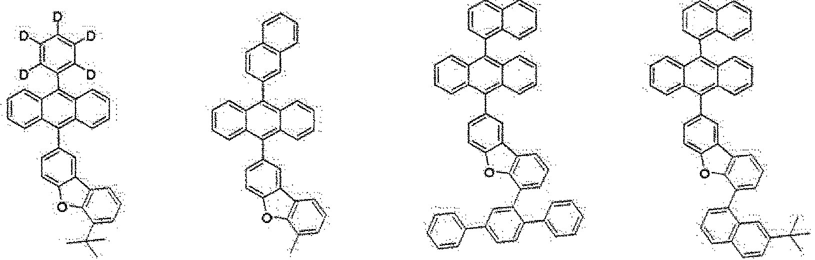

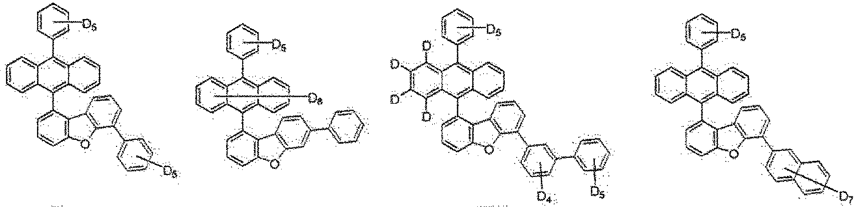

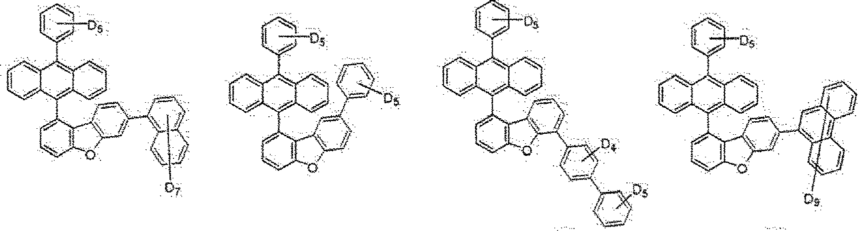

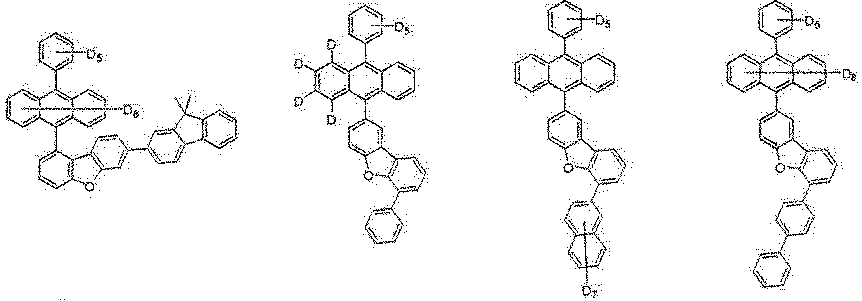

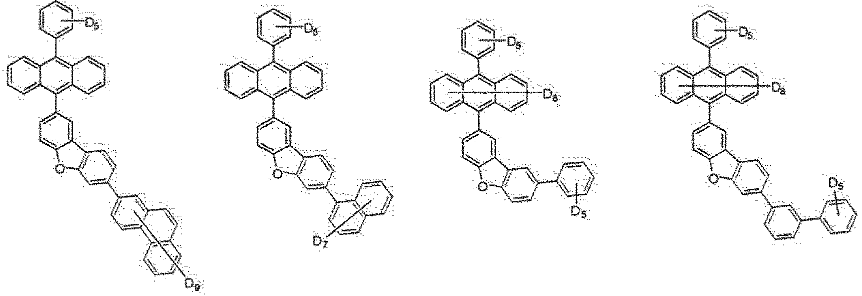

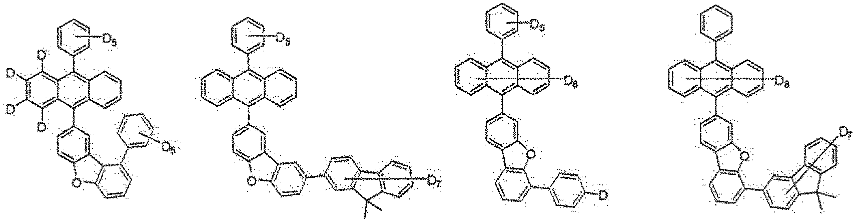

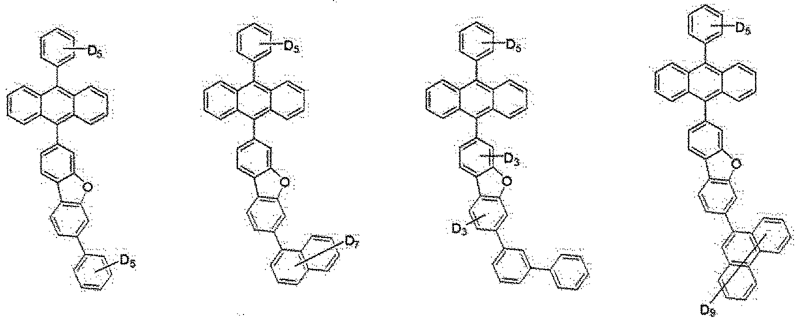

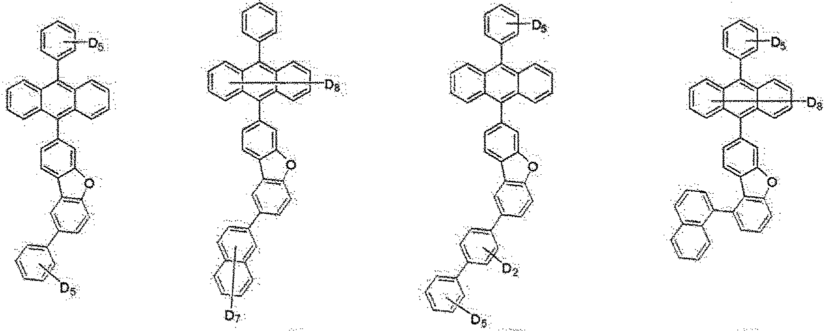

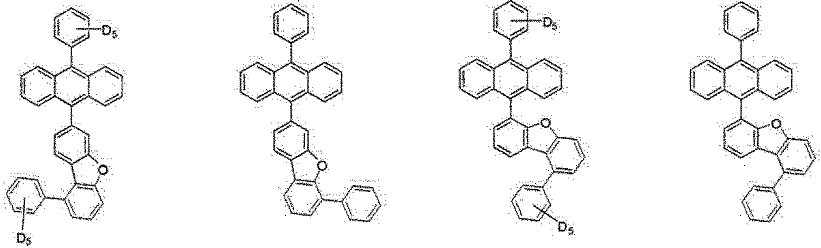

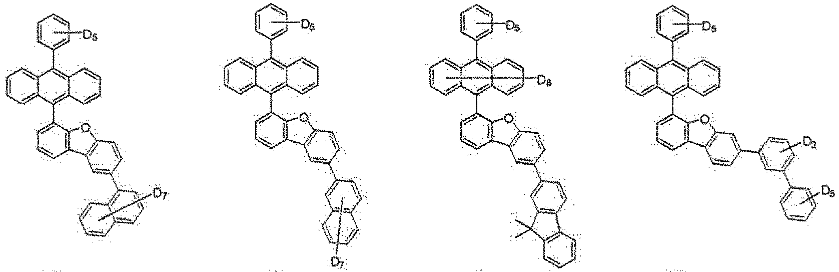

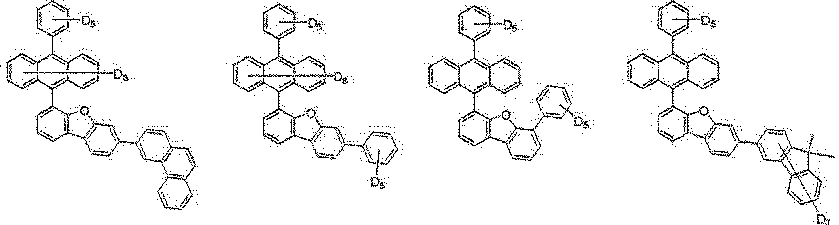

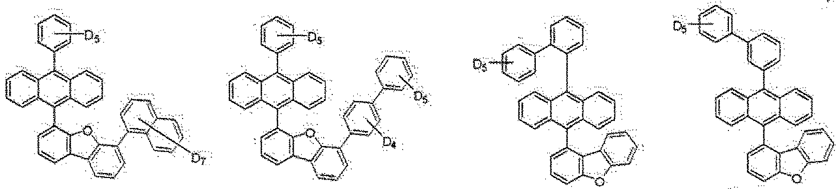

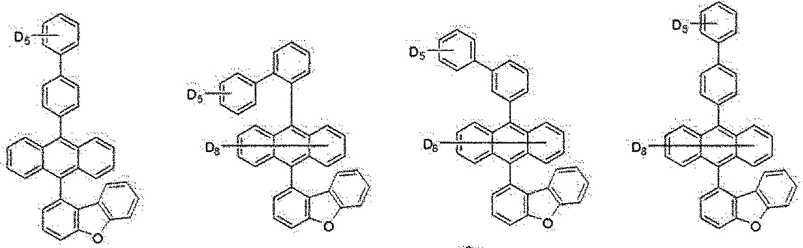

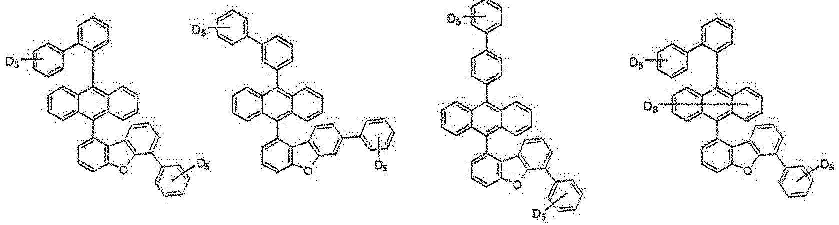

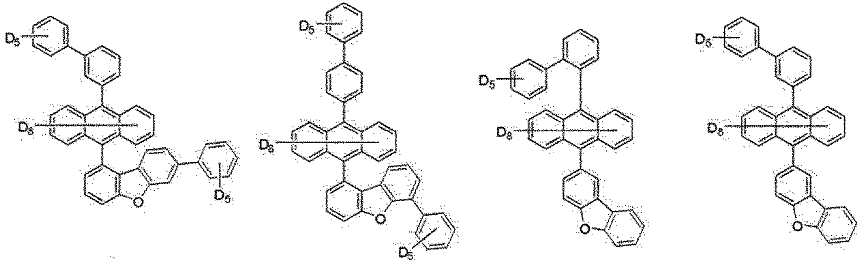

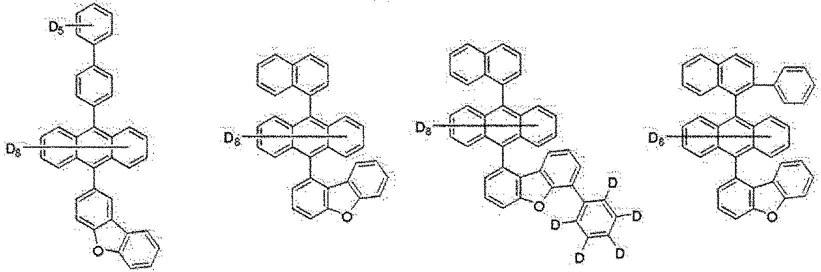

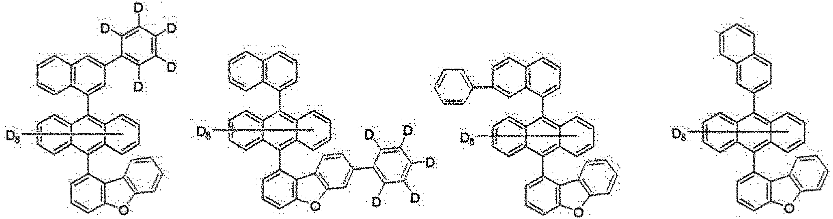

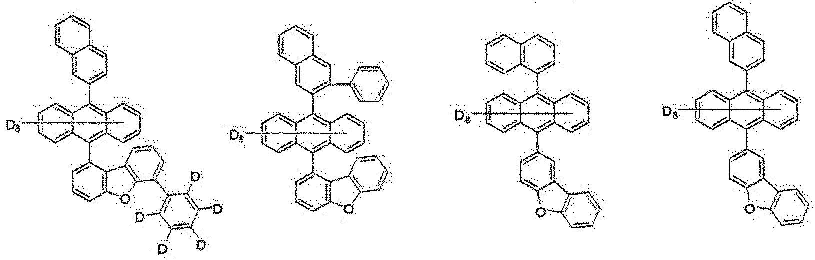

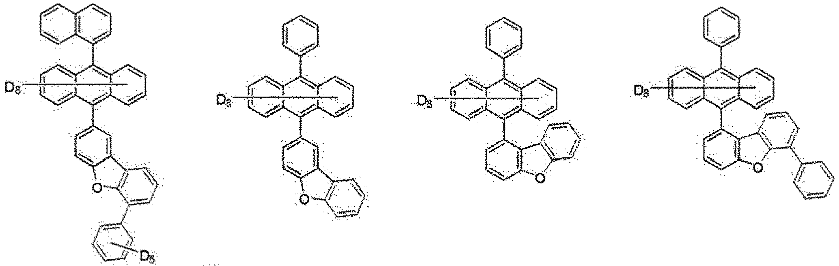

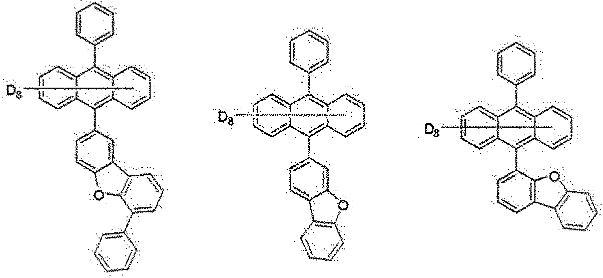

9. Die organische lichtemittierende Vorrichtung gemäß Anspruch 6, wobei eine oder mehrere andere Wirtsverbindungen als die durch Formel H dargestellte Anthracenverbindung in der lichtemittierenden Schicht gemischt oder gestapelt sind.

10. Die organische lichtemittierende Vorrichtung gemäß Anspruch 6, wobei eine oder mehrere Dotierungsverbindungen außer der durch Formel I dargestellten polyzyklischen Verbindung in der lichtemittierenden Schicht gemischt oder gestapelt sind.

11. Die organische lichtemittierende Vorrichtung gemäß Anspruch 5, wobei eine oder mehrere der Schichten durch einen Abscheidungs- oder Lösungsprozess gebildet werden.

12. Die organische lichtemittierende Vorrichtung gemäß Anspruch 4, wobei die organische lichtemittierende Vorrichtung in einem Anzeigegerät oder Beleuchtungssystem verwendet wird, das aus Flachbildschirmen, flexiblen Anzeigegeräten, monochromatischen Flachbildschirm-Beleuchtungssystemen, weißen Flachbildschirm-Beleuchtungssystemen, flexiblen monochromatischen Beleuchtungssystemen, flexiblen weißen Beleuchtungssystemen, Anzeigegeräten für Automobilanwendungen, Anzeigegeräten für virtuelle Realität und Anzeigegeräten für erweiterte Realität ausgewählt ist.

## Revendications

1. Composé polycyclique représenté par la Formule I : 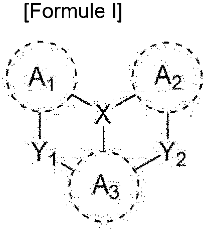
X étant B, P=O, P=S ou AI, Y₁ et Y₂ étant indépendamment NR₁, O, S, CRR₂R₃ ou SiR₄R₅, et A₁ à A₃ étant chacun indépendamment choisis parmi des cycles hydrocarbonés aromatiques en C₅-C₅₀ substitués ou non substitués, des cycles hétérocycliques aromatiques en C₂-C₅₀ substitués ou non substitués, des cycles aliphatiques en C₃-C₃₀ substitués ou non substitués, et des cycles mixtes aliphatique-aromatique en C₃-C₃₀ substitués ou non substitués, et comprenant la structure représentée par la Formule structurelle A : 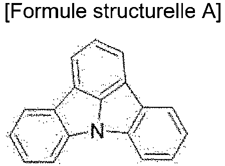
sous réserve qu'au moins un des A₁ à A₃ est la structure représentée par la Formule structurelle A, la structure représentée par la Formule structurelle A étant optionnellement substituée par un ou plusieurs radicaux R, R et R₁ à R₅ étant identiques ou différents les uns des autres et étant chacun indépendamment choisis parmi hydrogène, deutérium, alkyle en C1-C30 substitué ou non substitué, alcényle en C₂-C₃₀ substitué ou non substitué, aryle en C₆-C₅₀ substitué ou non substitué, cycloalkyle en C₃-C₃₀ substitué ou non substitué, hétérocycloalkyle en C₃-C₃₀ substitué ou non substitué, hétéroaryle en C₂-C₅₀ substitué ou non substitué, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₅-C₃₀ substitué ou non substitué, amine substituée ou non substituée, silyle substitué ou non substitué, des groupes cycliques mixtes aliphatique-aromatique en C₃-C₃₀ substitués ou non substitués, nitro, cyano, et halogène, et les substituants de chacun des cycles A₁ à A₃ étant optionnellement liés les uns aux autres pour former un monocycle ou polycycle alicyclique ou aromatique, chacun des R₁ à R₅ étant optionnellement lié à un substituant adjacent d'au moins un des cycles A₁ à A₃ pour former un monocycle ou polycycle alicyclique ou aromatique, les radicaux R étant optionnellement liés les uns aux autres pour former un monocycle ou polycycle alicyclique ou aromatique, R₂ et R₃ étant optionnellement liés les uns aux autres pour former un monocycle ou polycycle alicyclique ou aromatique, et R₄ et R₅ étant optionnellement liés les uns aux autres pour former un monocycle ou polycycle alicyclique ou aromatique,
le terme « substitué » dans la définition des cycles A₁ à A₃, R, R₁ à R₅, etc. désignant une substitution par un ou plusieurs substituants choisis parmi deutérium, cyano, halogène, hydroxyle, nitro, alkyle, cycloalkyle, halogénoalkyle, alcényle, alcynyle, hétéroalkyle, hétérocycloalkyle, aryle, arylalkyle, hétéroaryle, hétéroarylalkyle, alcoxy, alkylamine, arylamine, hétéroarylamine, alkylsilyle, arylsilyle, et aryloxy, ou une combinaison de ceux-ci.

2. Composé polycyclique selon la revendication 1, le composé polycyclique étant représenté par une des Formules I-1 et I-2 : 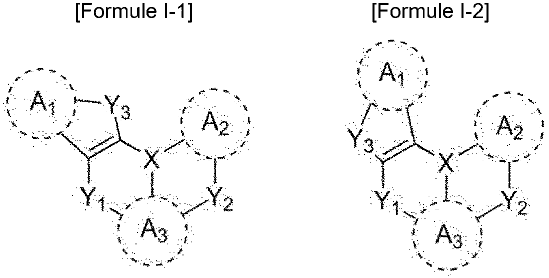 Y₃ étant NR₁, O, S, CRR₂R₃ ou SiR₄R₅, R₁ à R₅ étant tels que définis dans la Formule I, et X, Y₁, Y₂, et A₁ à A₃ étant tels que définis dans la Formule I.

3. Composé polycyclique selon la revendication 1, le composé polycyclique étant choisi parmi les composés suivants :

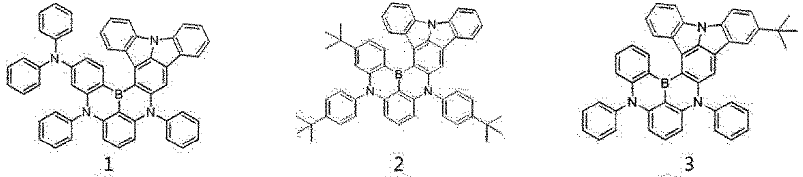

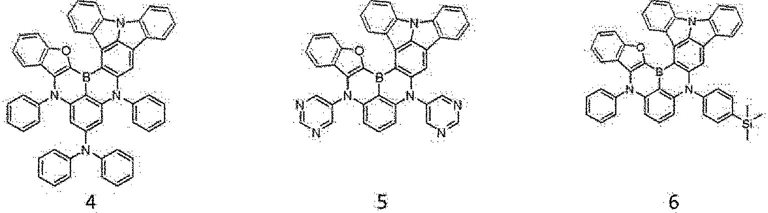

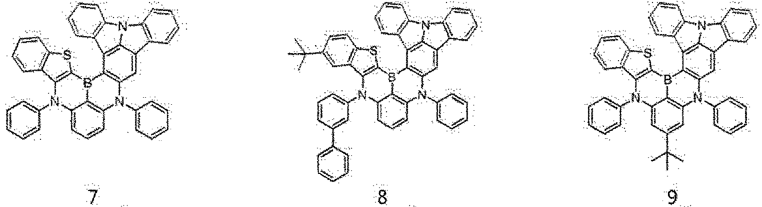

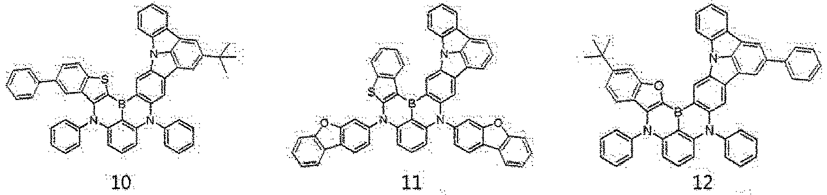

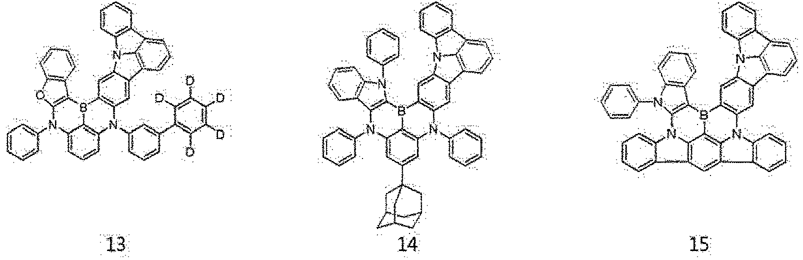

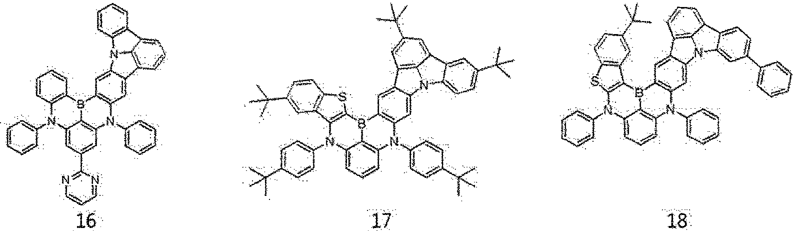

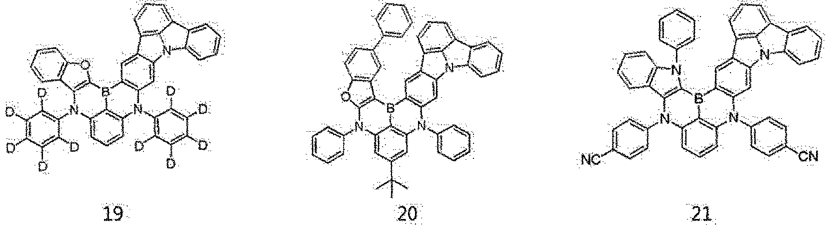

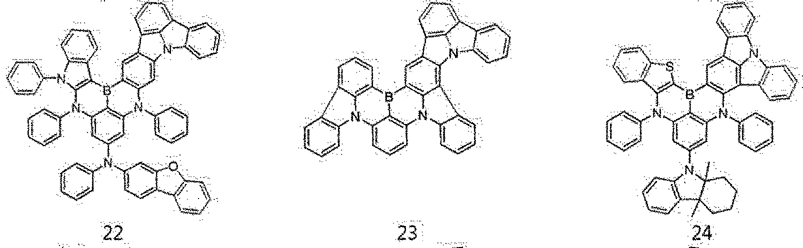

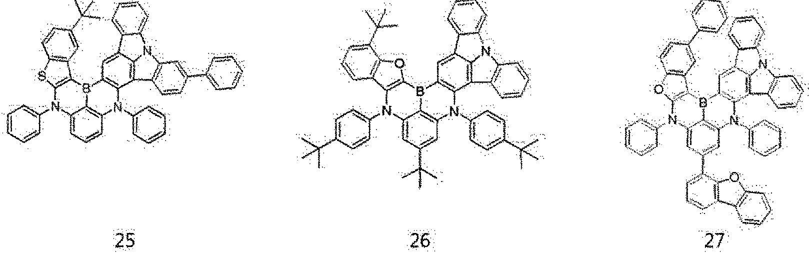

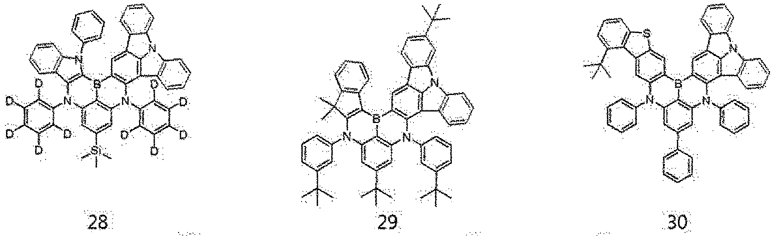

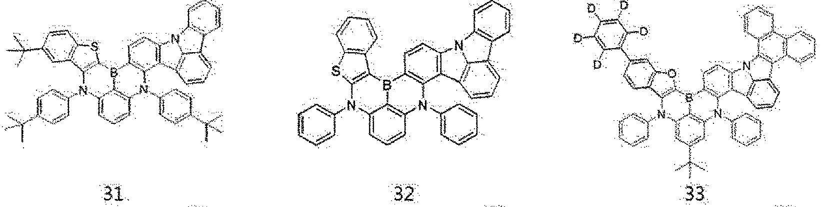

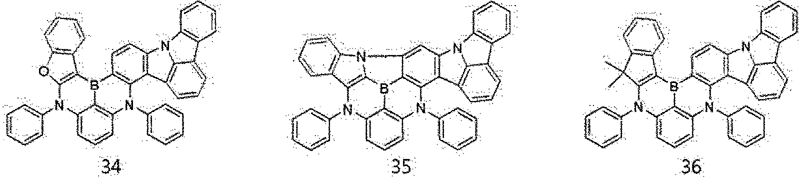

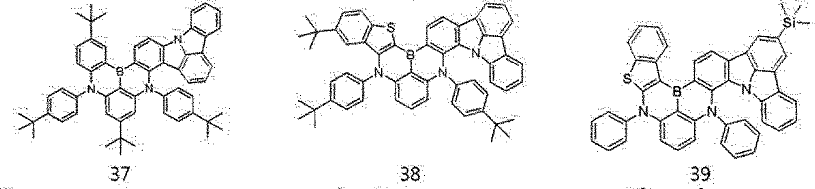

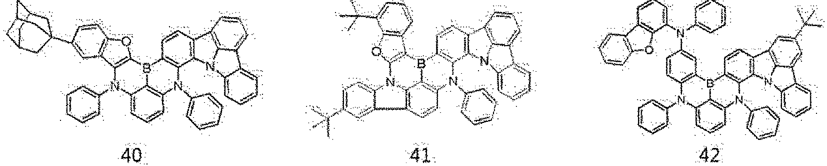

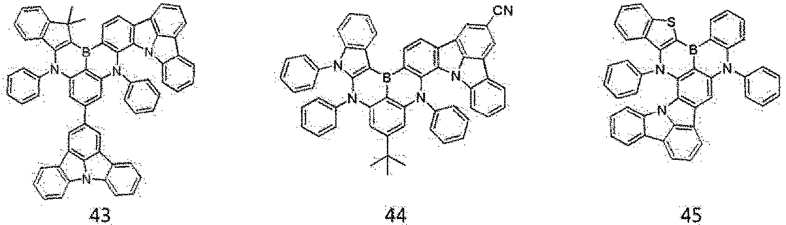

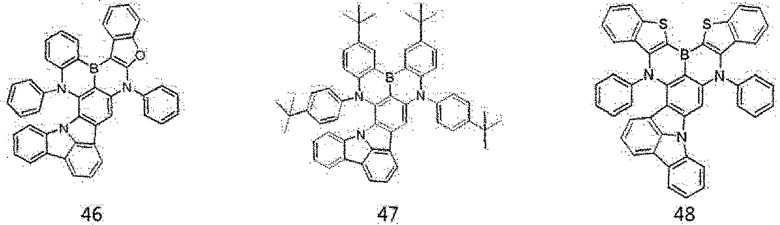

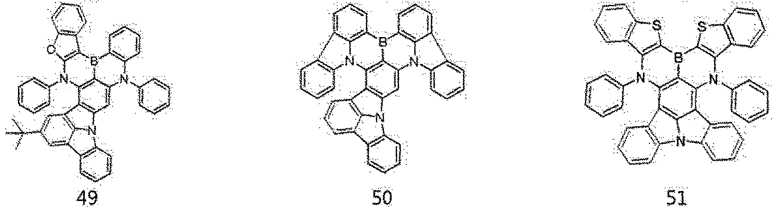

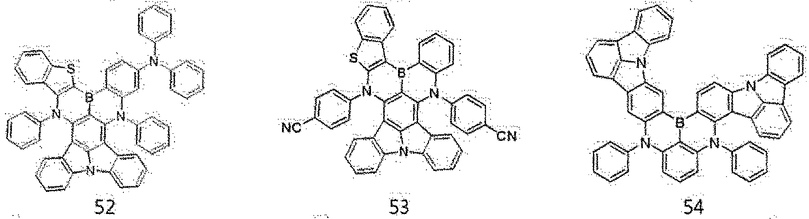

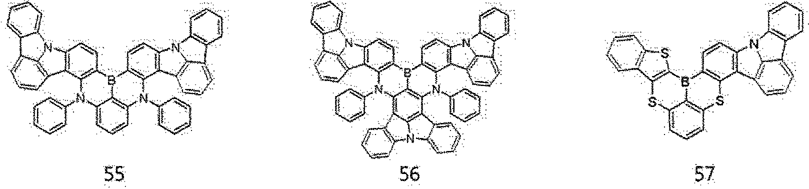

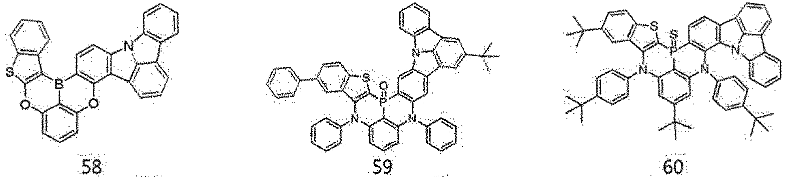

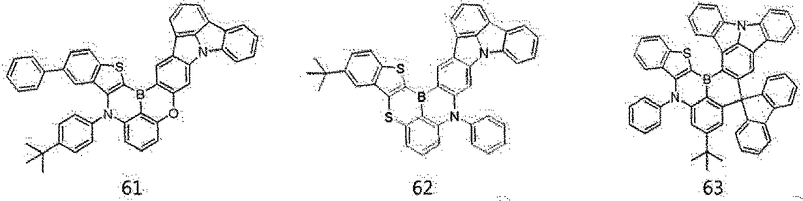

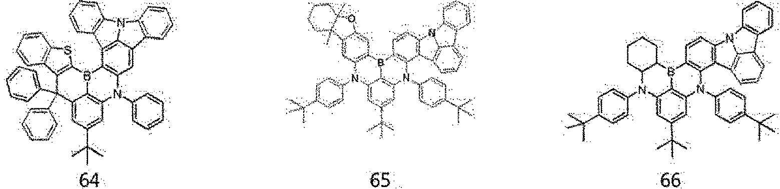

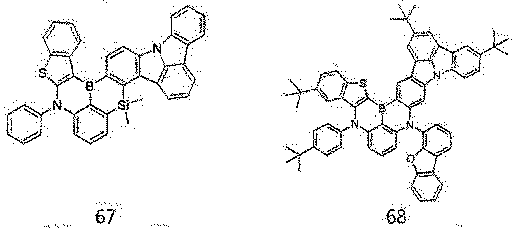

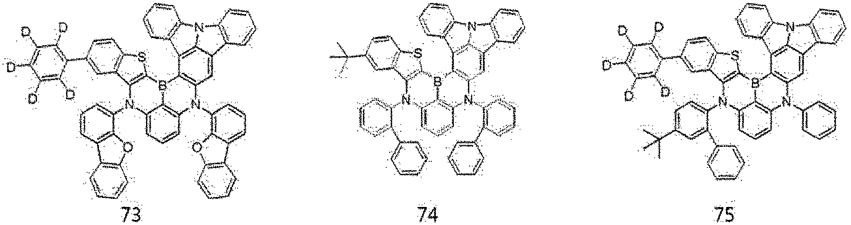

4. Dispositif électroluminescent organique comprenant une première électrode, une deuxième électrode en face de la première électrode, et une ou plusieurs couches organiques interposées entre les première et deuxième électrodes, une des couches organiques comprenant les composés polycycliques représentés par la Formule I selon la revendication 1.

5. Dispositif électroluminescent organique selon la revendication 4, dans lequel les couches organiques comprennent une couche d'injection d'électrons, une couche de transport d'électrons, une couche d'injection de trous, une couche de transport de trous, une couche de blocage d'électrons, une couche de blocage de trous, et/ou une couche d'émission de lumière, au moins une de celles-ci comprenant le composé électroluminescent organique représenté par la Formule I.

6. Dispositif électroluminescent organique selon la revendication 5, dans lequel la couche d'émission de lumière est constituée d'un hôte et du composé représenté par la Formule I en tant que dopant.

7. Dispositif électroluminescent organique selon la revendication 6, dans lequel ledit hôte est un composé d'anthracène représenté par la Formule H : 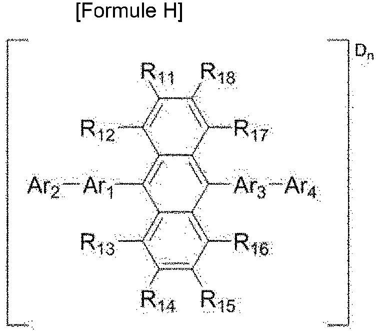 R₁₁ à R₁₈ étant identiques ou différents les uns des autres et étant choisis chacun indépendamment parmi hydrogène, alkyle en C₁-C₃₀ substitué ou non substitué, alcényle en C₂-C₃₀ substitué ou non substitué, aryle en C₆-C₅₀ substitué ou non substitué, cycloalkyle en C₃-C₃₀ substitué ou non substitué, hétérocycloalkyle en C₃-C₃₀ substitué ou non substitué, hétéroaryle en C₂-C₅₀ substitué ou non substitué, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₅-C₃₀ substitué ou non substitué, amine substituée ou non substituée, silyle substitué ou non substitué, des groupes cycliques mixtes aliphatiques-aromatiques en C₃-C₃₀ substitués ou non substitués, nitro, cyano, et halogène, Ar₁ et Ar₃ étant identiques ou différents l'un de l'autre et étant chacun indépendamment arylène en C₆-C₃₀ substitué ou non substitué ou hétéroarylène en C₅-C₃₀ substitué ou non substitué, Ar₂ et Ar₄ étant identiques ou différents l'un de l'autre et étant chacun indépendamment choisis parmi hydrogène, aryle en C₆-C₅₀ substitué ou non substitué, cycloalkyle en C₃-C₃₀ substitué ou non substitué, hétérocycloalkyle en C₃-C₃₀ substitué ou non substitué, hétéroaryle en C₂-C₅₀ substitué ou non substitué, et des groupes cycliques mixtes aliphatiques-aromatiques en C₃-C₂₀ substitués ou non substitués, Dₙ représentant le nombre des atomes de deutérium remplaçant les atomes d'hydrogène, et n étant un nombre entier compris entre 0 et 50.

8. Dispositif électroluminescent organique selon la revendication 7, dans lequel le composé représenté par la Formule H est choisi dans le groupe constitué des composés suivants :

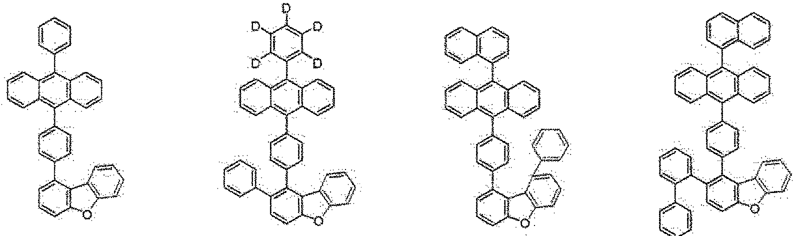

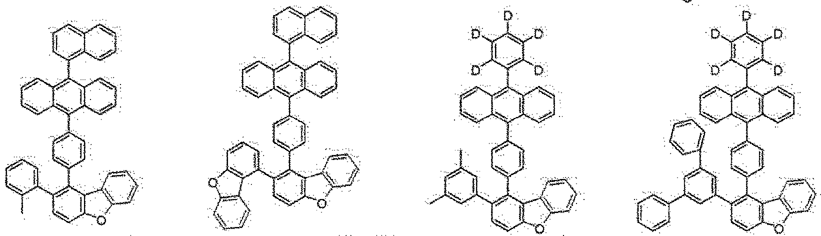

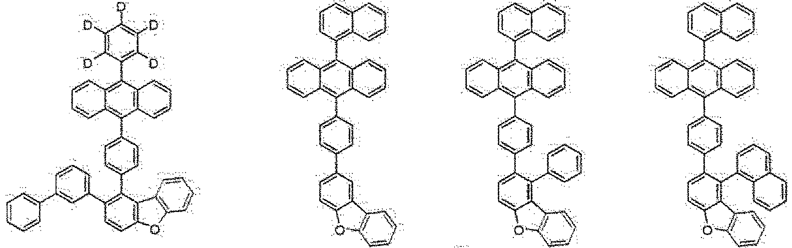

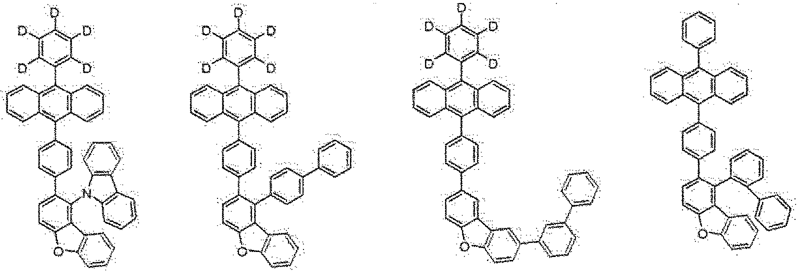

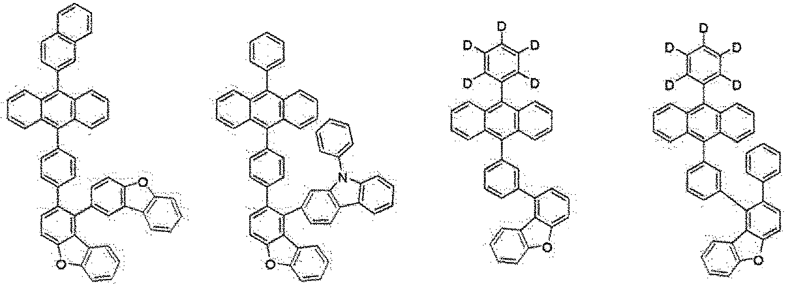

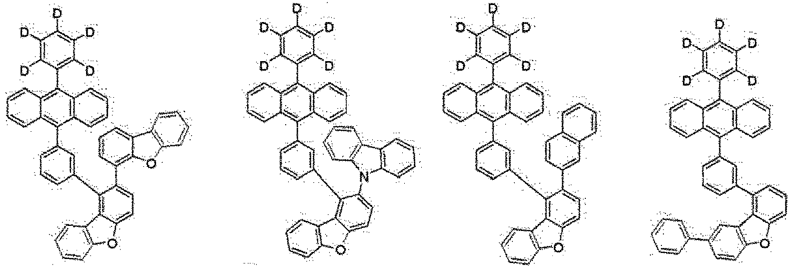

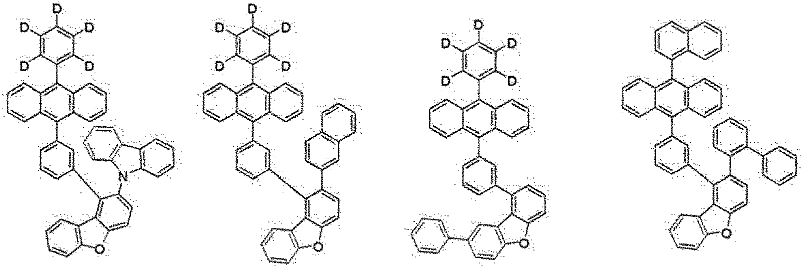

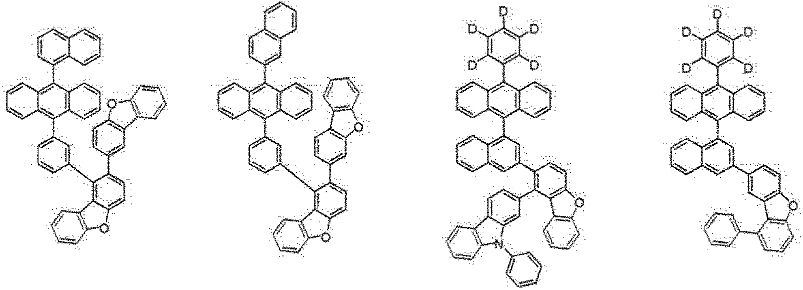

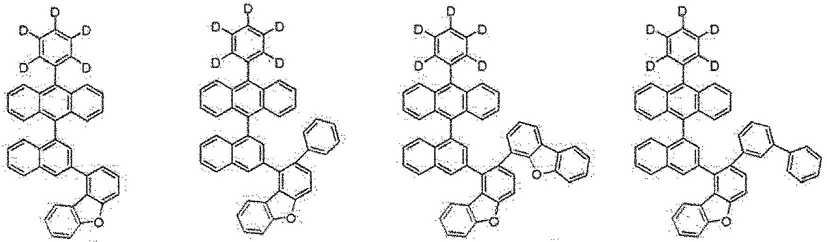

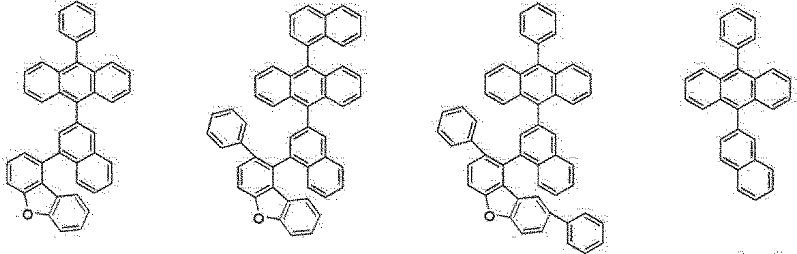

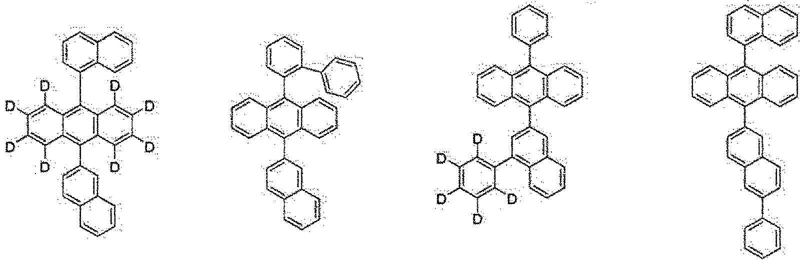

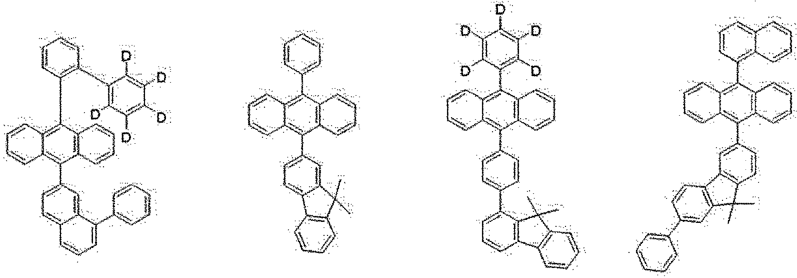

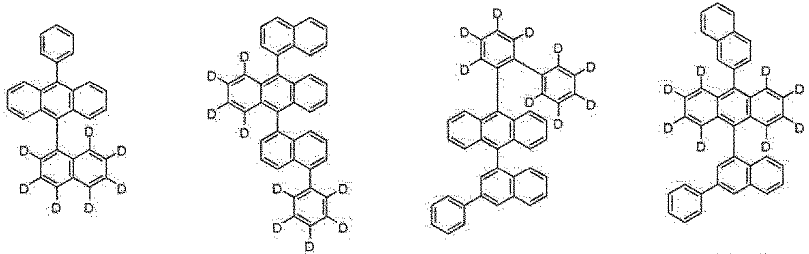

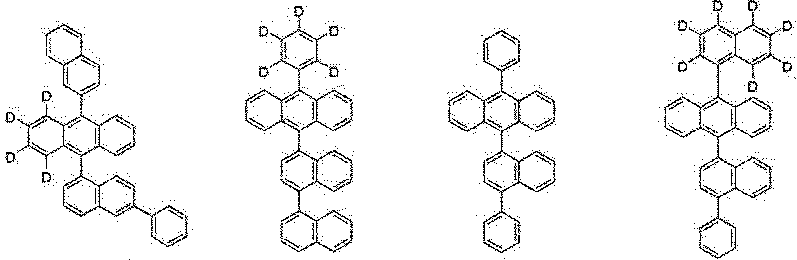

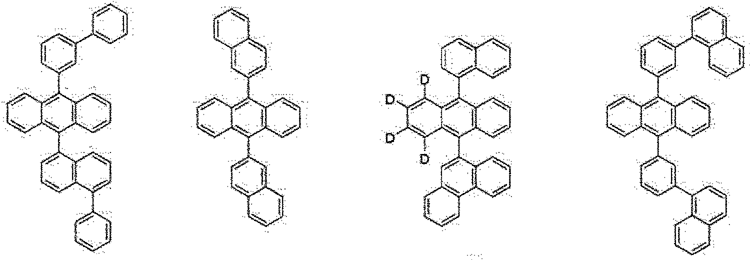

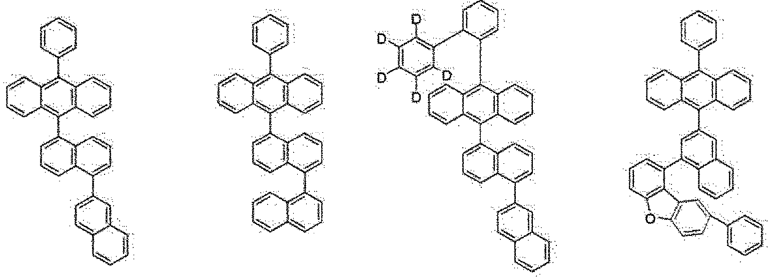

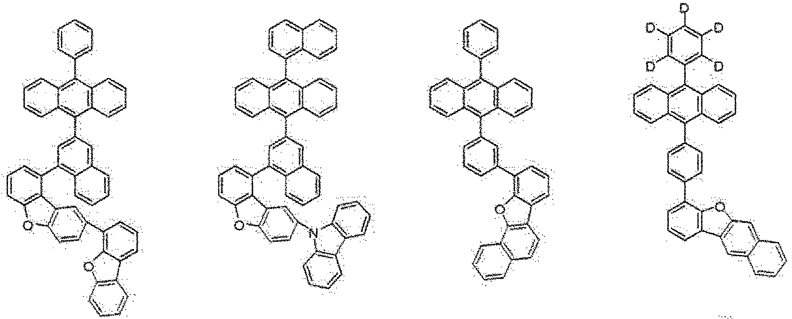

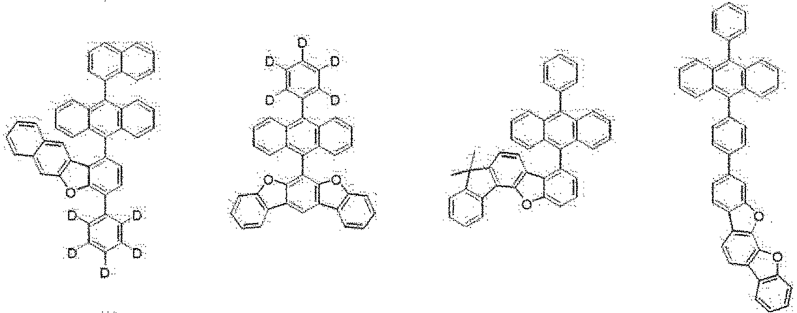

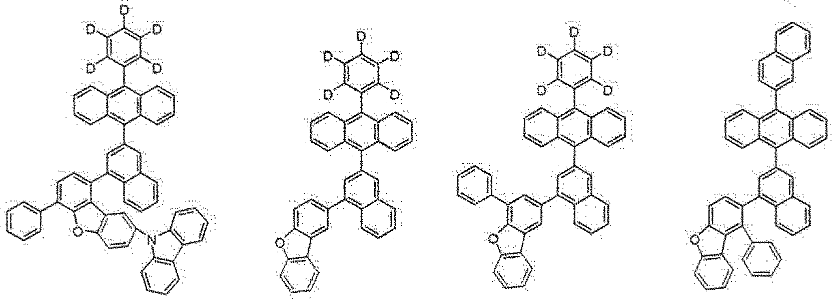

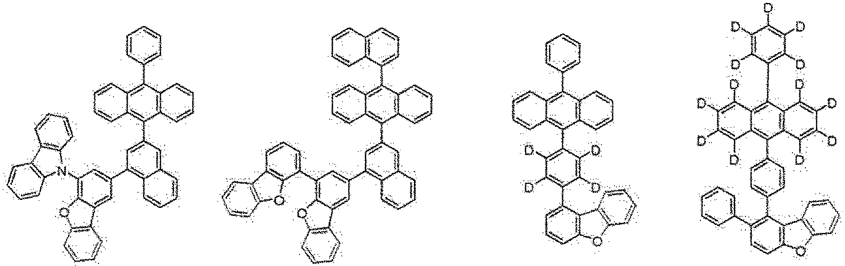

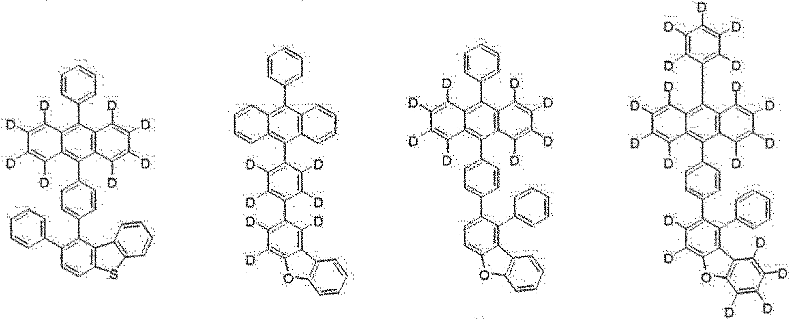

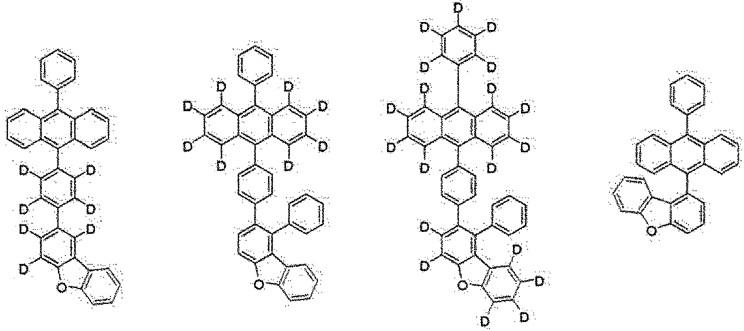

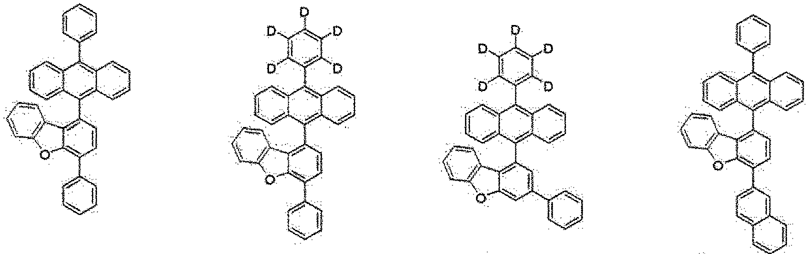

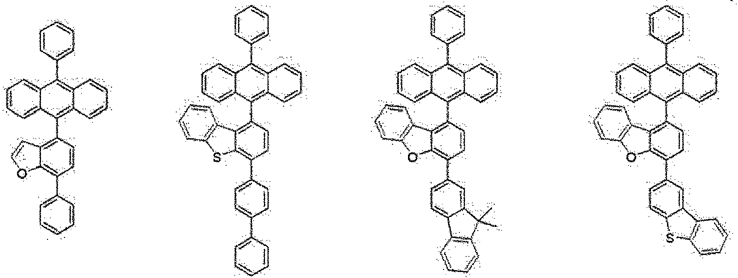

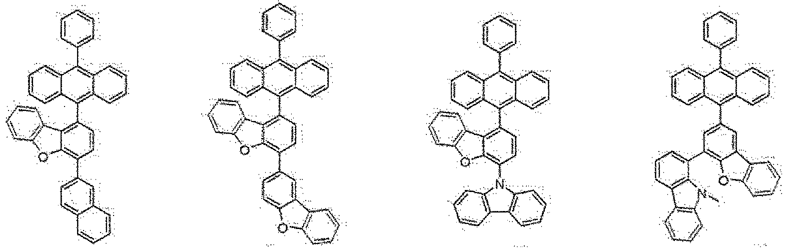

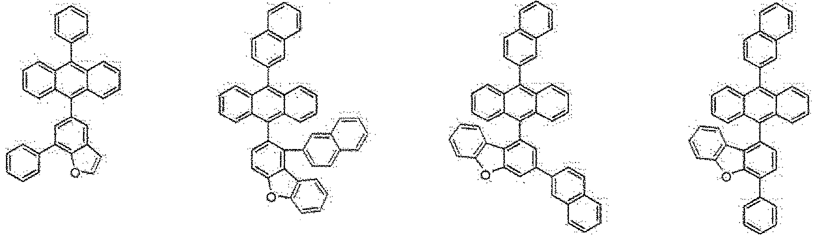

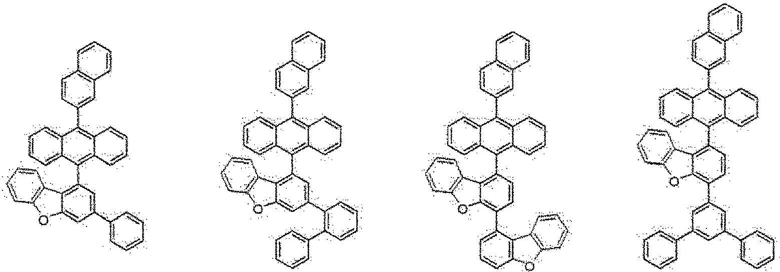

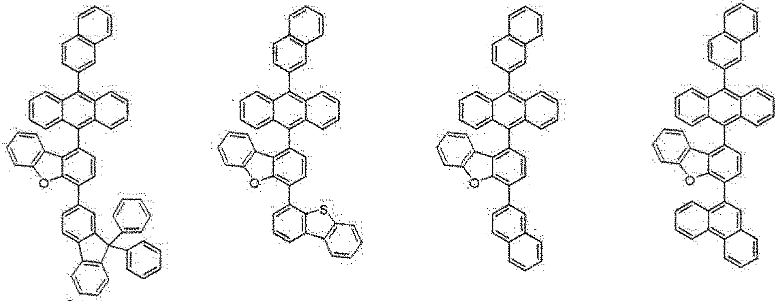

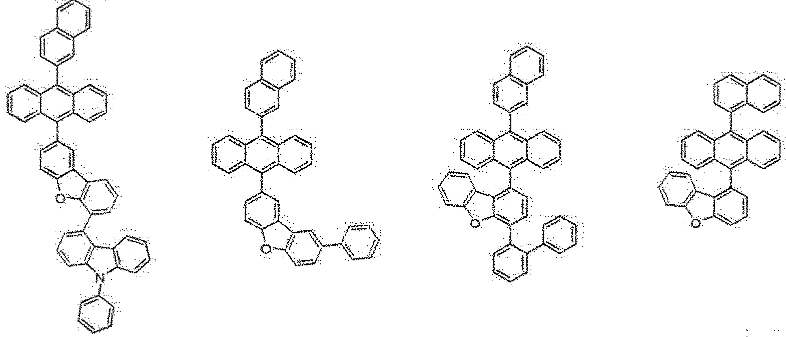

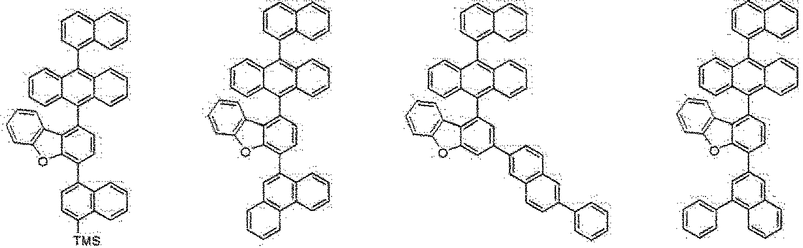

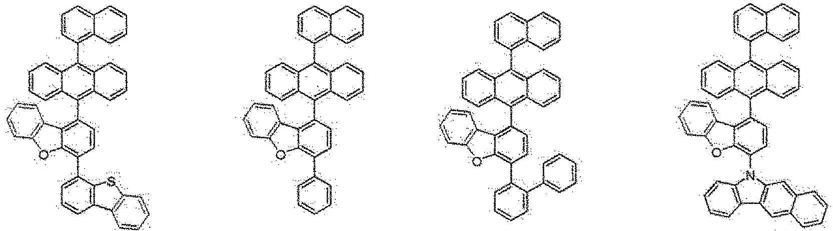

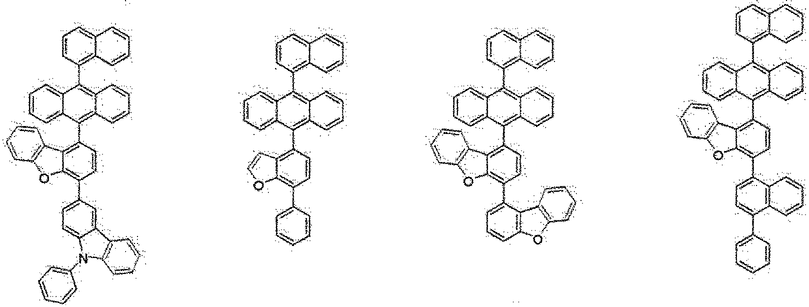

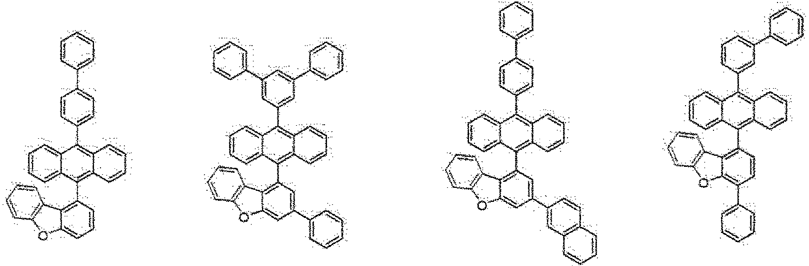

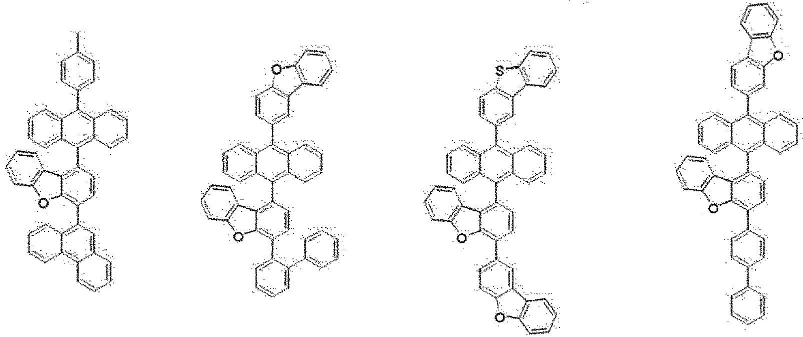

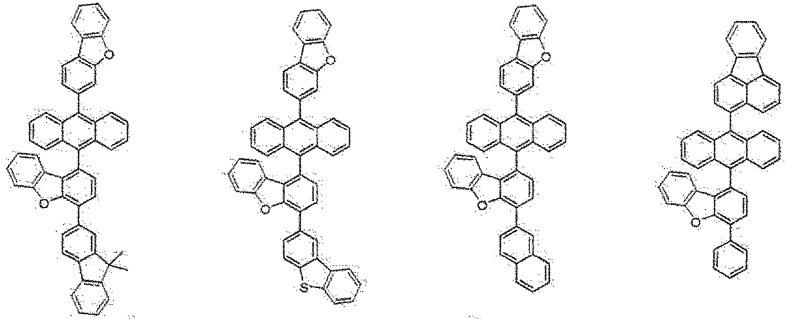

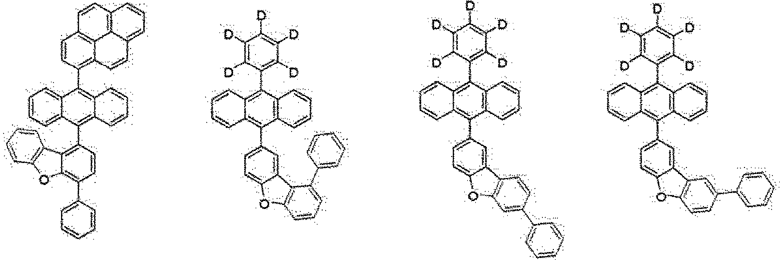

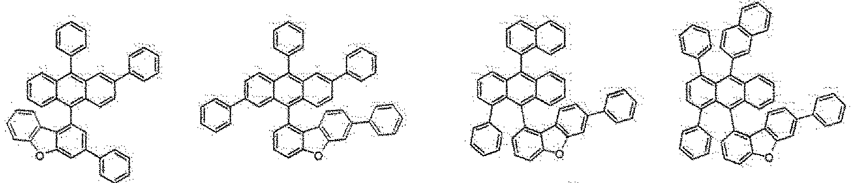

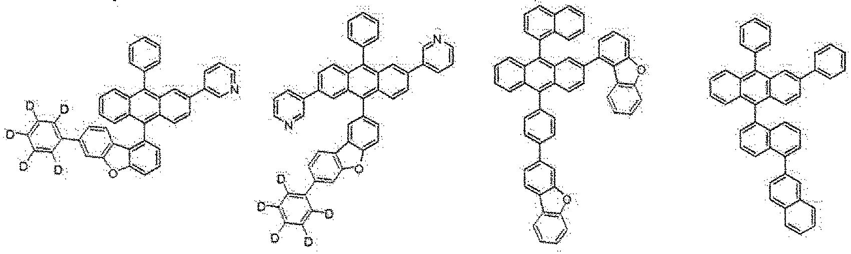

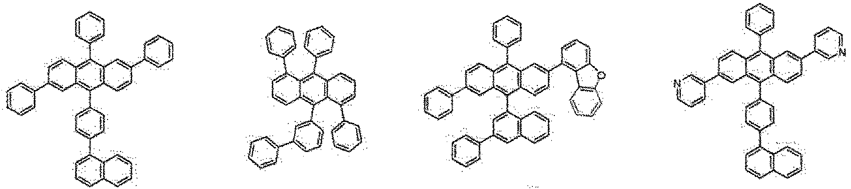

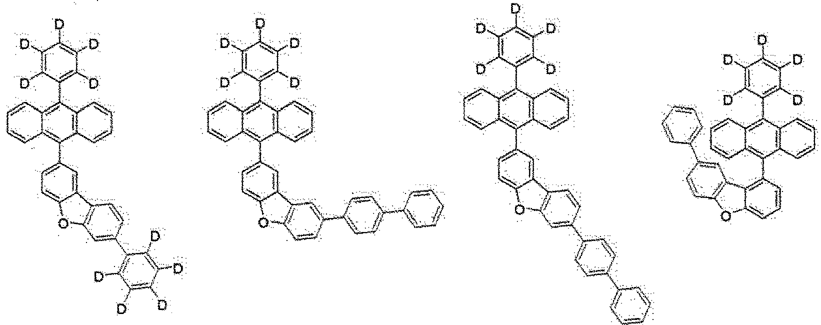

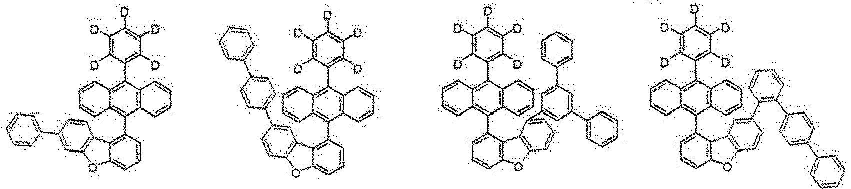

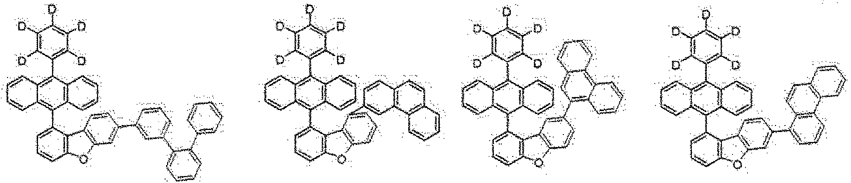

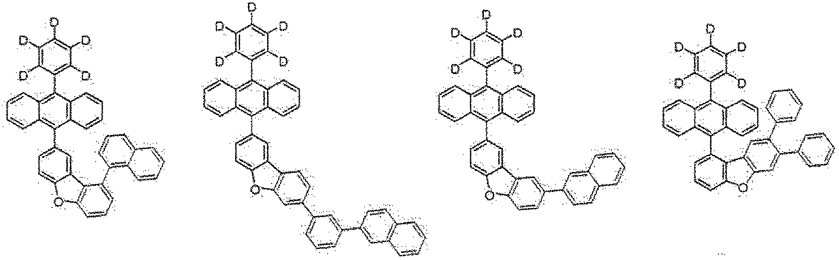

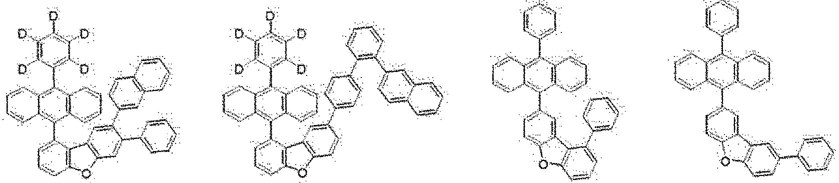

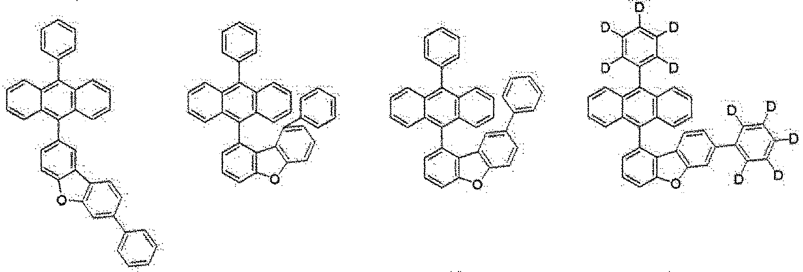

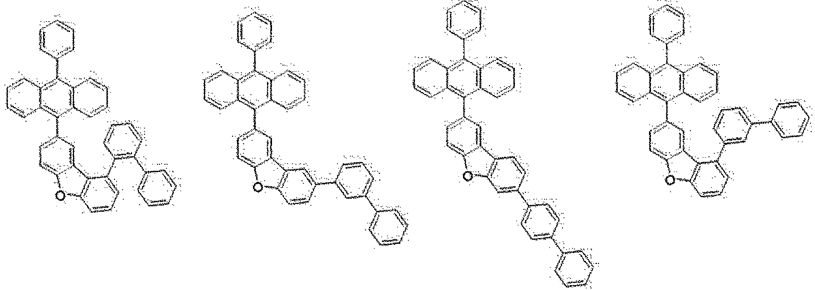

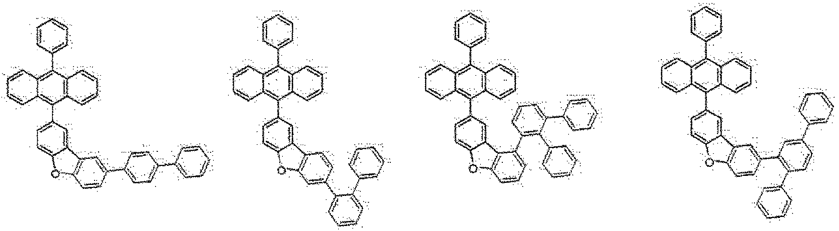

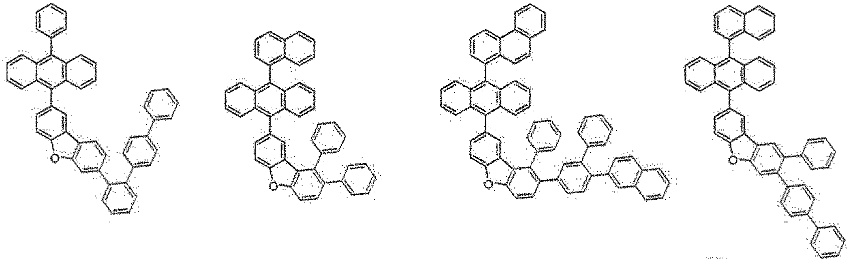

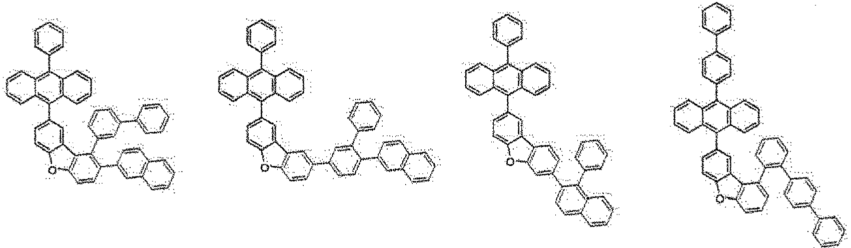

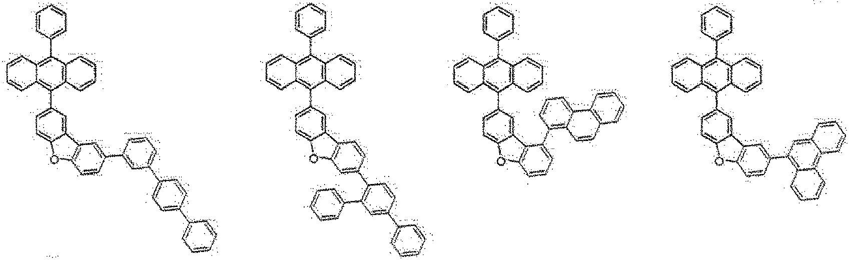

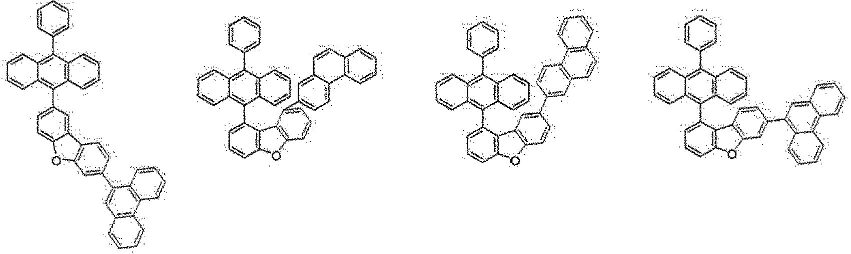

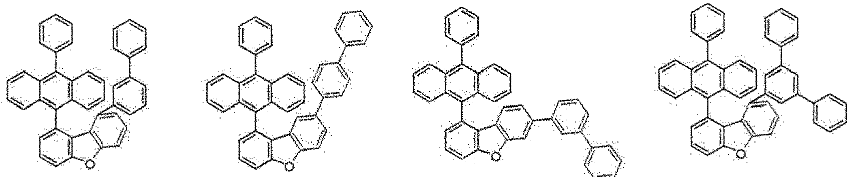

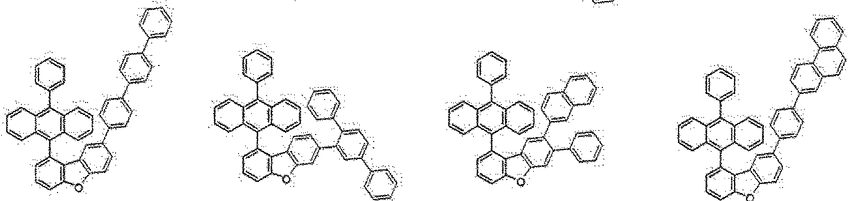

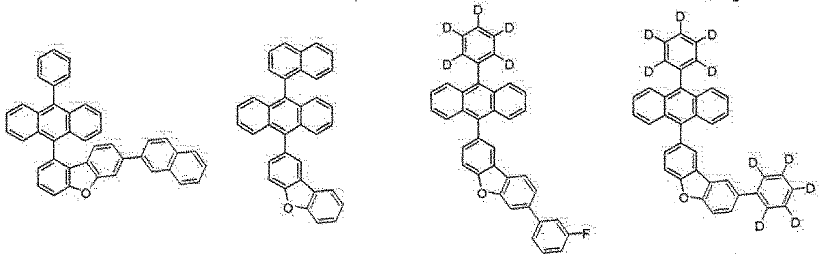

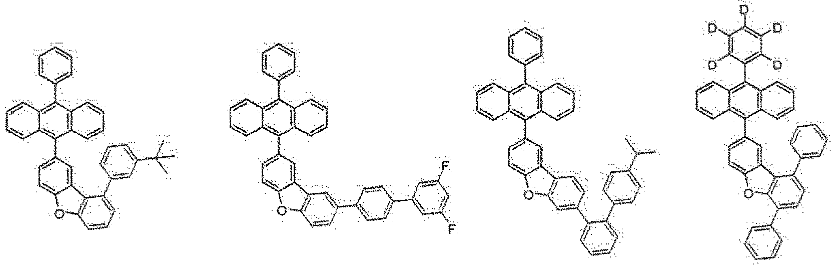

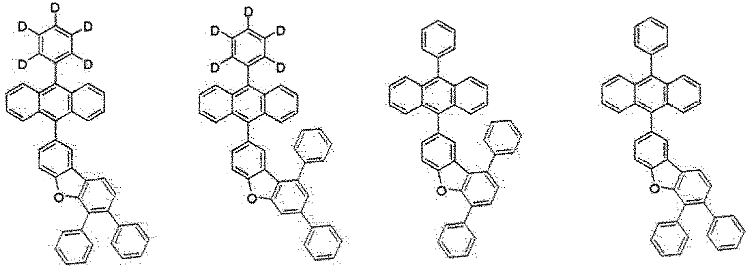

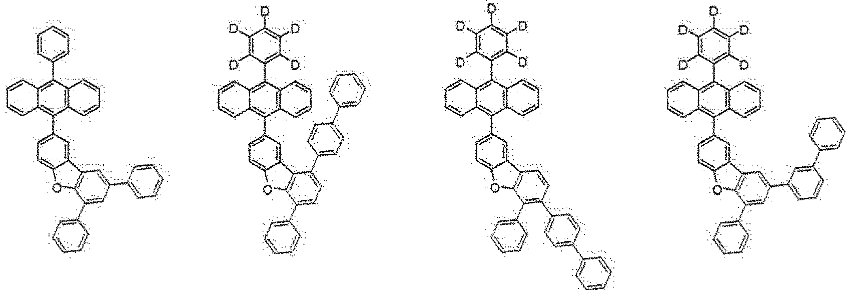

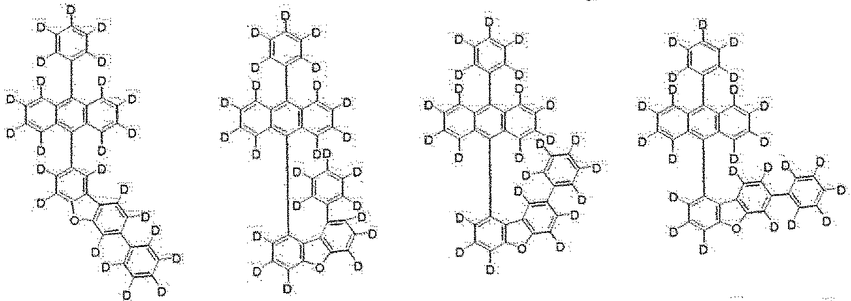

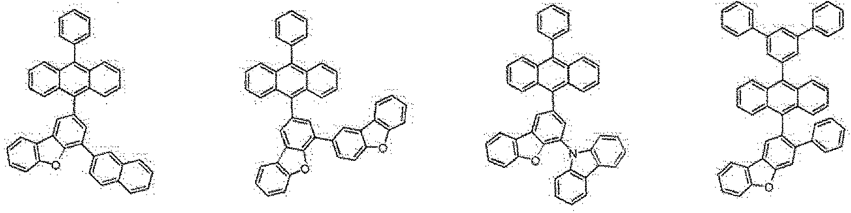

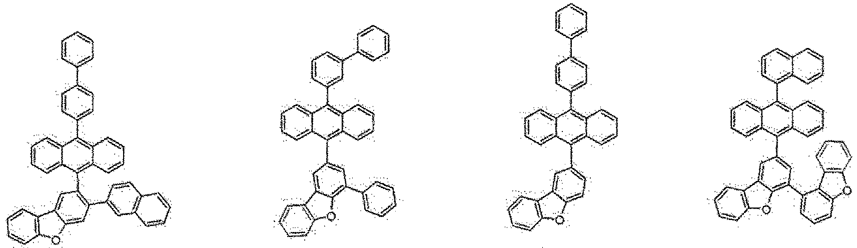

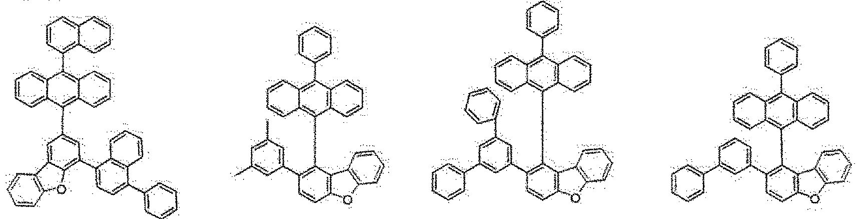

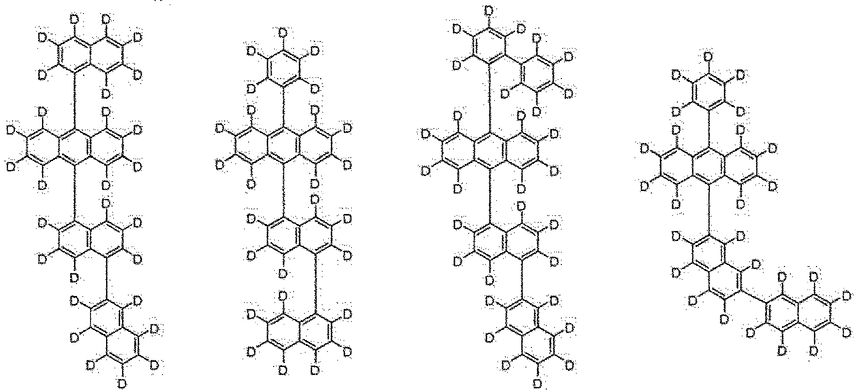

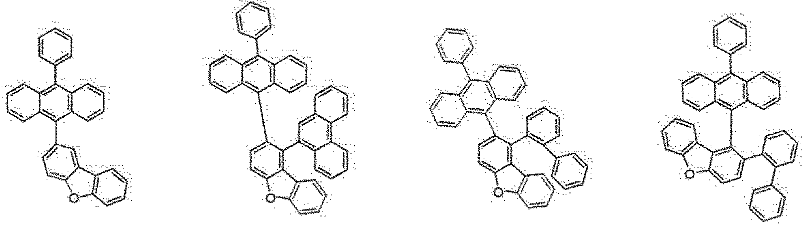

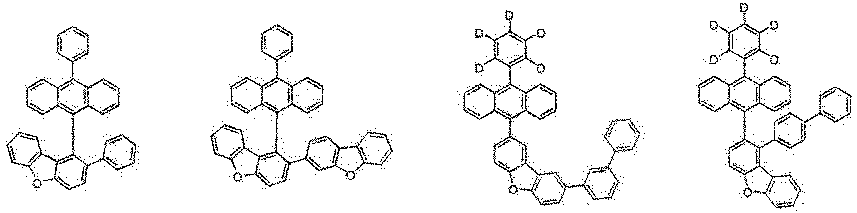

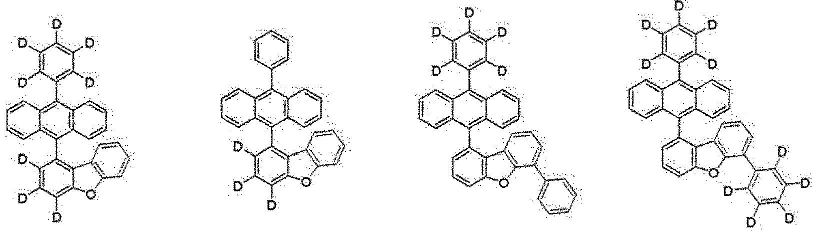

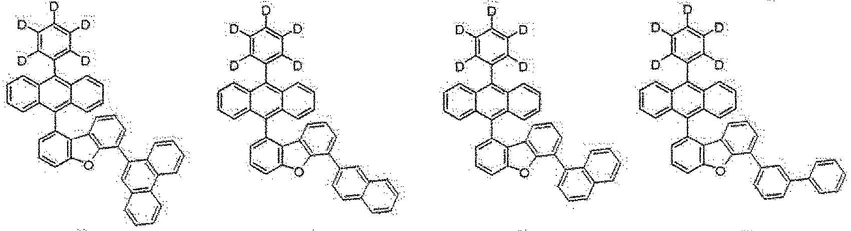

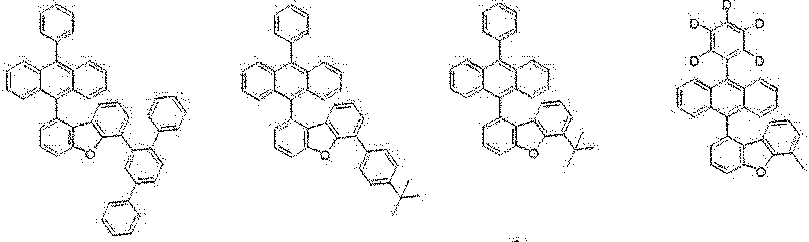

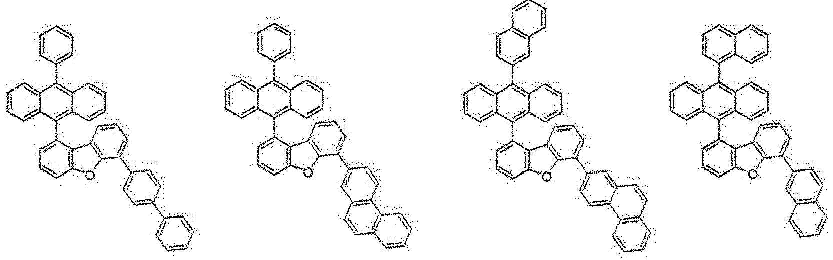

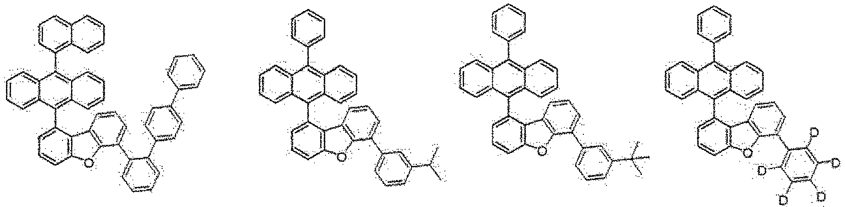

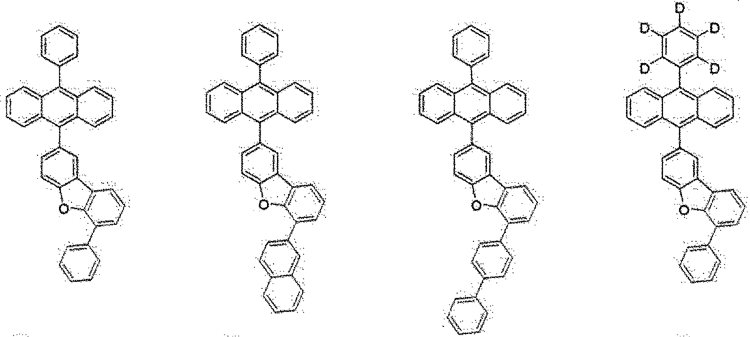

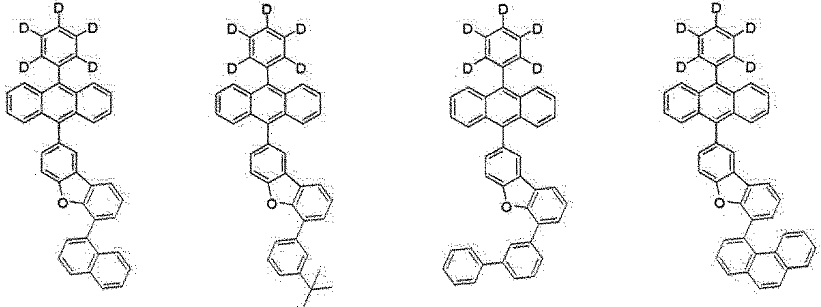

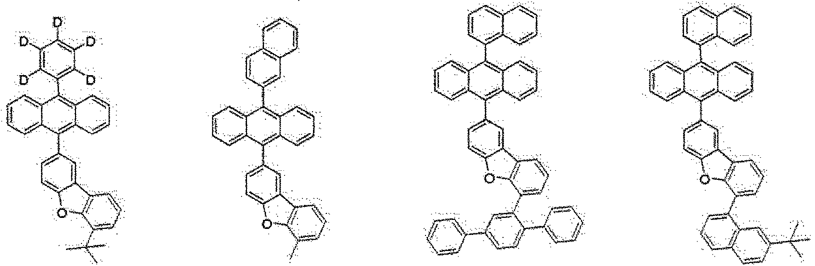

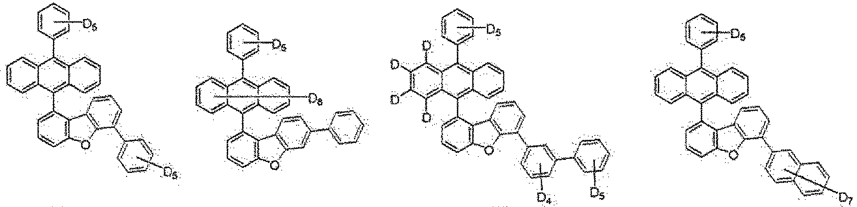

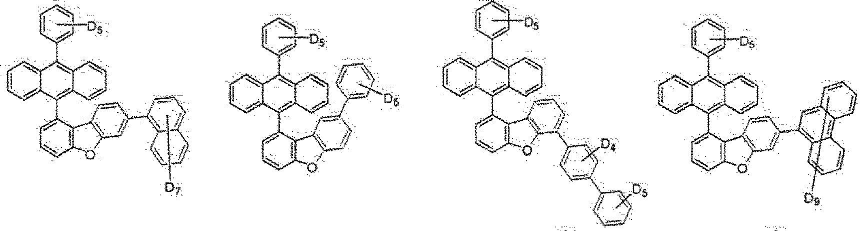

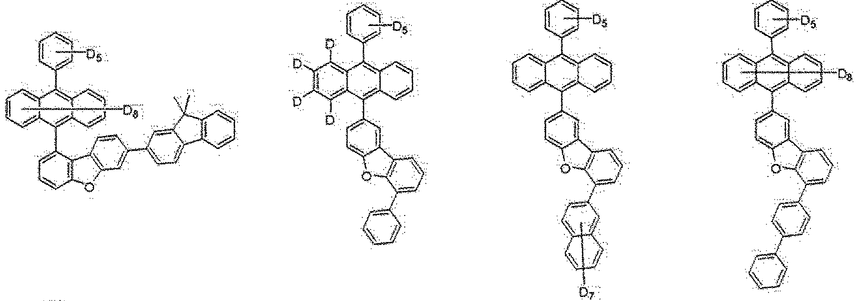

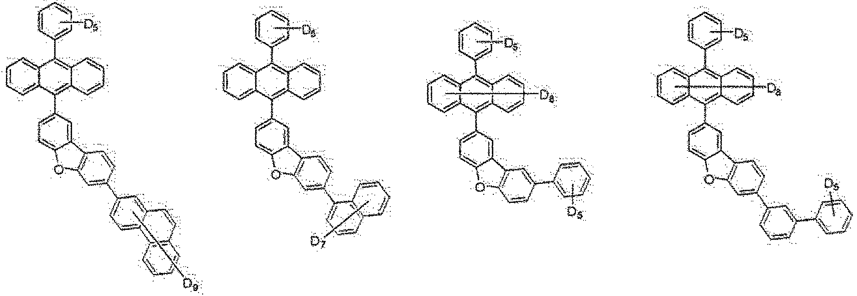

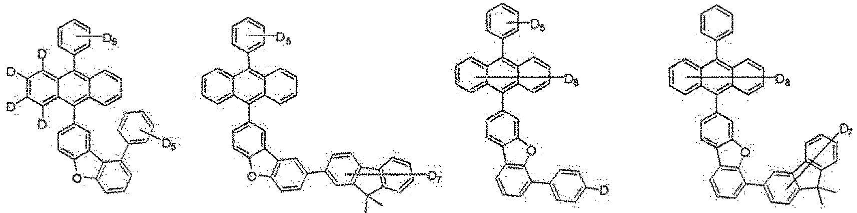

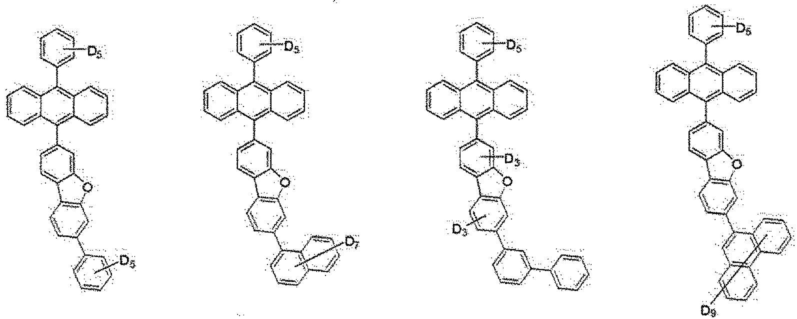

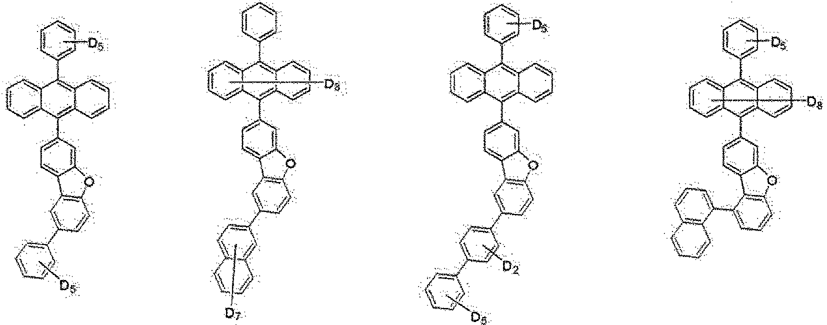

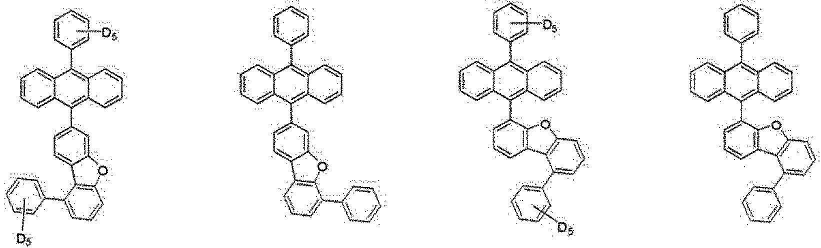

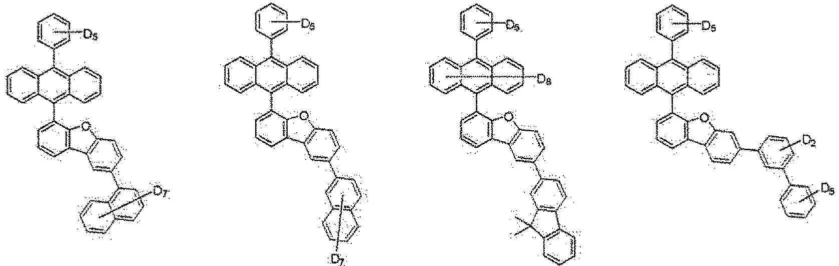

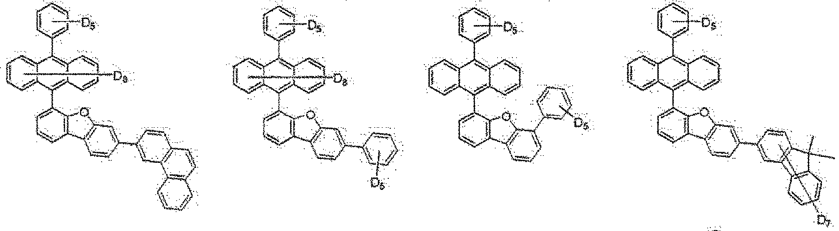

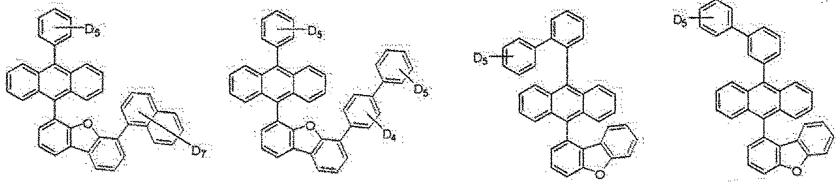

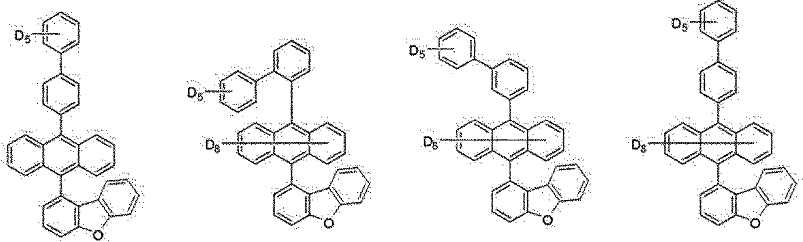

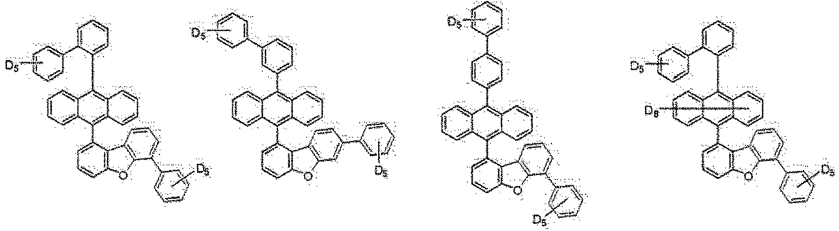

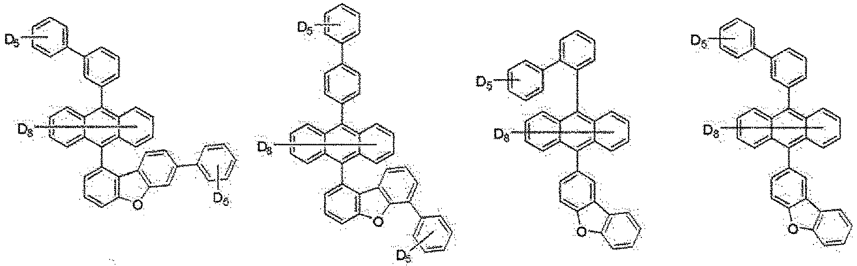

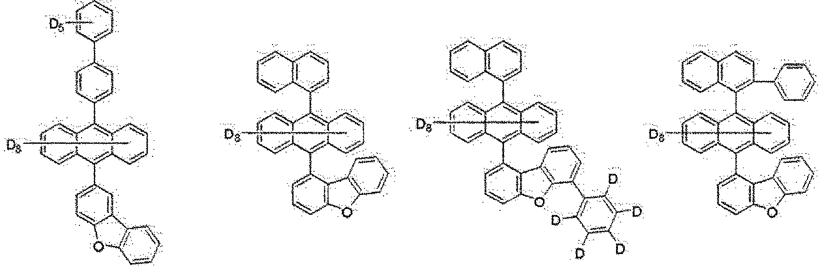

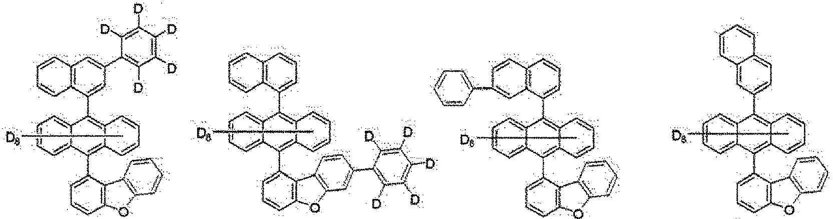

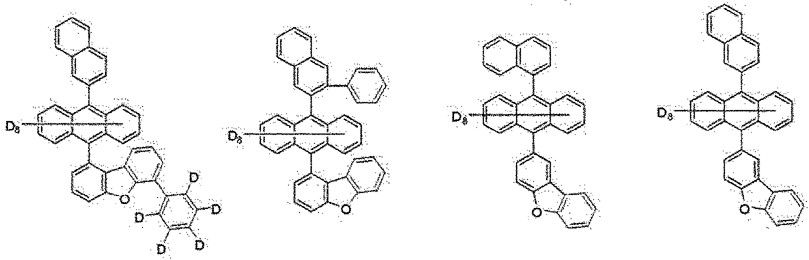

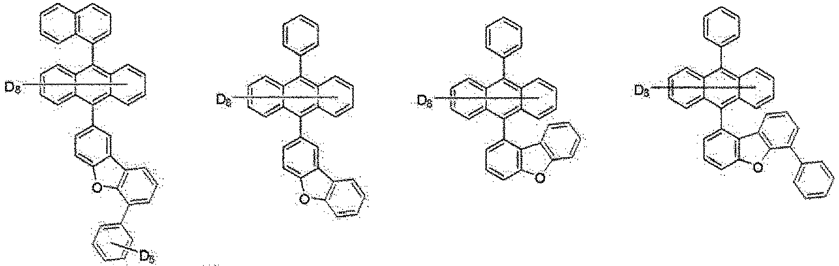

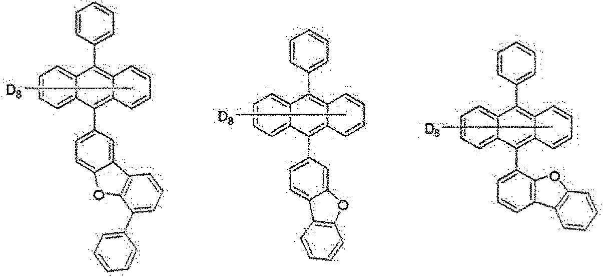

9. Dispositif électroluminescent organique selon la revendication 6, dans lequel un ou plusieurs composés hôtes outre le composé d'anthracène représenté par la Formule H sont mélangés ou empilés dans la couche d'émission de lumière.

10. Dispositif électroluminescent organique selon la revendication 6, dans lequel un ou plusieurs composés dopants outre le composé polycyclique représenté par la Formule I sont mélangés ou empilés dans la couche d'émission de lumière.

11. Dispositif électroluminescent organique selon la revendication 5, dans lequel une ou plusieurs des couches sont formées par un processus de déposition ou un processus de solution.

12. Dispositif électroluminescent organique selon la revendication 4, ledit dispositif électroluminescent organique étant utilisé dans un système d'affichage ou d'éclairage choisi parmi des écrans à panneau plat, des écrans flexibles, des systèmes d'éclairage monochromatique à panneau plat, des systèmes d'éclairage blanc à panneau plat, des systèmes flexibles d'éclairage monochromatique, des systèmes flexibles d'éclairage blanc, des écrans pour applications automobiles, des écrans pour la réalité virtuelle, et des écrans pour la réalité augmentée.
